# EUROPEAN PATENT APPLICATION

(11) **EP 4 451 062 A2**
(43) Date of publication of application: **23.10.2024**
(21) Application number: 24170434.5
(22) Date of filing: 16.04.2024
(51) Int. Cl.: G03F 7/09

(54) **COMPOSITION FOR FORMING ORGANIC FILM, METHOD FOR FORMING ORGANIC FILM, AND PATTERNING PROCESS**

(30) Priority: 19.04.2023 JP 2023068874
(71) Applicant: SHIN-ETSU CHEMICAL CO., LTD., Tokyo 1000005 (JP)
(72) Inventor: Yamamoto, Yasuyuki, Niigata (JP); Imata, Tomohiro, Niigata (JP); Kori, Daisuke, Niigata (JP)
(74) Representative: Sonnenhauser, Thomas Martin

(57) **Abstract**

The present invention is a composition for forming an organic film, comprising: a resin for forming an organic film; a polymer having a unit represented by the following general formula (I), and at least one of a unit represented by the following general formula (II) and a unit represented by the following general formula (III); and a solvent, wherein the unit represented by the following general formula (I), and at least one of the unit represented by the following general formula (II) and the unit represented by the following general formula (III) form a random copolymer, and the polymer has a fluorine content of 5 mass% to 16 mass%. This provides: a composition for forming an organic film that has excellent film-formability on a substrate and filling characteristics, and that inhibits humps in EBR process; and a method for forming an organic film, and patterning process using this composition.

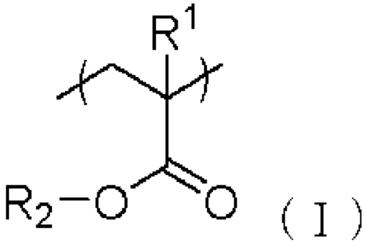

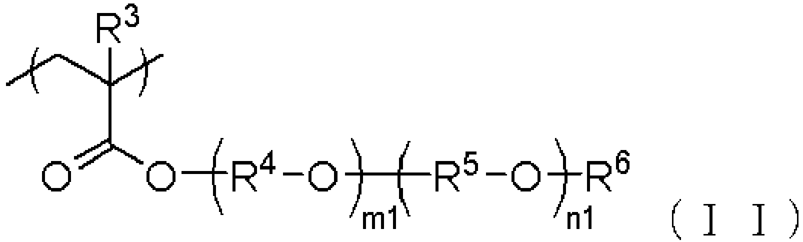

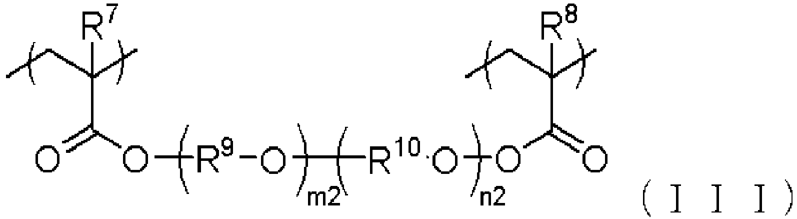

## Description

### TECHNICAL FIELD

The present invention relates to: a composition for forming an organic film for forming an organic film for a multilayer resist for fine processing in manufacturing of semiconductor device, etc. and an organic film for planarization in manufacturing of semiconductor device, etc.; a method for forming an organic film using the composition; and a patterning process using the composition.

### BACKGROUND ART

In recent requirement of a finer pattern rule with higher integration and higher speed of semiconductor devices, various technical developments have been made in lithography using light exposure, which is used as a common technology at present, about how finer and more accurate pattern is processed relative to the used light source.

As the light source for lithography used in the resist pattern formation, light exposure using a light source of g-line (436 nm) or i-line (365 nm) of a mercury lamp is widely used for portions having a low integration degree. Meanwhile, practically used for portions having a high integration degree requiring finer patterns are lithography using KrF excimer laser (248 nm) and ArF excimer laser (193 nm), which have a shorter wavelength. In the latest generation requiring a further finer pattern, lithography with extreme ultraviolet ray (EUV, 13.5 nm) is approaching the practical use.

It is well known that such a finer resist pattern increases a ratio of a pattern height to a pattern line width (aspect ratio) in a single-layer resist method, which is used as a typical resist patterning process, leading to pattern collapse due to a surface tension of a developing liquid during development. A multilayer resist method, which stacks films having different dry-etching properties to form a pattern, is known to be excellent for forming a pattern with a high aspect ratio on a stepped substrate. There have been developments of a two-layer resist method combining: a photoresist layer of a silicon-containing photosensitive polymer; and an underlayer of an organic polymer having carbon, hydrogen, and oxygen as major constituent elements, for example a novolac-type polymer (Patent Document 1). Also developed is a three-layer resist method combining: a photoresist layer of an organic photosensitive polymer used in the single-layer resist method; an intermediate layer of a silicon-based polymer or a silicon-based CVD film; and an underlayer of an organic polymer (Patent Document 2).

In this three-layer resist method, for example, an organic film such as novolac is uniformly formed on a substrate to be processed as a resist underlayer film, a silicon-containing film is formed thereon as a resist intermediate film, and a common organic photoresist film is formed thereon as a resist upper layer film. Since the organic resist upper layer film has good etching selectivity rate of dry etching with fluorine-based gas plasma to the silicon-containing resist intermediate film, the resist pattern is transferred to the silicon-containing resist intermediate film by using dry etching with the fluorine-based gas plasma. This method can transfer the pattern to the silicon-containing film even using a resist composition that is difficult to form a pattern having a sufficient film thickness for directly processing the substrate to be processed or even using a resist composition having insufficient dry-etching resistance for processing a substrate. A subsequent pattern transfer using dry etching with oxygen-based gas plasma can yield a novolac film pattern having sufficient dry-etching resistance for processing.

Although many techniques about the aforementioned organic underlayer film have been already known (for example, Patent Document 3), excellent filling characteristics have been required in addition to the dry-etching properties with development of the recent fining in recent years. Required is an organic underlayer film material having filling characteristics that can uniformly form a film even on a material or base substrate to be processed having a complex shape, and that can fill an inside of the required pattern without a void.

The organic underlayer film as noted above is formed in manufacturing a semiconductor substrate, etc. by using a coater/developer that can perform process such as spin-coating process, edge bead removal (EBR) process, and baking process. The EBR process is a process of removing a coating on an edge of the substrate (wafer) with a removing liquid after formation of the coating on the substrate by spin-coating for a purpose of preventing contamination of a substrate-conveyer arm of the coater/developer. One of the removing liquids used in the EBR process is a mixed liquid of propylene glycol monomethyl ether acetate and propylene glycol monomethyl ether (30 mass% : 70 mass%), and this mixed liquid is widely used in the EBR process for a resist film, a silicon-containing intermediate film, and an organic underlayer film.

The remover in the EBR process may affect an outer periphery of the organic underlayer film to form a thick state (hump). The hump causes defects in dry-etching process in the aforementioned substrate processing, and thereby an organic underlayer film having reduced humps has been required.

### CITATION LIST

### PATENT LITERATURE

Patent Document 1: JP H06-118651 A
Patent Document 2: JP 4355943 B
Patent Document 3: JP 2004-205685 A

### SUMMARY OF INVENTION

### TECHNICAL PROBLEM

The present invention has been made in view of the above circumstances. An object of the present invention is to provide: a composition for forming an organic film having excellent film-formability (in-plane uniformity) and filling characteristics on the substrate (wafer), and reducing humps in the EBR process; and a method for forming an organic film and patterning process using this composition.

### SOLUTION TO PROBLEM

To achieve the above object, the present invention provides a composition for forming an organic film comprising: a resin for forming an organic film; a polymer having a structural unit represented by the following general formula (I), and at least one of a structural unit represented by the following general formula (II) and a structural unit represented by the following general formula (III); and a solvent, wherein the structural unit represented by the following general formula (I), and at least one of the structural unit represented by the following general formula (II) and the structural unit represented by the following general formula (III) form a random copolymer, and the polymer has a fluorine content of 5 mass% to 16 mass%, 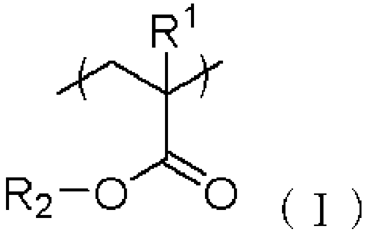 wherein R¹ represents a hydrogen atom or an alkyl group having 1 to 20 carbon atoms; and R² represents an organic group having a fluorine atom and 1 to 20 carbon atoms, and having no sulfonyl group and no amino group, 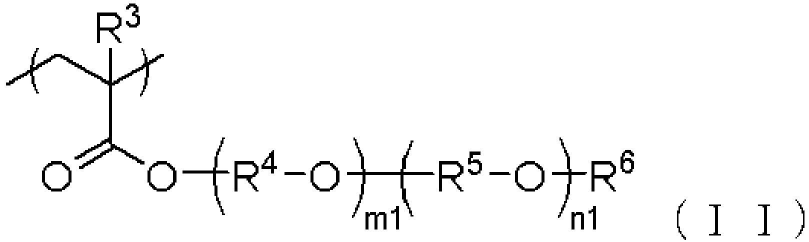 wherein R³ represents a hydrogen atom or an alkyl group having 1 to 20 carbon atoms; R⁴ and R⁵ each represent a linear or branched divalent alkylene group having 1 to 4 carbon atoms; R⁶ represents a hydrogen atom, an alkyl group having 1 to 4 carbon atoms, or a phenyl group; m1 represents 0 to 23; n1 represents 0 to 23; and 23 ≥ m1+n1 ≥ 2, 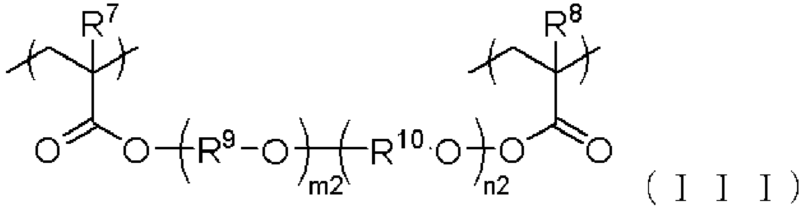 wherein R⁷ and R⁸ represent a hydrogen atom or an alkyl group having 1 to 20 carbon atoms; R⁹ and R¹⁰ each represent a linear or branched divalent alkylene group having 1 to 4 carbon atoms; m2 represents 0 to 23; n2 represents 0 to 23; and 23 ≥ m2+n2 ≥ 2.

Such a composition for forming an organic film has excellent in-plane uniformity and filling characteristics, and can form an organic film reducing hump formation due to the effect of the remover in the EBR process.

In the composition for forming an organic film, R² in the structural unit represented by the general formula (I) of the polymer preferably has a structure represented by the following general formula (IV) or (V), 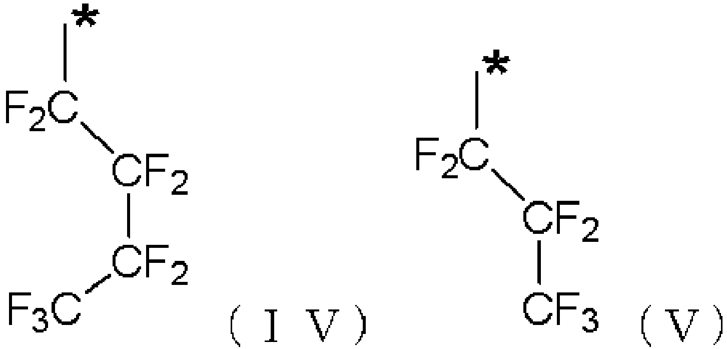 wherein "*" represents a bonding position.

The composition for forming an organic film containing such a polymer is preferable because the in-plane uniformity of the formed organic film becomes more excellent.

In the composition for forming an organic film, the resin for forming an organic film is preferably a resin having an aromatic skeleton.

The resin having such an aromatic skeleton is preferable because of more excellent etching resistance, optical properties, heat resistance, etc.

In the composition for forming an organic film, a content of the polymer is preferably 0.01 part by mass to 5 parts by mass relative to 100 parts by mass of the resin for forming an organic film.

The composition for forming an organic film containing such a content of the polymer is preferable because the in-plane uniformity of the formed organic film becomes more excellent.

In the composition for forming an organic film, a content of the resin for forming an organic film is preferably 10 parts by mass to 40 parts by mass relative to 100 parts by mass of the composition for forming an organic film.

In a case of such a content of the resin for forming an organic film, the composition for forming an organic film can be suitably used because the composition can have excellent in-plane uniformity and filling characteristics.

The composition for forming an organic film as noted above sufficiently exhibits the effect of the present invention.

In addition, the present invention provides a method for forming an organic film used in a semiconductor device manufacturing process, the method comprising steps of: applying the above composition for forming an organic film on a substrate to be processed by spin-coating; and heat-treating the substrate coated with the composition for forming an organic film at a temperature of 100°C to 600°C within a range of 10 seconds to 600 seconds for forming a cured film.

The method for forming an organic film of the present invention can fill a pattern having a complex shape on the substrate to be processed by spin-coating with the above composition for forming an organic film, and can form an organic film having excellent in-plane uniformity. The organic film obtained by the above method is preferable because an organic film on the edge can be removed while inhibiting the humps in the EBR process.

In addition, the present invention provides a patterning process comprising steps of: forming an organic film on a body to be processed by using the above composition for forming an organic film; forming a resist intermediate film on the organic film by using a resist intermediate film material containing a silicon atom; forming a resist upper layer film on the resist intermediate film by using a resist upper layer film material composed of a photoresist composition; forming a circuit pattern in the resist upper layer film; transferring the pattern to the resist intermediate film by etching while using the circuit-patterned resist upper layer film as a mask; transferring the pattern to the organic film by etching while using the patterned resist intermediate film as a mask; and transferring the pattern to the body to be processed by etching while using the patterned organic film as a mask.

As above, the patterning process with a three-layer resist process using the composition for forming an organic film of the present invention, the silicon-containing resist intermediate film, and the resist upper layer film can be provided. The patterning process of the present invention as above can transfer and form the circuit pattern in the resist upper layer film to the body to be processed with high accuracy.

In addition, the present invention provides a patterning process comprising steps of: forming an organic film on a body to be processed by using the above composition for forming an organic film; forming a resist intermediate film on the organic film by using a resist intermediate film material containing a silicon atom; forming an organic anti-reflection film or an adhesion film on the resist intermediate film; forming a resist upper layer film on the organic anti-reflection film or the adhesion film by using a resist upper layer film material composed of a photoresist composition; forming a circuit pattern in the resist upper layer film; transferring the pattern to the organic anti-reflection film or the adhesion film, and the resist intermediate film by etching while using the circuit-patterned resist upper layer film as a mask; transferring the pattern to the organic film by etching while using the patterned resist intermediate film as a mask; and transferring the pattern to the body to be processed by etching while using the patterned organic film as a mask.

As above, the patterning process with a four-layer resist process using the composition for forming an organic film of the present invention, the silicon-containing resist intermediate film, the organic anti-reflection film or the adhesion film, and the resist upper layer film can be provided. The patterning process of the present invention as above can transfer and form the circuit pattern in the resist upper layer film to the body to be processed with high accuracy.

In addition, the present invention provides a patterning process comprising steps of: forming an organic film on a body to be processed by using the above composition for forming an organic film; forming an inorganic hard mask selected from a silicon oxide film, a silicon nitride film, and a silicon oxynitride film on the organic film; forming a resist upper layer film on the inorganic hard mask by using a resist upper layer film material composed of a photoresist composition; forming a circuit pattern in the resist upper layer film; transferring the pattern to the inorganic hard mask by etching while using the circuit-patterned resist upper layer film as a mask; transferring the pattern to the organic film by etching while using the patterned inorganic hard mask as a mask; and transferring the pattern to the body to be processed by etching while using the patterned organic film as a mask.

As above, the patterning process with a three-layer resist process using the composition for forming an organic film of the present invention, the inorganic hard mask, and the resist upper layer film can be provided. The patterning process of the present invention as above can transfer and form the circuit pattern in the resist upper layer film to the body to be processed with high accuracy.

In addition, the present invention provides a patterning process comprising steps of: forming an organic film on a body to be processed by using the above composition for forming an organic film; forming an inorganic hard mask selected from a silicon oxide film, a silicon nitride film, and a silicon oxynitride film on the organic film; forming an organic anti-reflection film or an adhesion film on the inorganic hard mask; forming a resist upper layer film on the organic anti-reflection film or the adhesion film by using a resist upper layer film material composed of a photoresist composition; forming a circuit pattern in the resist upper layer film; transferring the pattern to the organic anti-reflection film or the adhesion film and the inorganic hard mask by etching while using the circuit-patterned resist upper layer film as a mask; transferring the pattern to the organic film by etching while using the patterned inorganic hard mask as a mask; and transferring the pattern to the body to be processed by etching while using the patterned organic film as a mask.

As above, the patterning process with a four-layer resist process using the composition for forming an organic film of the present invention, the inorganic hard mask, the organic anti-reflection film or the adhesion film, and the resist upper layer film can be provided. The patterning process of the present invention as above can transfer and form the circuit pattern in the resist upper layer film to the body to be processed with high accuracy.

The inorganic hard mask is preferably formed by a CVD method or an ALD method.

In the patterning process of the present invention, the inorganic mask may be formed by such a method, for example.

The circuit pattern is preferably formed by lithography using light having a wavelength of 10 nm or longer and 300 nm or shorter, direct writing with electron beam, nanoimprinting, or a combination thereof.

The circuit pattern is preferably developed with alkaline development or an organic solvent.

In the patterning process of the present invention, such a means of forming and developing the circuit pattern may be suitably used.

The body to be processed is preferably a semiconductor device substrate, or a substrate in which any of a metal film, a metal carbide film, a metal oxide film, a metal nitride film, a metal oxycarbide film, and a metal oxynitride film is formed on the semiconductor device substrate.

A metal to constitute the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

The patterning process of the present invention can process the body to be processed as above to form a pattern.

### ADVANTAGEOUS EFFECTS OF INVENTION

As described above, the present invention can provide the composition for forming an organic film having excellent film-formability (in-plane uniformity) and filling characteristics on the substrate (wafer), and reducing humps in the EBR process. Since the composition for forming an organic film of the present invention as above has excellent film-formability, filling characteristics, and hump inhibition property generated in the EBR process, the composition of the present invention is extremely useful for an organic film material used for a multilayer resist process such as, for example: a two-layer resist process; a three-layer resist process using the silicon-containing resist intermediate film or the inorganic hard mask; or a four-layer resist process using the silicon-containing resist intermediate film or the inorganic hard mask, and the organic anti-reflection film or the adhesion film. The composition of the present invention is also extremely useful for a material for forming an organic film for semiconductor device manufacturing. The method for forming an organic film of the present invention can form an organic film with reduced humps, and thereby a semiconductor device, etc. can be efficiently manufactured.

### BRIEF DESCRIPTION OF DRAWINGS

FIG. 1 is a graph of measuring a height of a hump by using a contact-type profiler in an example of Comparative Example (Comparative UDL-1) of the composition for forming an organic film of the present invention;
FIG. 2 is a graph of measuring a height of a hump by using a contact-type profiler in an example (UDL-4) of the composition for forming an organic film of the present invention;
FIG. 3 is an explanatory view for an example of the patterning process of the present invention with a three-layer resist process; and
FIG. 4 is an explanatory view for a method for evaluating filling characteristics in Examples.

### DESCRIPTION OF EMBODIMENTS

As noted above, there has been a demand for development of a composition for forming an organic film having excellent film-formability (in-plane uniformity) and filling characteristics on the substrate (wafer), and reducing humps in the EBR process.

When the organic film is formed, a resin for forming an organic film and an additive are commonly dissolved in an organic solvent to prepare a composition, and this composition is applied with a coater/developer on a substrate on which a structure, wiring, etc. are formed. The composition spreads by rotating the substrate to remove the composition on the edge in the EBR process, and then baked to form the organic film.

It is considered that a composition having insufficient flowability causes voids in filling holes or trenches with an extremely high aspect ratio, and if the resin for forming an organic film and the additive have poor solubility in a remover used in the EBR process, humps are generated on an outer periphery of the organic film.

The present inventors have further made earnest study to find that the composition for forming an organic film having film-formability, high filing characteristics, and excellent hump inhibition property in the EBR process is obtained by blending a composition for forming an organic film comprising: a resin for forming an organic film; a polymer having a structural unit represented by the following general formula (I), and at least one of a structural unit represented by the following general formula (II) and a structural unit represented by the following general formula (III); and a solvent, wherein the structural unit represented by the following general formula (I), and at least one of the structural unit represented by the following general formula (II) and the structural unit represented by the following general formula (III) form a random copolymer, and the polymer has a fluorine content of 5 mass% to 16 mass%. This finding has led to completion of the present invention.

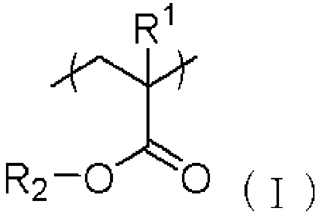

In the formula, R¹ represents a hydrogen atom or an alkyl group having 1 to 20 carbon atoms; and R² represents an organic group having a fluorine atom and 1 to 20 carbon atoms, and having no sulfonyl group and no amino group.

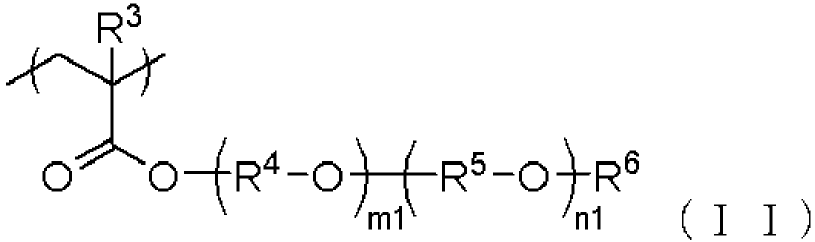

In the formula, R³ represents a hydrogen atom or an alkyl group having 1 to 20 carbon atoms; R⁴ and R⁵ each represent a linear or branched divalent alkylene group having 1 to 4 carbon atoms; R⁶ represents a hydrogen atom, an alkyl group having 1 to 4 carbon atoms, or a phenyl group; m1 represents 0 to 23; n1 represents 0 to 23; and 23 ≥ m1+n1 ≥ 2.

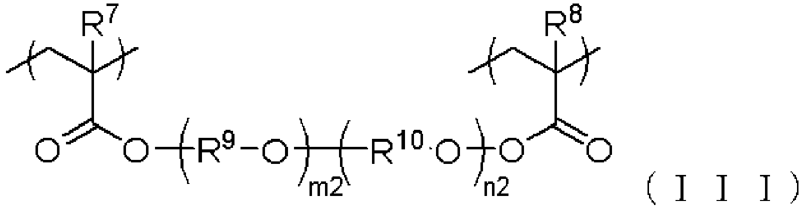

In the formula, R⁷ and R⁸ represent a hydrogen atom or an alkyl group having 1 to 20 carbon atoms; R⁹ and R¹⁰ each represent a linear or branched divalent alkylene group having 1 to 4 carbon atoms; m2 represents 0 to 23; n2 represents 0 to 23; and 23 ≥ m2+n2 ≥ 2.

Specifically, the present invention is a composition for forming an organic film comprising: a resin for forming an organic film; a polymer having a structural unit represented by the following general formula (I), and at least one of a structural unit represented by the following general formula (II) and a structural unit represented by the following general formula (III); and a solvent, wherein the structural unit represented by the following general formula (I), and at least one of the structural unit represented by the following general formula (II) and the structural unit represented by the following general formula (III) form a random copolymer, and the polymer has a fluorine content of 5 mass% to 16 mass%, 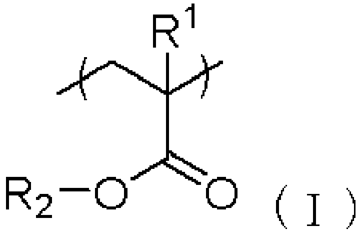 wherein R¹ represents a hydrogen atom or an alkyl group having 1 to 20 carbon atoms; and R² represents an organic group having a fluorine atom and 1 to 20 carbon atoms, and having no sulfonyl group and no amino group, 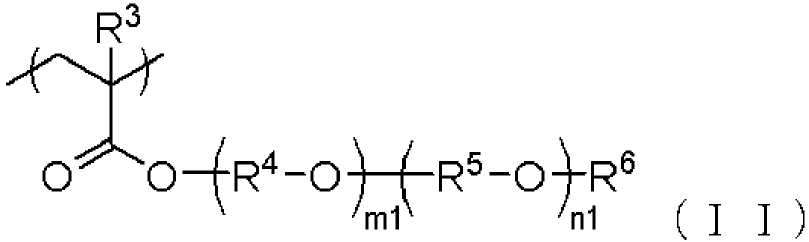 wherein R³ represents a hydrogen atom or an alkyl group having 1 to 20 carbon atoms; R⁴ and R⁵ each represent a linear or branched divalent alkylene group having 1 to 4 carbon atoms; R⁶ represents a hydrogen atom, an alkyl group having 1 to 4 carbon atoms, or a phenyl group; m1 represents 0 to 23; n1 represents 0 to 23; and 23 ≥ m1+n1 ≥ 2, 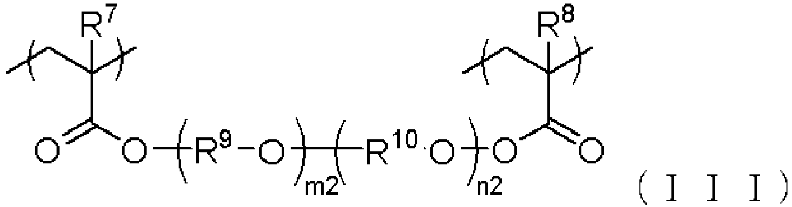 wherein R⁷ and R⁸ represent a hydrogen atom or an alkyl group having 1 to 20 carbon atoms; R⁹ and R¹⁰ each represent a linear or branched divalent alkylene group having 1 to 4 carbon atoms; m2 represents 0 to 23; n2 represents 0 to 23; and 23 ≥ m2+n2 ≥ 2.

Note that the fluorine content of the polymer used in the present invention is calculated from a mass proportion of fluorine atoms relative to a total amount of used raw material monomers.

Hereinafter, the present invention will be described in detail, but the present invention is not limited thereto.

### Composition for Forming Organic Film

The composition for forming an organic film of the present invention is a composition for forming an organic film comprising: a resin for forming an organic film; a polymer having a structural unit represented by the following general formula (I), and at least one of a structural unit represented by the following general formula (II) and a structural unit represented by the following general formula (III); and a solvent, wherein the structural unit represented by the following general formula (I), and at least one of the structural unit represented by the following general formula (II) and the structural unit represented by the following general formula (III) form a random copolymer, and the polymer has a fluorine content of 5 mass% to 16 mass%, 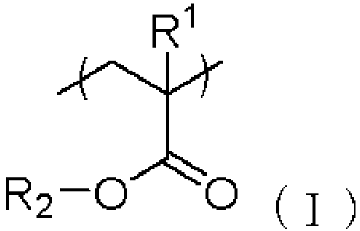 wherein R¹ represents a hydrogen atom or an alkyl group having 1 to 20 carbon atoms; and R² represents an organic group having a fluorine atom and 1 to 20 carbon atoms, and having no sulfonyl group and no amino group, 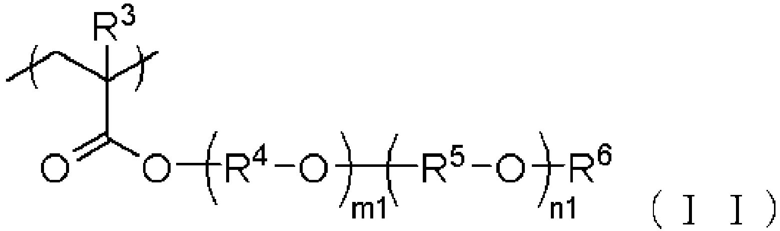 wherein R³ represents a hydrogen atom or an alkyl group having 1 to 20 carbon atoms; R⁴ and R⁵ each represent a linear or branched divalent alkylene group having 1 to 4 carbon atoms; R⁶ represents a hydrogen atom, an alkyl group having 1 to 4 carbon atoms, or a phenyl group; m1 represents 0 to 23; n1 represents 0 to 23; and 23 ≥ m1+n1 ≥ 2, 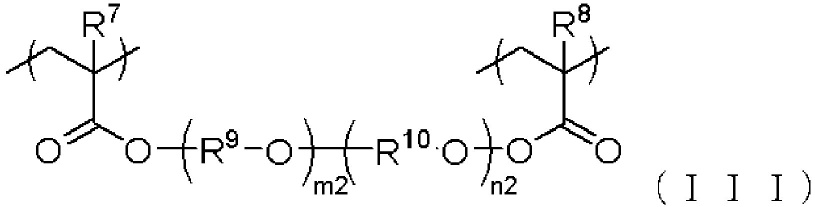 wherein R⁷ and R⁸ represent a hydrogen atom or an alkyl group having 1 to 20 carbon atoms; R⁹ and R¹⁰ each represent a linear or branched divalent alkylene group having 1 to 4 carbon atoms; m2 represents 0 to 23; n2 represents 0 to 23; and 23 ≥ m2+n2 ≥ 2.

In the composition for forming an organic film of the present invention, each of the resin for forming an organic film, the polymer, and the solvent may be used singly or in combination of two or more.

Polymer Having at Least One of Structural Unit Represented by General Formula (I), Structural Unit Represented by General Formula (II), and Structural Unit Represented by General Formula (III), wherein Structural Unit Represented by General Formula (I), and at Least One of Structural Unit Represented by General Formula (II) and Structural Unit Represented by General Formula (III) Form Random Copolymer, and Polymer Has Fluorine Content of 5 mass% to 16 mass%

The composition for forming an organic film of the present invention comprises a polymer having a structural unit represented by the general formula (I), and at least one of a structural unit represented by the general formula (II) and a structural unit represented by the general formula (III), wherein the structural unit represented by the general formula (I), and at least one of the structural unit represented by the general formula (II) and the structural unit represented by the general formula (III) form a random copolymer, and the polymer has a fluorine content of 5 mass% to 16 mass%. These structural units are polymerized for forming the random copolymer because of excellent compatibility between the resin for forming an organic film and the solvent. It is considered that this polymer has excellent flexibility because of the contained oxyalkylene group, and improves flowability of the composition for forming an organic film by setting the fluorine content to be within an appropriate range to regulate an aggregation state of the polymer, leading to the excellent filling characteristics. Further, this polymer has excellent solubility in a remover in the EBR process to inhibit humps. The contained fluorine reduces surface tension to also improve in-plane uniformity of the composition for forming an organic film. An upper limit of the fluorine content is 16 mass%, preferably 14 mass% from the viewpoint of the hump inhibition, and most preferably 12 mass% from the viewpoint of the filling characteristics.

From the viewpoint of the in-plane uniformity, a lower limit of the fluorine content is 5 mass%, and preferably 7 mass%.

The R¹ represents a hydrogen atom or an alkyl group having 1 to 20 carbon atoms. Specific examples of the alkyl group having 1 to 20 carbon atoms include a methyl group, an ethyl group, a propyl group, an isopropyl group, an n-butyl group, a s-butyl group, a t-butyl group, an isobutyl group, a pentyl group, a cyclopentyl group, a hexyl group, a cyclohexyl group, and a decyl group. Among these, a hydrogen atom and a methyl group are more preferable.

The R² represents an organic group having a fluorine atom and 1 to 20 carbon atoms, and having no sulfonyl group and no amino group.

Here, the term "organic group" in the present invention means a group having at least one carbon, the organic group further has hydrogen, and may have nitrogen, oxygen, sulfur, silicon, a halogen atom, etc.

R² preferably represents an organic group having a fluorine atom and 1 to 20 carbon atoms, and further preferably an organic group having 1 to 20 carbon atoms wherein a substituent having the fluorine atom is represented by the following general formula (IV) or (V), 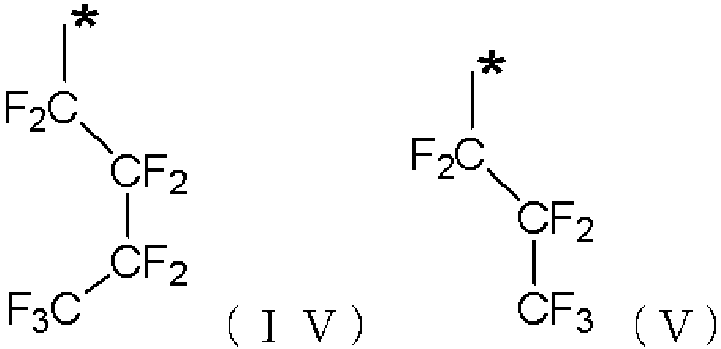 wherein "*" represents a bonding position.

R² excludes a sulfonyl group and an amino group because these structures increase the polarity to limit a preferable type of the solvent.

The polymer having these structures yields properties of reduction in the surface tension of the composition for forming an organic film and excellent compatibility of the polymer with the solvent, which can form the organic film having more excellent in-plane uniformity by spin-coating.

More specific examples of the structural unit represented by the general formula (I) include, but not limited to, the following structures. Among these, structural units having a perfluoroalkyl group having 3 or 4 carbon atoms are preferable, as noted above.

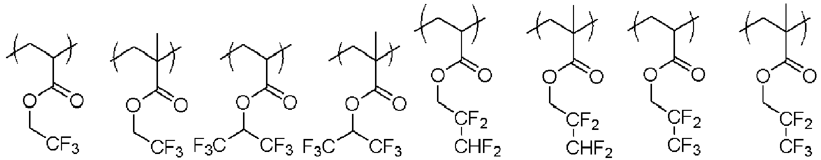

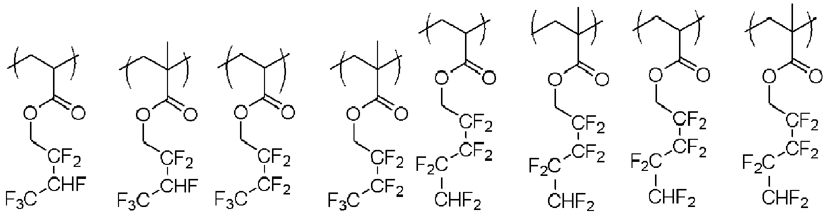

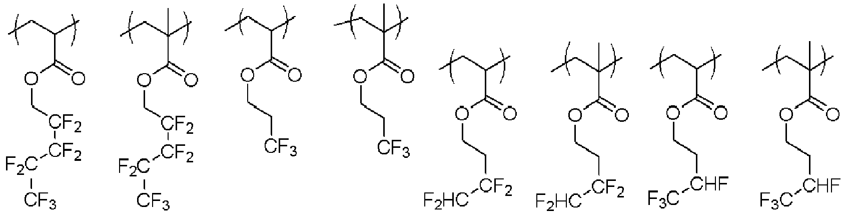

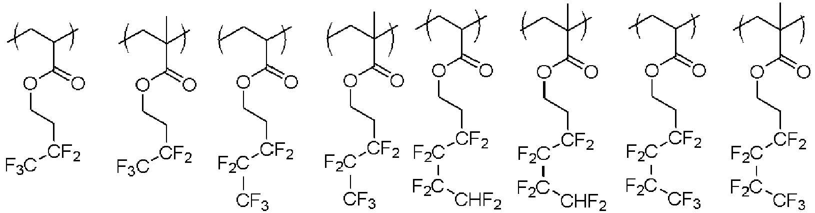

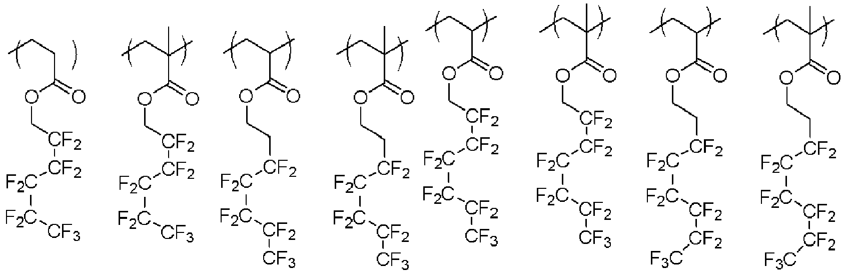

The R³ represents a hydrogen atom or an alkyl group having 1 to 20 carbon atoms. Specific examples of the alkyl group having 1 to 20 carbon atoms include a methyl group, an ethyl group, a propyl group, an isopropyl group, an n-butyl group, a s-butyl group, a t-butyl group, an isobutyl group, a pentyl group, a cyclopentyl group, a hexyl group, a cyclohexyl group, and a decyl group. Among these, a hydrogen atom and a methyl group are more preferable.

The R⁴ and the R⁵ each represent a linear or branched divalent alkylene group having 1 to 4 carbon atoms. Specific examples of the linear or branched divalent alkylene group having 1 to 4 carbon atoms include a methylene group, an ethylene group, a propylene group, a butylene group, a trimethylene group, and a tetramethylene group. Among these, an ethylene group is more preferable from the viewpoint of the filling characteristics. The sequence of (R⁴O) and (R⁵O) may be a random, block, or multiblock sequence.

The R⁶ represents a hydrogen atom, an alkyl group having 1 to 4 carbon atoms, or a phenyl group. Specific examples of the alkyl group having 1 to 4 carbon atoms include a methyl group, an ethyl group, a propyl group, an isopropyl group, an allyl group, an n-butyl group, a s-butyl group, a t-butyl group, and an isobutyl group. Among these, a hydrogen atom, a methyl group or an ethyl group, and a phenyl group are more preferable.

The m1 represents 0 to 23, n1 represents 0 to 23, and 23 ≥ m1+n1 ≥ 2. Here, m1 and n1 represent an average number of repetitions. An upper limit of m1+n1 is 23, and more preferably 13 from the viewpoint of storage stability at low temperature.

More specific examples of the structural unit represented by the general formula (II) include, but not limited to, the following structures.

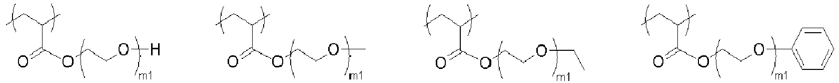

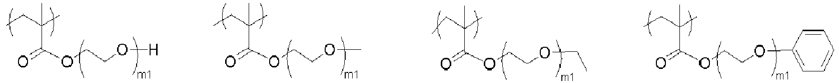

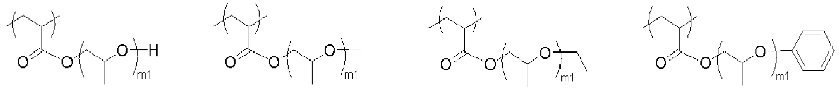

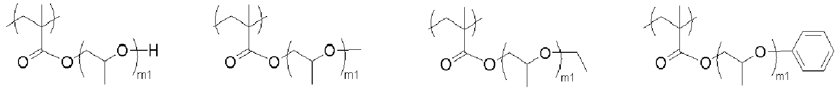

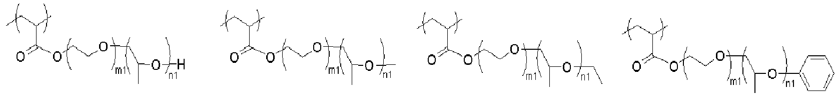

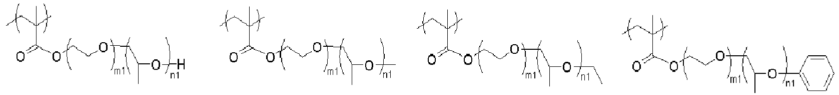

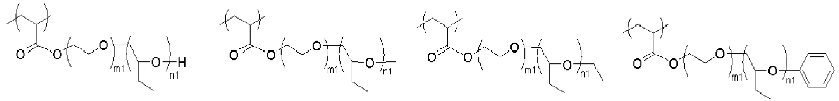

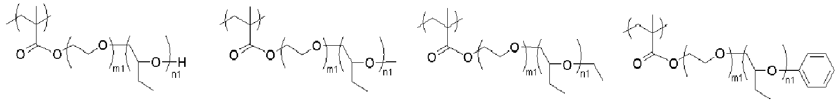

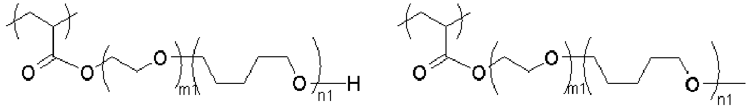

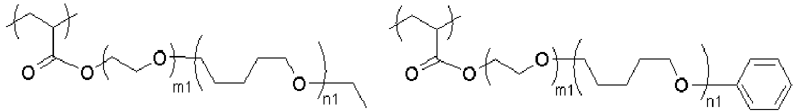

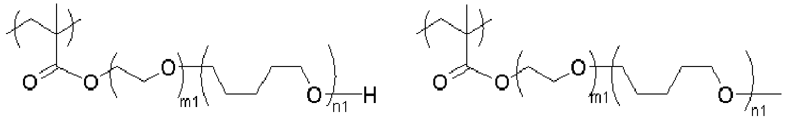

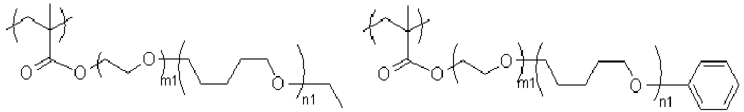

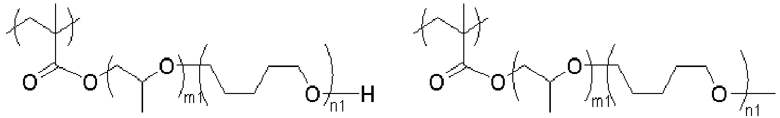

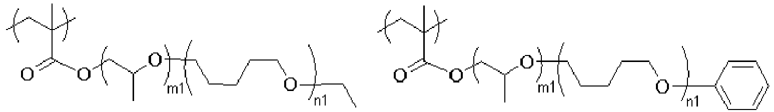

The R⁷ and R⁸ represent a hydrogen atom or an alkyl group having 1 to 20 carbon atoms. Specific examples of the alkyl group having 1 to 20 carbon atoms include a methyl group, an ethyl group, a propyl group, an isopropyl group, an n-butyl group, a s-butyl group, a t-butyl group, an isobutyl group, a pentyl group, a cyclopentyl group, a hexyl group, a cyclohexyl group, and a decyl group. Among these, a hydrogen atom and a methyl group are more preferable.

The R⁹ and the R¹⁰ each represent a linear or branched divalent alkylene group having 1 to 4 carbon atoms. Specific examples of the linear or branched divalent alkylene group having 1 to 4 carbon atoms include a methylene group, an ethylene group, a propylene group, a butylene group, a trimethylene group, and a tetramethylene group. Among these, an ethylene group is more preferable. The sequence of (R⁹O) and (R¹⁰O) may be a random, block, or multiblock sequence.

The m2 represents 0 to 23, n2 represents 0 to 23, and 23 ≥ m2+n2 ≥ 2. Here, m2 and n2 represent an average number of repetition. An upper limit of m2+n2 is 23, and more preferably 13 from the viewpoint of storage stability at low temperature.

More specific examples of the structural unit represented by the general formula (III) include, but not limited to, the following structures.

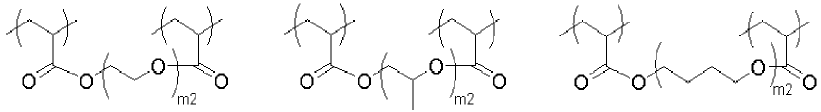

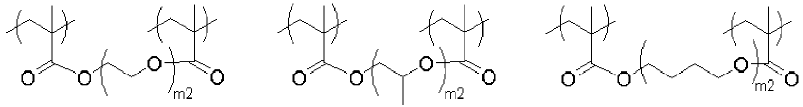

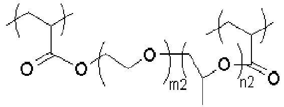

The polymer can be synthesized by polymerizing a monomer to provide the structural unit represented by the general formula (I), and at least one monomer of a monomer to provide the structural unit represented by the general formula (II) and a monomer to provide the structural unit represented by the general formula (III) at a blending ratio depending on each of the structures of the polymer so as to be a predetermined content ratio by a known method.

For the polymer, each of the monomer to provide the structural unit represented by the general formula (I), and at least one monomer of the monomer to provide the structural unit represented by the general formula (II) and the monomer to provide the structural unit represented by the general formula (III) may be used singly, or in combination of two or more.

Combination of a plurality of the structural units provides complex structure to inhibit aggregation of the polymer, which can appropriately regulate the solvent solubility.

The polymer can be obtained by polymerizing polymerizable monomers by a known method, and the polymerization is performed so that the structural unit represented by the general formula (I), and at least one of the structural units represented by the general formula (II) and the structural unit represented by the general formula (III) form a random copolymer. For obtaining the polymer, the polymer can also be synthesized by polymerizing monomers protected with a protecting group as necessary, and then performing a deprotection reaction as necessary. A reaction method for obtaining the polymer is not particularly limited, and methods such as radical polymerization and cation polymerization may be used and appropriately selected depending on reactivity of the monomers.

One method for using the radical polymerization is a method in which monomers having a polymerizable unsaturated bond are mixed, and in a solvent, adding a radical initiator to perform polymerization with heating. This method can yield the polymer. The polymerization conditions may be variously selected depending on the monomers to be used, a target molecular weight, etc. Specific examples of a solvent used in the polymerization include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, and butyl acetate. Examples of the polymerization initiator include 2,2'-azobisisobutyronitrile (AIBN), 2,2'-azobis(2,4-dimethylvaleronitrile), dimethyl 2,2-azobis(2-methylpropionate), benzoyl peroxide, and lauroyl peroxide. In the polymerization, thiols such as octanethiol and 2-mercaptoethanol may be added as a chain transfer agent. The polymerization reaction may be preferably performed by heating at 40°C to a boiling point of the solvent. The reaction time is 0.5 to 100 hours, and preferably 1 to 48 hours.

One method for using the cation polymerization is a method in which monomers having a polymerizable unsaturated bond are mixed, and adding a cation polymerization initiator to perform polymerization. This method can yield the polymer. The polymerization conditions may be variously selected depending on the monomers to be used, a target molecular weight, etc. Specific examples of a solvent used in the polymerization include hexane, heptane, octane, toluene, methylene chloride, 1,2-dichloroethane, ethyl ether, and butyl ether. An available catalyst as the cation polymerization initiator may be an acid including: protonic acids, such as sulfuric acid, a perchloric acid, trifluoroacetic acid, methanesulfonic acid, trifluoromethanesulfonic acid, chlorosulfonic acid, and fluorosulfonic acid; Lewis acids, such as boron trifluoride, aluminum chloride, titanium tetrachloride, stannic chloride, and ferric chloride; etc. When a Lewis acid is used for the catalyst, presence of a proton supplying source such as an acid, water, and an alcohol at an approximately same mole amount as the catalyst improves the cation polymerization activity, and thus such a proton supplying source may be added. The temperature is not particularly limited as long as the polymerization reaction proceeds, the polymerization reaction may be preferably performed at -10°C to a heating temperature of a boiling point of the reaction solvent. The reaction time is 0.5 to 100 hours, and preferably 1 to 48 hours.

The polymer preferably has a weight-average molecular weight (Mw) of 1,000 to 300,000, more preferably 2,000 to 20,000, and further preferably 3,000 to 15,000. With Mw of 1,000 or more, excellent in-plane uniformity is exhibited. Meanwhile, with Mw of 30,000 or less, application failure due to insufficient solubility in the solvent can be inhibited. A molecular weight distribution (Mw/Mn) is preferably 1.0 to 3.0, and more preferably 1.0 to 2.0. Mw and the molecular weight distribution in the present invention are measurement values in terms of polystyrene by gel permeation chromatography (GPC) using tetrahydrofuran (THF) as a solvent.

A blending amount of the polymer is preferably 0.01 to 5 parts by mass, more preferably 0.1 to 3 parts by mass, and particularly preferably 0.5 to 2 parts by mass relative to 100 parts by mass of the resin for forming an organic film. When the blending amount of the polymer is 0.01 part by mass or more, the effect by blending can be sufficiently obtained. Although the polymer is decomposed by heat in baking to deteriorate the in-plane uniformity and the filling characteristics, the polymer at the range of 5 parts by mass or less can be suitably used.

### Resin for Forming Organic Film

The resin for forming an organic film usable in the organic film composition of the present invention is not particularly limited as long as it is a compound containing a resin satisfying film-formability in spin-coating and curability, but the resin is more preferably a compound having an aromatic skeleton from the viewpoints of etching resistance, optical properties, heat resistance, etc.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, and carbazole. Among these, benzene, naphthalene, fluorene, and carbazole are particularly preferable.

Examples of the resin for forming an organic film applied to the present invention include resins described in JP 2012-1687 A and JP 2012-77295 A, and having the following structure.

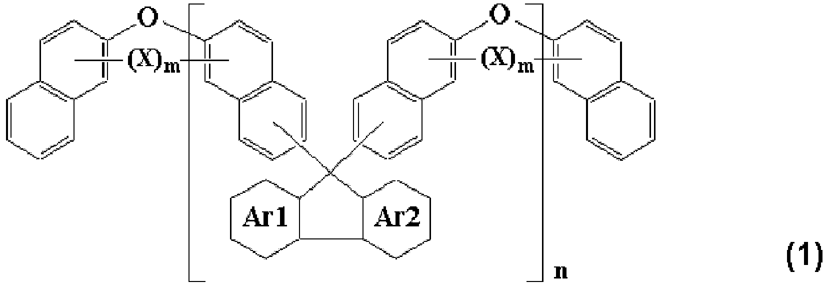

In the formula (1), the ring structures Ar1 and Ar2 represent a benzene ring or a naphthalene ring; X represents a single bond or an alkylene group having 1 to 20 carbon atoms; "m" represents 0 or 1; and "n" represents a given natural number so that the molecular weight is 100,000 or less. The symbols in the formula are applied only in this formula.

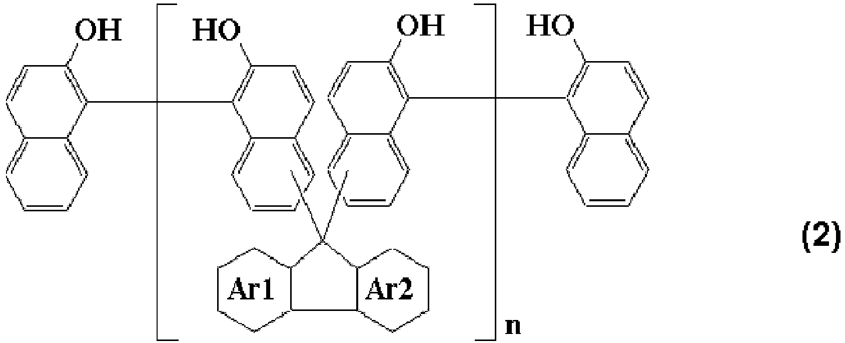

In the formula (2), the ring structures Ar1 and Ar2 represent a benzene ring or a naphthalene ring; and "n" represents a given natural number so that the weight-average molecular weight in terms of polystyrene by gel permeation chromatography is 100,000 or less. The symbols in the formula are applied only in this formula.

Examples of the resin for forming an organic film applied to the present invention further include resins described in JP 2004-264710 A, JP 2005-043471 A, JP 2005-250434 A, JP 2007-293294 A, and JP 2008-65303 A, and having the following structure.

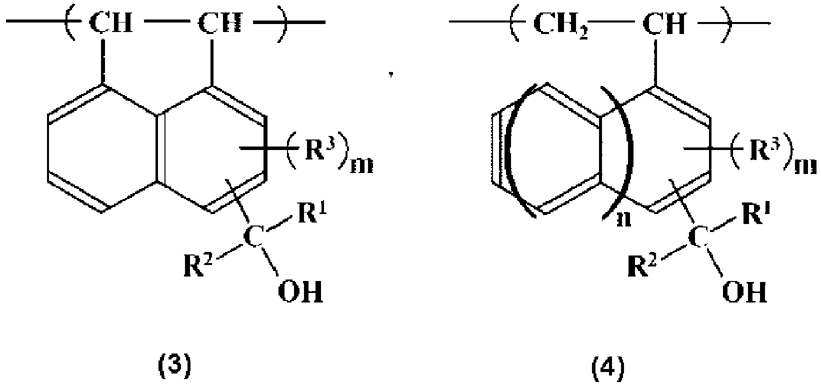

In the formulae (3) and (4), R¹ and R² represent a hydrogen atom, an alkyl group having 1 to 3 carbon atoms, or an aryl group; R³ represents an alkyl group having 1 to 3 carbon atoms, a vinyl group, an allyl group, or an optionally substituted aryl group; "n" represents 0 or 1; and "m" represents 0, 1, or 2. The symbols in the formulae are applied only in these formulae.

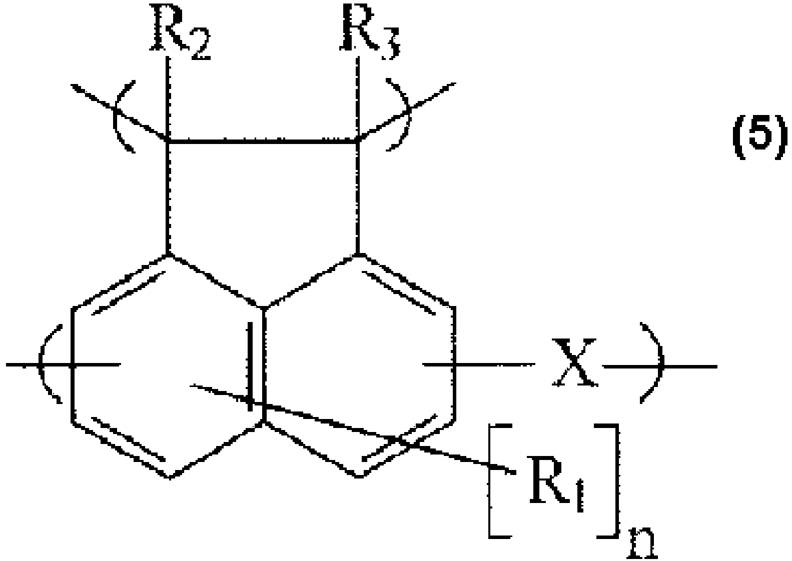

In the formula (5), R₁ represents a monovalent atom or group except for a hydrogen atom; "n" represents an integer of 0 to 4, provided that, when "n" represents 2 to 4, the plurality of R₁ may be same as or different from each other; R₂ and R₃ independently represent a monovalent atom or group; and X represents a divalent group. The symbols in the formula are applied only in this formula.

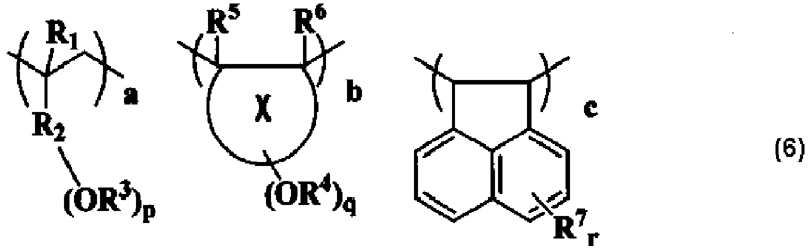

In the formula (6), R₁ represents a hydrogen atom or a methyl group; R₂ represents any one of a single bond, a linear, branched, or cyclic alkylene group having 1 to 20 carbon atoms, and an arylene group having 6 to 10 carbon atoms, R₂ optionally having any one of ether, ester, lactone, and amide; R₃ and R₄ each represent a hydrogen atom or a glycidyl group; X represents a polymer of any one of a hydrocarbon having an indene skeleton, a cycloolefin having 3 to 10 carbon atoms, and maleimide, X optionally having any one of ether, ester, lactone, and carboxylic anhydride; R₅ and R₆ each represent any one of a hydrogen atom, a fluorine atom, a methyl group, and a trifluoromethyl group; R₇ represents any one of a hydrogen atom, a linear, branched, or cyclic alkyl group having 1 to 6 carbon atoms, a hydroxy group, and an alkoxycarbonyl group; "p" and "q" each represent an integer of 1 to 4; "r" represents an integer of 0 to 4; and "a", "b", and "c" are each within a range of 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. The symbols in the formula are applied only in these formulae.

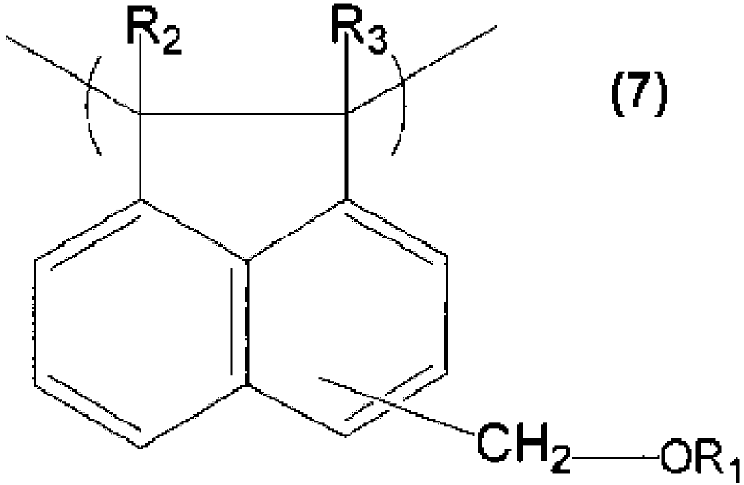

In the formula (7), R¹ represents a hydrogen atom or a monovalent organic group; and R² and R₃ each independently represent a monovalent atom or a monovalent organic group. The symbols in the formula are applied only in this formula.

Specific examples of the resin for forming an organic film applied to the present invention include resins described in JP 2004-205685 A, JP 2007-171895 A, and JP 2009-14816 A, and having the following structure.

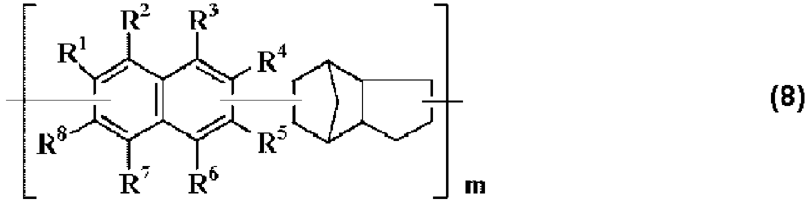

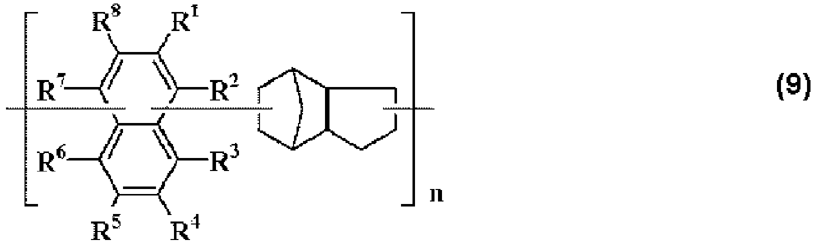

In the formulae (8) and (9), R¹ to R⁸ each independently represent a hydrogen atom, a hydroxy group, an optionally substituted alkyl group having 1 to 6 carbon atoms, an optionally substituted alkoxy group having 1 to 6 carbon atoms, an optionally substituted alkoxycarboxyl group having 2 to 6 carbon atoms, an optionally substituted aryl group having 6 to 10 carbon atoms, a hydroxyalkyl group having 1 to 6 carbon atoms, an isocyanate group, or a glycidyl group; and "m" and "n" represent a positive integer. The symbols in the formulae are applied only in these formulae.

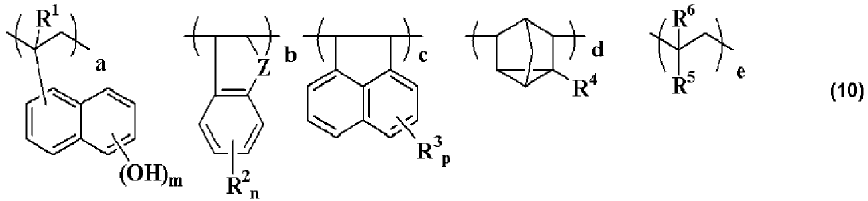

In the formula (10), R¹ and R⁶ represent a hydrogen atom or a methyl group; R², R³, and R⁴ represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, - C(=O)-O-R⁷, -O-C(=O)-R⁷, or -C(=O)-NR⁸-R⁷; "m" represents 1 or 2; "n" represents an integer of 0 to 4; "p" represents an integer of 0 to 6; R⁷ represents an organic group having 7 to 30 carbon atoms; R⁸ represents a hydrogen atoms or a hydrocarbon group having 1 to 6 carbon atoms; Z represents any one of a methylene group, -O-, -S-, and -NH-; and "a", "b", "c", "d", and "e" are each within a range of 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. The symbols in the formula are applied only in this formula.

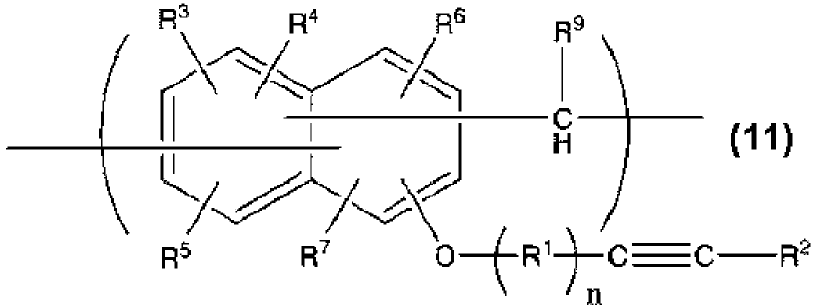

In the formula (11), "n" represents 0 or 1; R¹ represents an optionally substituted methylene group, an optionally substituted alkylene group having 2 to 20 carbon atoms, or an optionally substituted arylene group having 6 to 20 carbon atoms; R² represents a hydrogen atom, an optionally substituted alkyl group having 1 to 20 carbon atoms, or an optionally substituted aryl group having 6 to 20 carbon atoms; R³ to R⁷ represent a hydroxy group, an optionally substituted alkyl group having 1 to 6 carbon atoms, an optionally substituted alkoxy group having 1 to 6 carbon atoms, an optionally substituted alkoxycarbonyl group having 2 to 10 carbon atoms, an optionally substituted aryl group having 6 to 14 carbon atoms, or an optionally substituted glycidyl ether group having 2 to 6 carbon atoms; and R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. The symbols in the formula are applied only in this formula.

For example, the following compounds are exemplified.

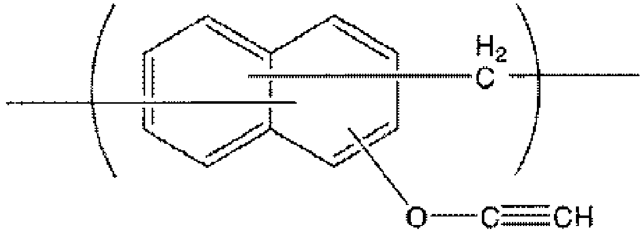

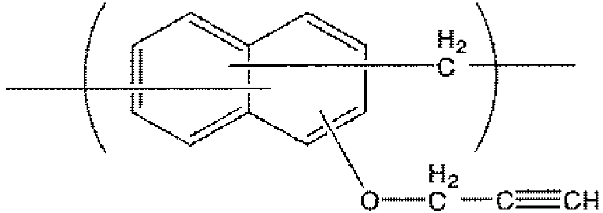

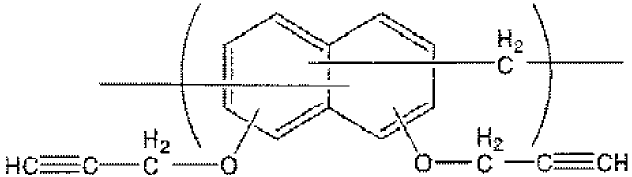

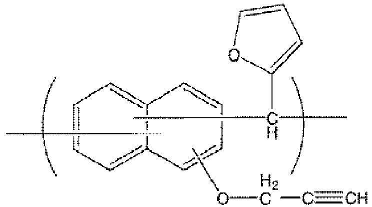

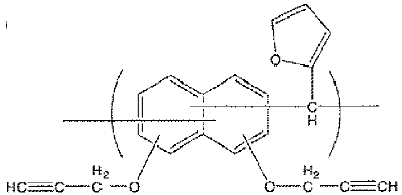

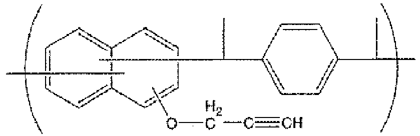

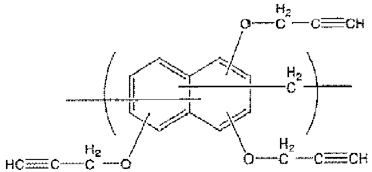

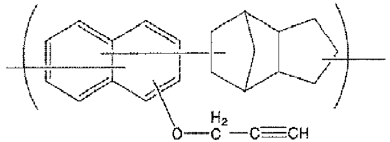

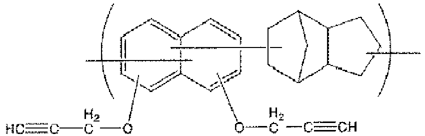

Examples of the resin for forming an organic film applied to the present invention include resins described in JP 2007-199653 A, JP 2008-274250 A, and JP 2010-122656 A, and having the following structure.

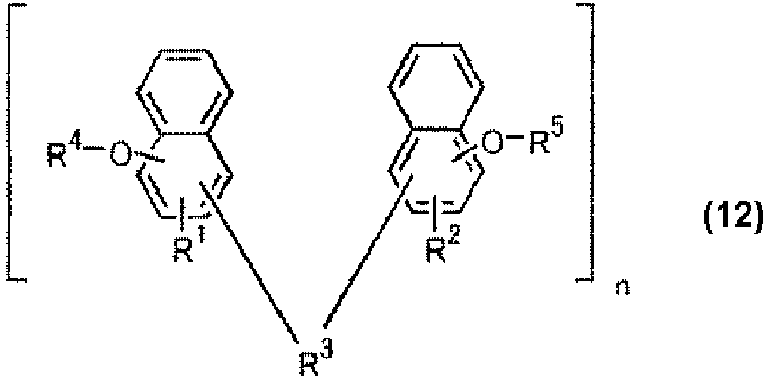

In the formula (12), R¹ and R² independently represent a hydrogen atom, a linear, branched, or cyclic alkyl group having 1 to 10 carbon atoms, an aryl group having 6 to 10 carbon atoms, or an alkenyl group having 2 to 10 carbon atoms, and these groups may be same as or different from each other; R³ represents a single bond or an alkylene group having 1 to 30 carbon atoms and having a linear, branched, or cyclic structure, and these groups optionally have a cross-linked cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. The symbols in the formula are applied only in this formula.

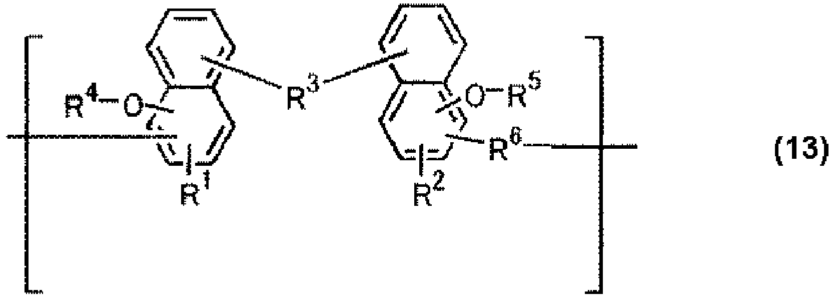

In the formula (13), R¹ and R² independently represent a hydrogen atom, a linear, branched, or cyclic alkyl group having 1 to 10 carbon atoms, an aryl group having 6 to 10 carbon atoms, or an alkenyl group having 2 to 10 carbon atoms, and these groups may be same as or different from each other; R³ represents a single bond or an alkylene group having 1 to 30 carbon atoms and having a linear, branched, or cyclic structure, these groups optionally have a cross-linked cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond, or a linear or branched alkylene group having 1 to 10 carbon atoms. The symbols in the formula are applied only in this formula.

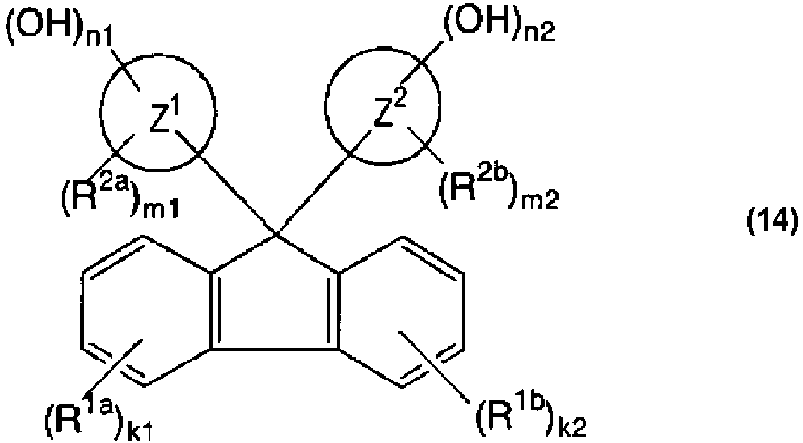

In the formula (14), the ring Z¹ and the ring Z² represent a condensed polycyclic aromatic hydrocarbon ring; R^{1a}, R^{1b}, R^{2a}, and R^{2b} represent same or different substituents. k1 and k2 represent same or different integers of 0 or 1 to 4; m1 and m2 each represent an integer of 0 or 1 or more; and n1 and n2 each represent an integer of 0 or 1 or more, and n1+n2 ≥ 1. The symbols in the formula are applied only in this formula.

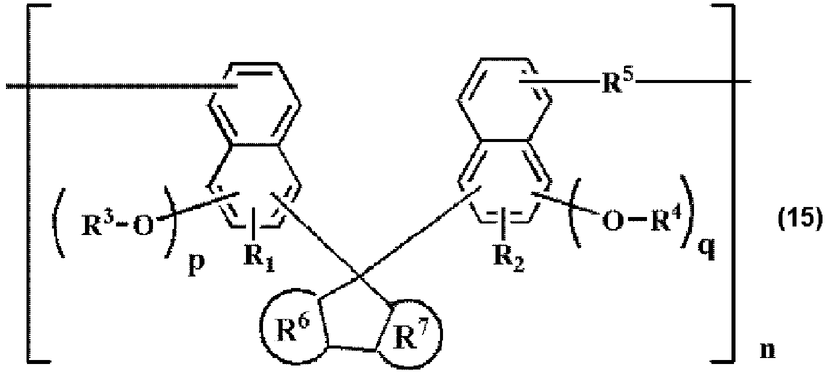

In the formula (15), R¹ and R² represent a hydrogen atom, a linear, branched, or cyclic alkyl group having 1 to 10 carbon atoms, an aryl group having 6 to 10 carbon atoms, or an alkenyl group having 2 to 10 carbon atoms, and these groups may be same as or different from each other; R³ and R⁴ each represent a hydrogen atom or a glycidyl group; R⁵ represents a single bond, or a linear or branched alkylene group having 1 to 10 carbon atoms; R⁶ and R⁷ represent a benzene ring or a naphthalene ring; "p" and "q" each represent 1 or 2; and "n" satisfies 0 < n ≤ 1. The symbols in the formula are applied only in this formula.

For example, the following compounds are exemplified.

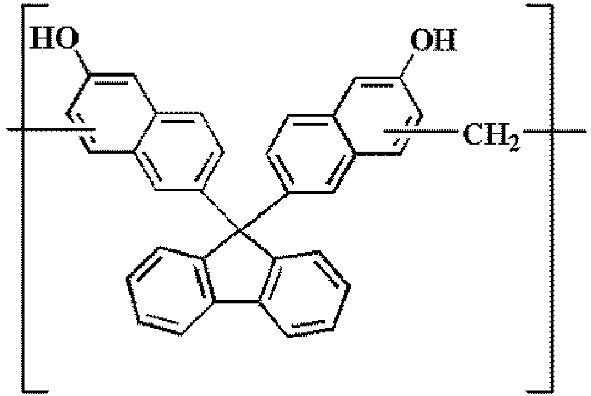

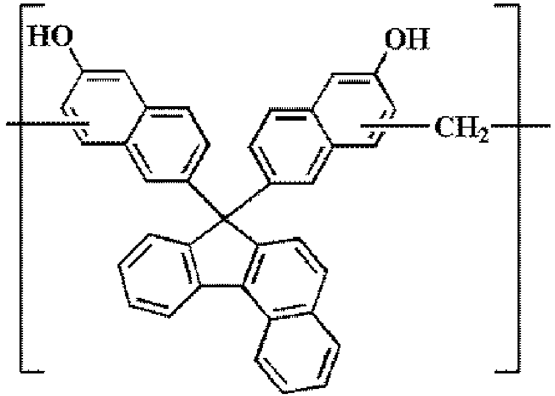

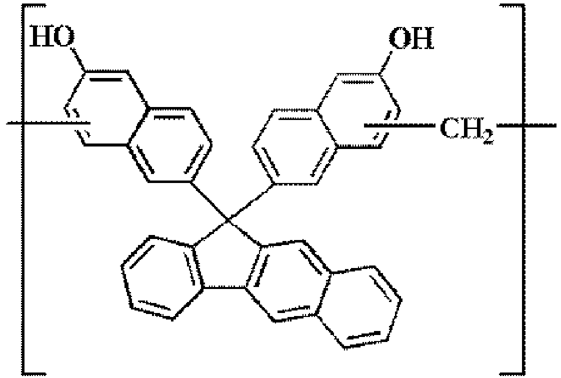

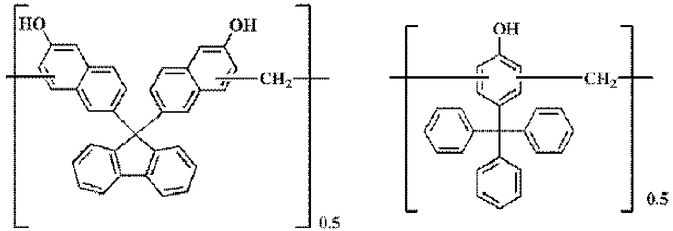

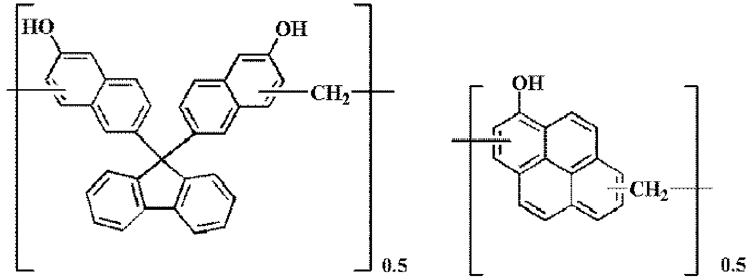

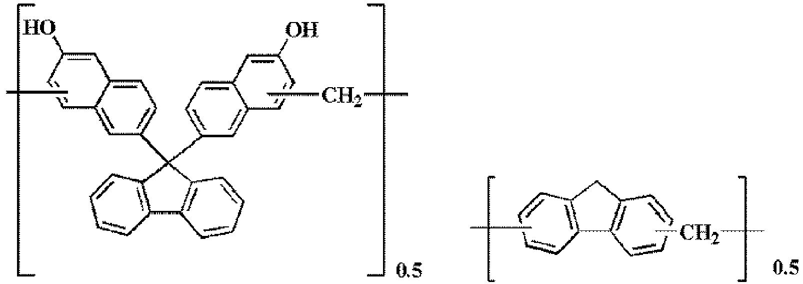

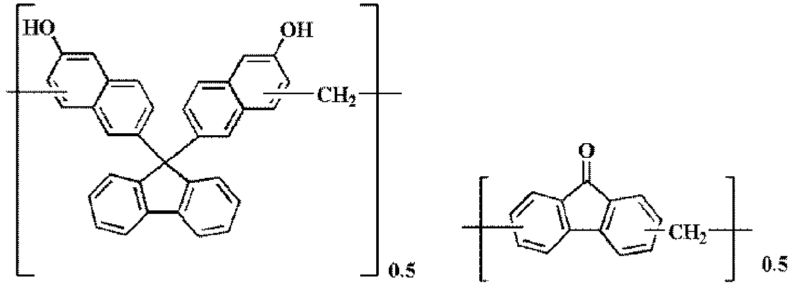

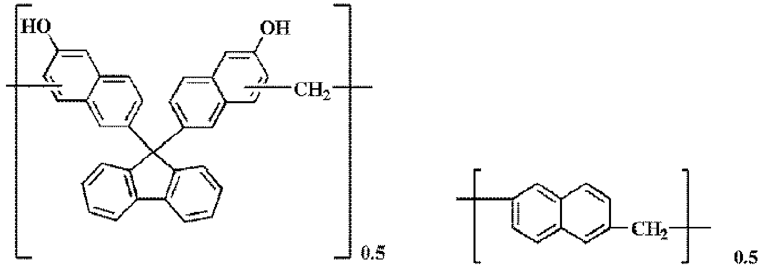

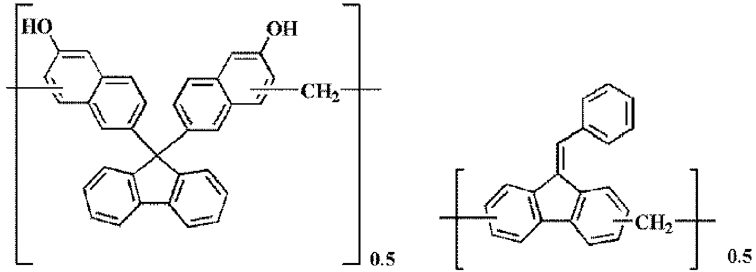

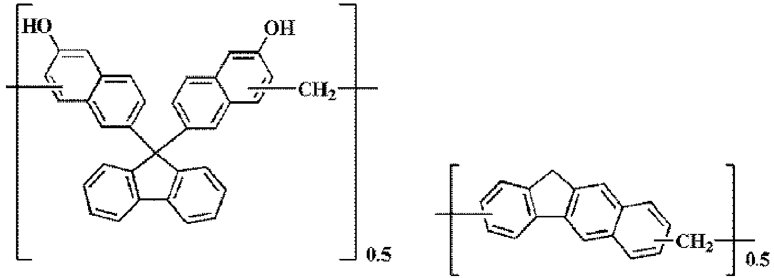

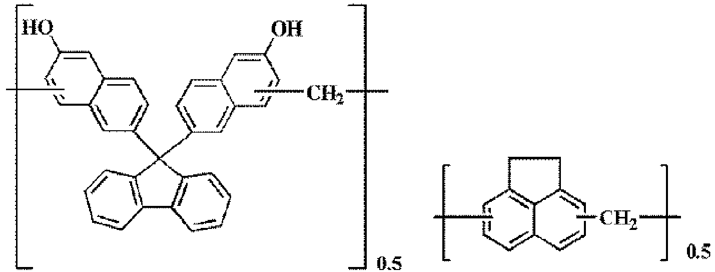

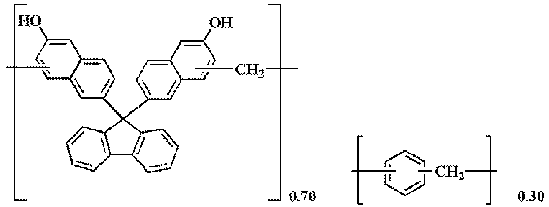

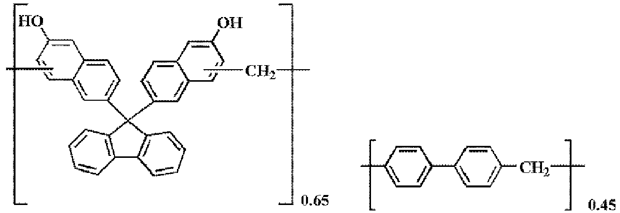

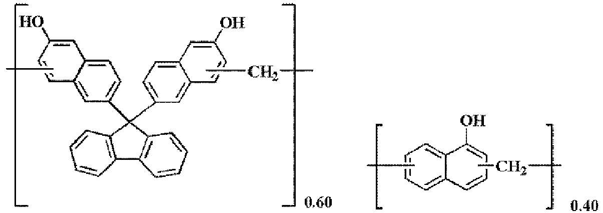

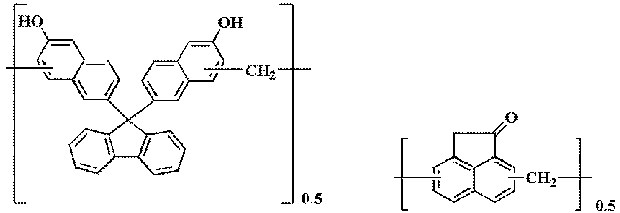

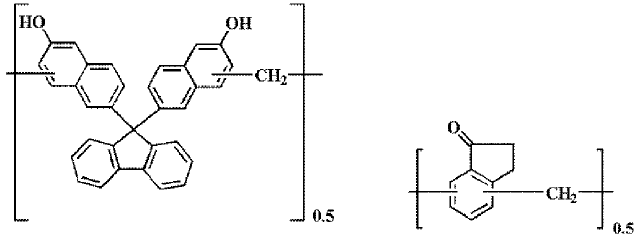

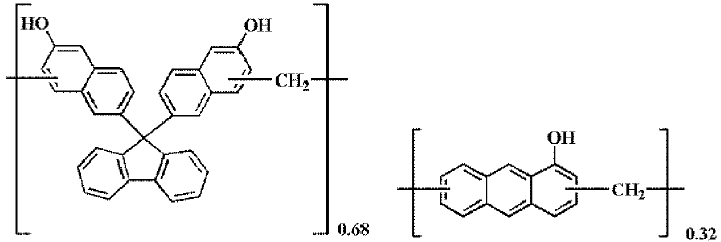

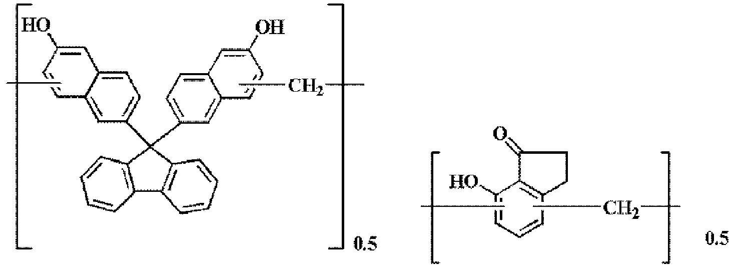

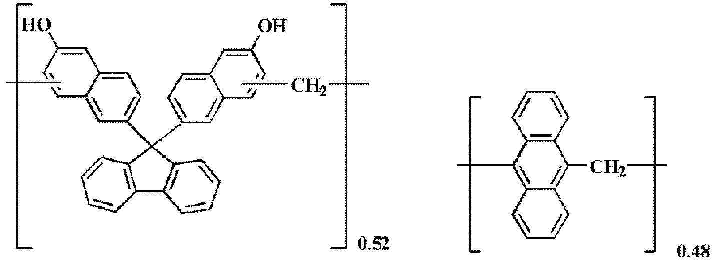

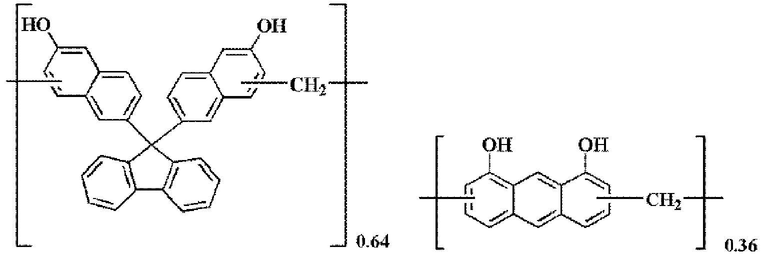

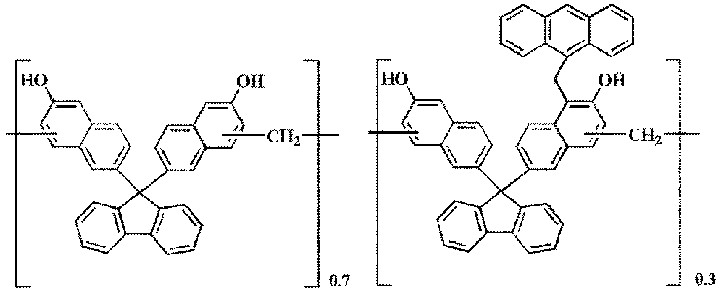

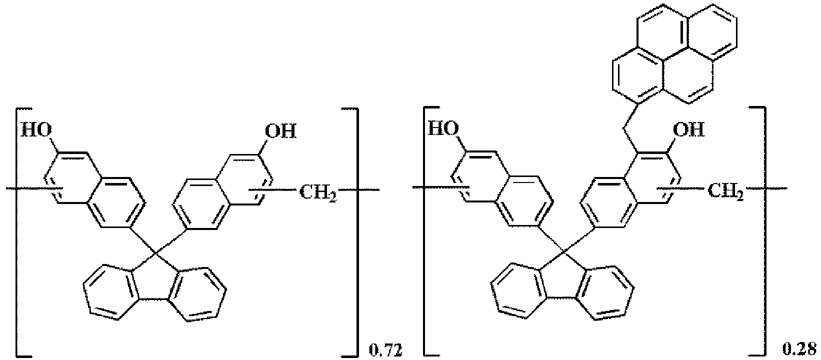

Examples of the resin for forming an organic film applied to the present invention include resins described in JP 2012-214720 A and having the following structure.

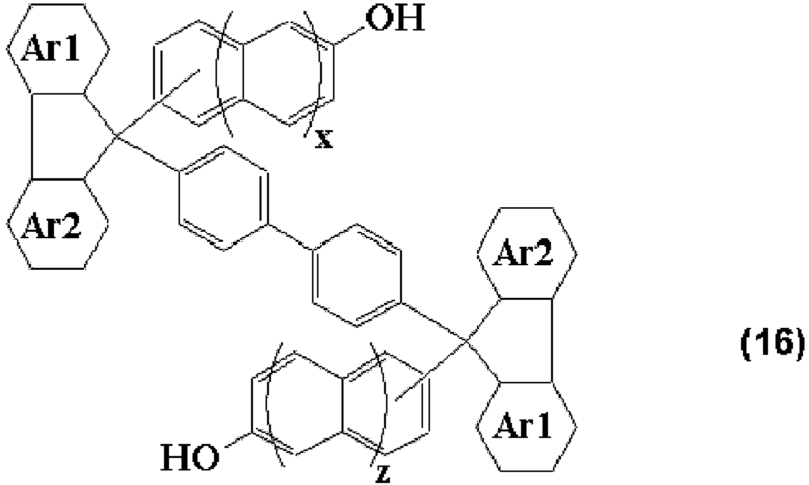

In the formula (16), the ring structures Ar1 and Ar2 represent a benzene ring or a naphthalene ring; and "x" and "z" each independently represent 0 or 1. The symbols in the formula are applied only in this formula.

Examples of the resin for forming an organic film applied to the present invention include resins described in JP 2014-29435 A, WO 2012/077640, and WO 2010/147155.

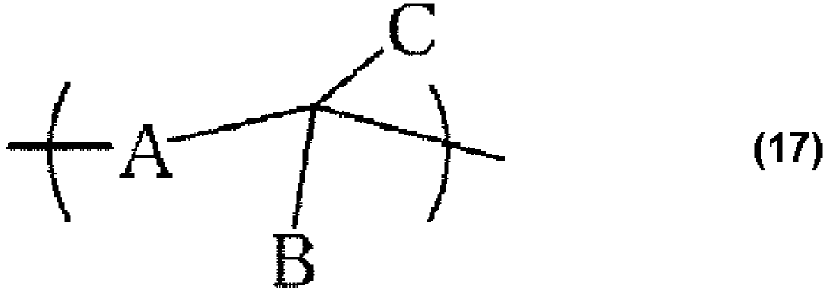

In the formula (17), A represents a structure having carbazole; B represents a structure having an aromatic ring; C represents a hydrogen atom, an alkyl group, or a structure having an aromatic ring, B and C optionally constitute a ring each other, and the structure including A, B, and C has 1 to 4 carboxyl groups or salts thereof, or carboxylate ester groups. The symbols in the formula are applied only in this formula.

Polymers described in WO 2012/077640 and having a unit structure represented by the following formula (18) and a unit structure represented by the following formula (19) can be exemplified. A ratio between the unit structure represented by the formula (18) and the unit structure represented by the formula (19) is 3 to 97 : 97 to 3 in a molar ratio.

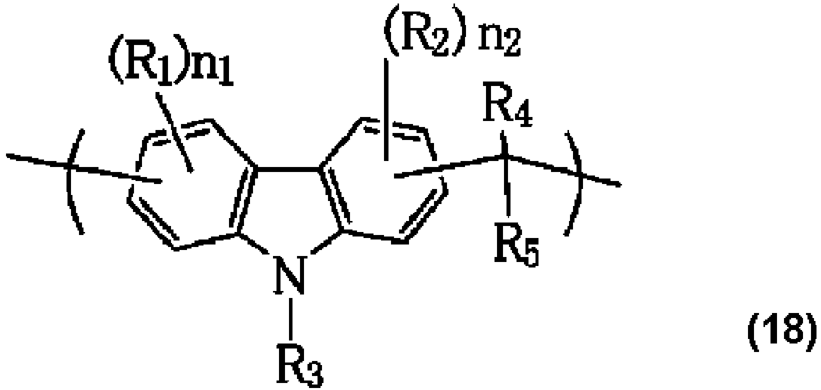

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of these groups and optionally having an ether bond, a ketone bond, or an ester bond; R₃ represents a hydrogen atom, an alkyl group having 1 to 10 carbon atoms, an alkenyl group having 2 to 10 carbon atoms, an aryl group having 6 to 40 carbon atoms, or a combination of these groups and optionally having an ether bond, a ketone bond, or an ester bond; R₄ represents a hydrogen atom, an aryl group having 6 to 40 carbon atoms, or a heterocyclic group, and the aryl group is optionally substituted with a halogen atom, a nitro group, an amino group, or a hydroxy group; R₅ represents a hydrogen atom, an alkyl group having 1 to 10 carbon atoms, an aryl group having 6 to 40 carbon atoms, or a heterocyclic group, the alkyl group is optionally substituted with a halogen atom, a nitro group, an amino group, or a hydroxy group; R₄ and R₅ optionally form a ring each other; and n1 and n2 each represent an integer of 1 to 3. The symbols in the formula are applied only in this formula.

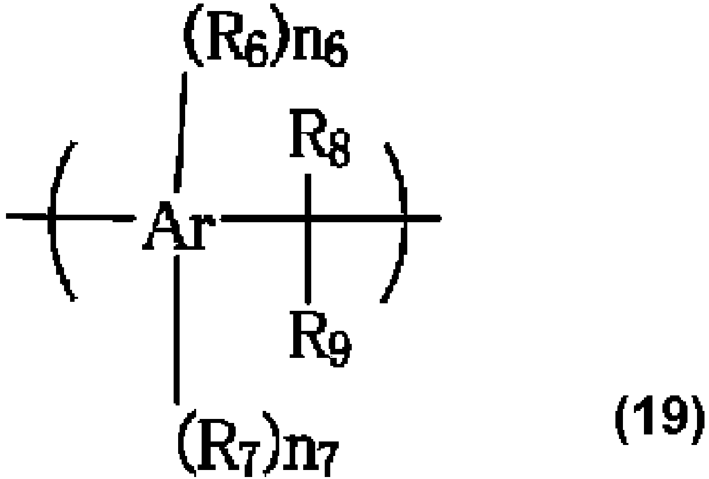

In the formula (19), Ar represents an aromatic ring group having 6 to 20 carbon atoms; R₆ represents a hydroxy group; R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of these groups and optionally having an ether bond, a ketone bond, or an ester bond; R₈ represents a hydrogen atom, an aryl group having 6 to 40 carbon atoms, or a heterocyclic group, and the aryl group is optionally substituted with a halogen atom, a nitro group, an amino group, or a hydroxy group; R₉ represents a hydrogen atom, an alkyl group having 1 to 10 carbon atoms, an aryl group having 6 to 40 carbon atoms, or a heterocyclic group, and the alkyl group is optionally substituted with a halogen atom, a nitro group, an amino group, or a hydroxy group; R₈ and R₉ optionally form a ring each other; n6 represents an integer of 1 to "p"; and n7 represents an integer of p-n6, and "p" here represents a maximum number of substituents that the aromatic ring group Ar can have. The symbols in the formula are applied only in this formula.

Examples of the resin for forming an organic film applied to the present invention include polymers described in WO 2010/147155 and having a unit structure represented by the following formula (20).

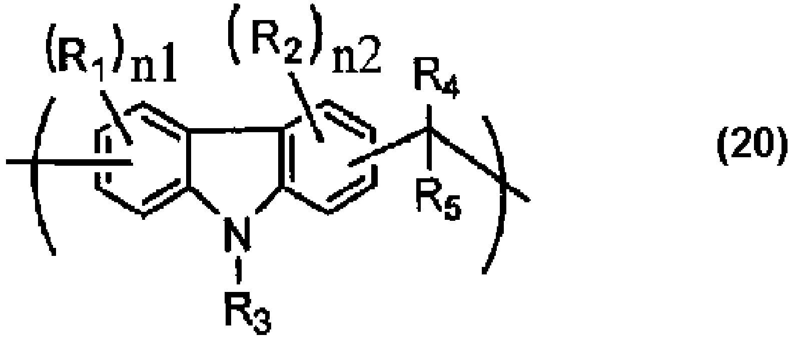

In the formula (20), R₁ and R₂ are each selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and a combination of these groups, and the alkyl group, the alkenyl group, or the aryl group optionally has an ether bond, a ketone bond, or an ester bond; R₃ is selected from the group consisting of a hydrogen atom, an alkyl group having 1 to 10 carbon atoms, an alkenyl group having 2 to 10 carbon atoms, an aryl group having 6 to 40 carbon atoms, and a combination of these groups, and the alkyl group, the alkenyl group, or the aryl group optionally has an ether bond, a ketone bond, or an ester bond; R₄ represents an aryl group or heterocyclic group having 6 to 40 carbon atoms, and the aryl group and the heterocyclic group are optionally substituted with a halogen group, a nitro group, an amino group, or a hydroxy group; R₅ represents a hydrogen atom, an alkyl group having 1 to 10 carbon atoms, an aryl group having 6 to 40 carbon atoms, or a heterocyclic group, and the alkyl group are optionally substituted with a halogen group, a nitro group, an amino group, or a hydroxy group; R₄ and R₅ optionally form a ring together with the carbon atom to which R₄ and R₅ are bonded; and n1 and n2 each represent an integer of 1 to 3. The symbols in the formula are applied only in this formula.

Examples of the resin for forming an organic film applied to the present invention include novolac resins, and resins having a repeating unit structure described in WO 2012/176767 and represented by the following formula (21). The novolac resins are obtained by a reaction of: one or two or more kinds of phenols, such as phenol, cresol, xylenol, catechol, resorcinol, hydroquinone, pyrogallol, hydroxyquinol, and phloroglucinol; and one or two or more kinds of aldehyde sources, such as formaldehyde, paraformaldehyde, and trioxane, using an acidic catalyst.

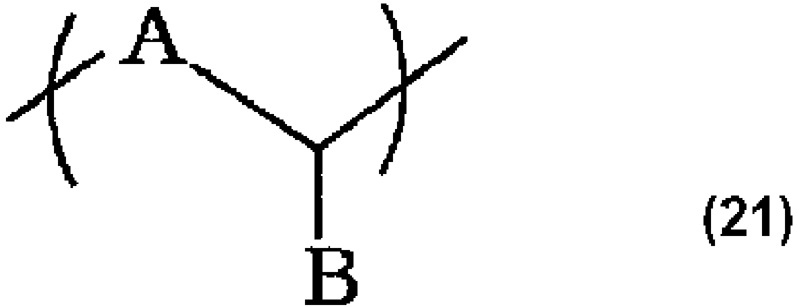

In the formula (21), A represents a hydroxyl-group-substituted phenylene group derived from a polyhydroxybenzene; and B represents a monovalent condensed aromatic hydrocarbon ring group in which two to six benzene rings are condensed. The symbols in the formula are applied only in this formula.

Examples of the resin for forming an organic film applied to the present invention include resins described in JP 2005-128509 A, JP 2006-259249 A, JP 2006-259482 A, JP 2006-293298 A, and JP 2007-316282 A. In the resins, a novolac resin having a fluorene or tetrahydrospirobiindene structure has a repeating unit structure represented by the following formula (22-1) or (22-2).

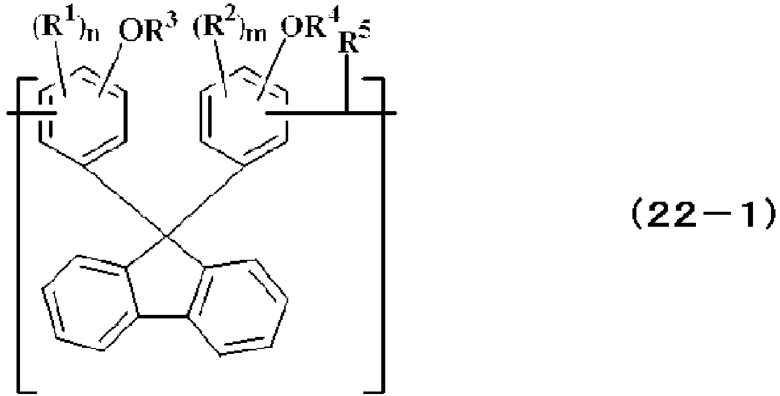

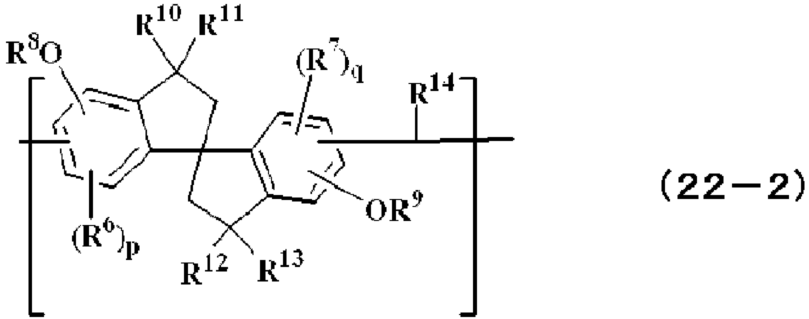

In the formulae (22-1) and (22-2), R¹, R², R⁶, and R⁷ independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; R⁵ and R¹⁴ independently represent a hydrogen atom, a linear, branched, or cyclic alkyl group having 1 to 10 carbon atoms, or an aryl group having 6 to 10 carbon atoms; "n", "m", "p", and "q" represent an integer of 1 to 3; and R¹⁰ to R¹³ independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. The symbols in the formulae are applied only in these formulae.

Examples of the resin for forming an organic film applied to the present invention include reaction products obtained by a method described in JP 2012-145897 A.

More specifically, a polymer obtained by condensing: one or more kinds of compounds represented by the following general formulae (23-1) and/or (23-2); and one or more kinds of compounds represented by the following general formulae (24-1) and/or (24-2), and/or equivalents thereof can be exemplified.

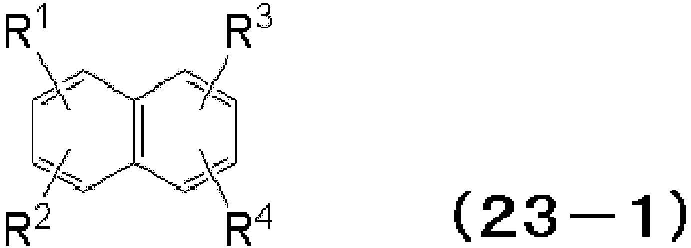

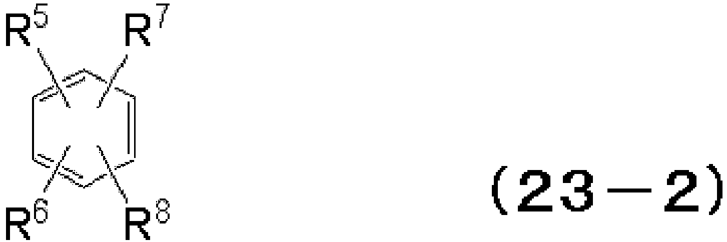

In the formulae (23-1) and (23-2), R¹ to R⁸ each independently represent a hydrogen atom, a halogen atom, a hydroxy group, an isocyanate group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or an optionally substituted saturated or unsaturated organic group having 1 to 30 carbon atoms, and furthermore, any two substituents freely selected from each of R¹ to R⁴ or R⁵ to R⁸ are optionally bonded in the molecule to form an additional cyclic substituent. The symbols in the formulae are applied only in these formulae.

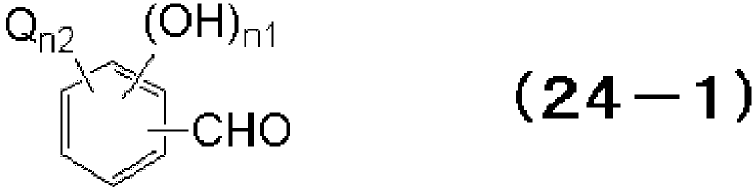

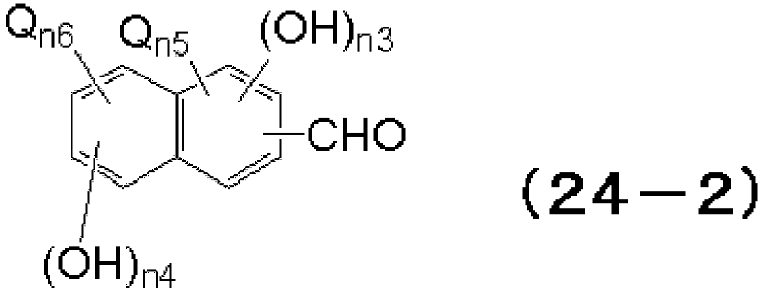

In the formulae (24-1) and (24-2), Q represents an optionally substituted organic group having 1 to 30 carbon atoms, furthermore, any two Q freely selected in the molecule are optionally bonded to form a cyclic substituent; and n1 to n6 represent a number of each substituent, and n1 to n6 = 0, 1, or 2. The formula (24-1) excludes hydroxybenzaldehyde. The formula (24-2) satisfies relationships of 0 ≤ n3+n5 ≤ 3, 0 ≤ n4+n6 ≤ 4, and 1 ≤ n3+n4 ≤ 4. The symbols in the formulae are applied only in these formulae.

Polymers obtained by condensing: one or more kinds of compounds represented by the general formulae (23-1) and/or (23-2); one or more kinds of compounds represented by the general formulae (24-1) and/or (24-2) and/or equivalents thereof; and one or more kinds of compounds represented by the general formula (25) and/or equivalents thereof can be exemplified.

Y-CHO (25)

In the formula (25), Y represents a hydrogen atom or an optionally substituted monovalent organic group having 30 or less carbon atoms. The formula (25) differs from the formulae (24-1) and (24-2). The symbols in the formula are applied only in this formula.

Examples of the resin for forming an organic film applied to the present invention include resins described in JP 2017-119671 A and having the following structure.

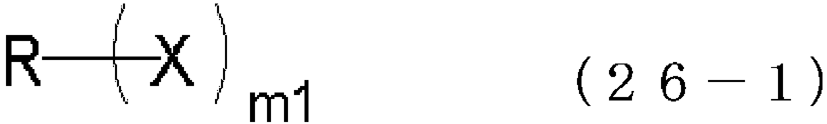

In the formula (26-1), R represents a single bond or an organic group having 1 to 50 carbon atoms; X represents a group represented by the following general formula (26-2); and m1 represents an integer satisfying 2 ≤ m1 ≤ 10. The symbols in the formula are applied only in this formula.

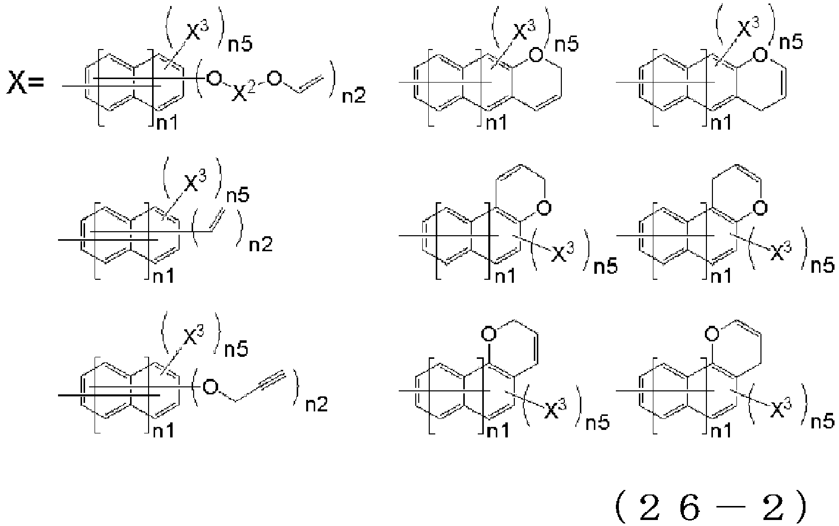

In the formula, X² represents a divalent organic group having 1 to 10 carbon atoms; n1 represents 0 or 1; n2 represents 1 or 2; X³ represents a group represented by the following general formula (26-3); and n5 represents 0, 1, or 2. The symbols in the formulae are applied only in this formula.

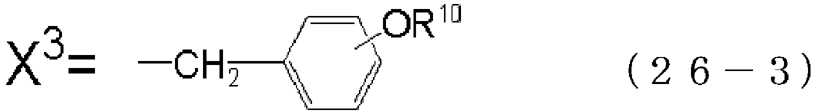

In the formula, R¹⁰ represents a hydrogen atom or a saturated or unsaturated hydrocarbon group having 1 to 10 carbon atoms. In the formula, hydrogen atoms on the benzene ring are optionally substituted with a methyl group or a methoxy group. The symbols in the formula are applied only in these formulae.

For example, the following compounds are exemplified.

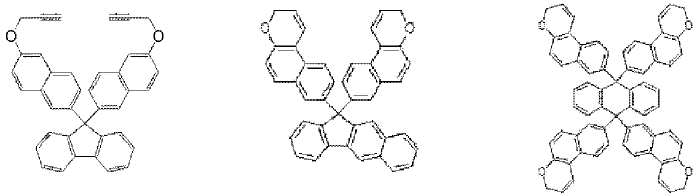

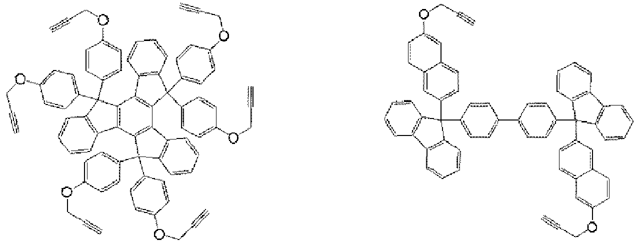

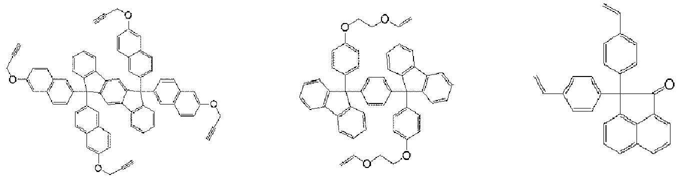

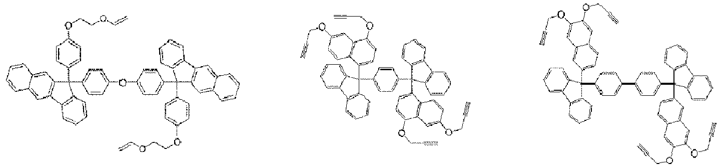

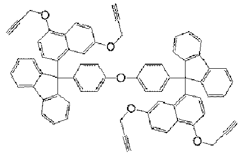

Examples of the resin for forming an organic film applied to the present invention include polymers described in JP 2019-44022 A and having a repeating unit represented by the following general formula (27-1).

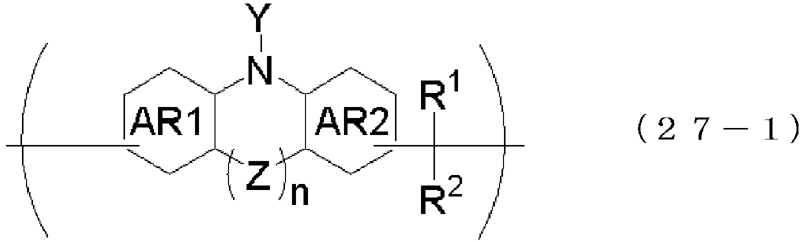

In the formula (27-1), AR1 and AR2 represent an optionally substituted benzene ring or naphthalene ring; R¹ and R² each independently represent a hydrogen atom or an organic group having 1 to 30 carbon atoms, and when R¹ and R² represent organic groups, R¹ and R² are optionally bonded in the molecule to form a cyclic organic group; "n" represents 0 or 1, when n=0, AR1 and AR2 do not form a cross-linked structure of the aromatic rings of AR1 and AR2 via Z, and when n=1, AR1 and AR2 form a cross-linked structure of the aromatic rings of AR1 and AR2 via Z; Z represents a single bond or any one group represented by the following formula (27-2); and Y represents a group represented by the following formula (27-3). The symbols in the formula are applied only in this formula. 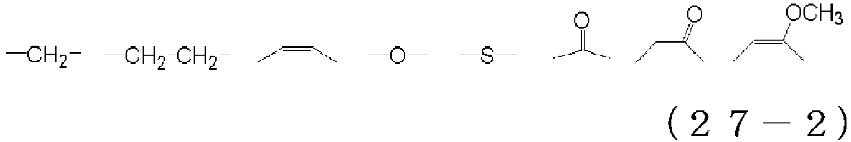 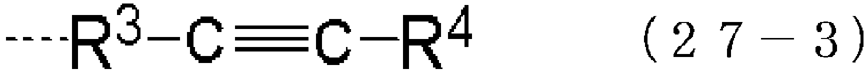 In the formula, R³ represents a single bond or a divalent organic group having 1 to 20 carbon atoms; R⁴ represents a hydrogen atom or a monovalent organic group having 1 to 20 carbon atoms; and a broken line represents an attachment point. The symbols in the formula are applied only in this formula.

For example, the following polymers are exemplified.

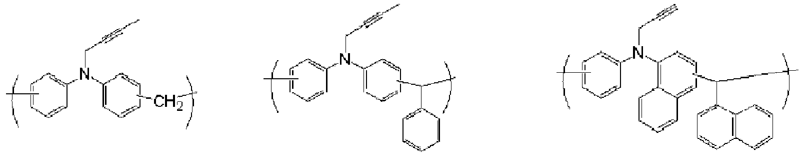

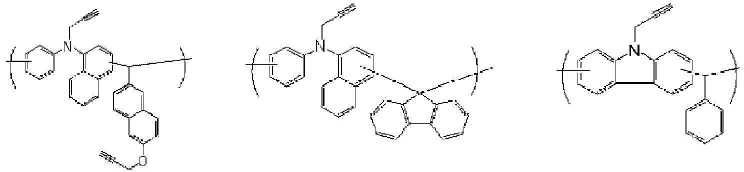

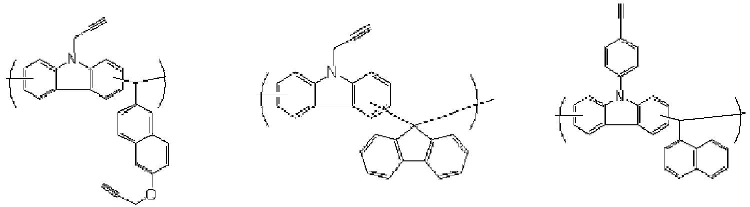

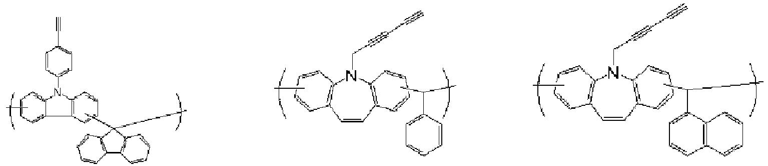

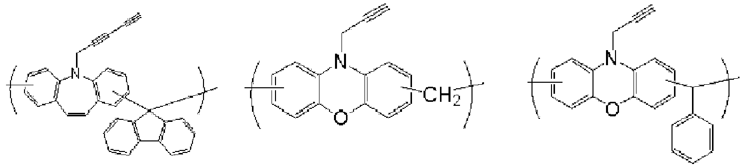

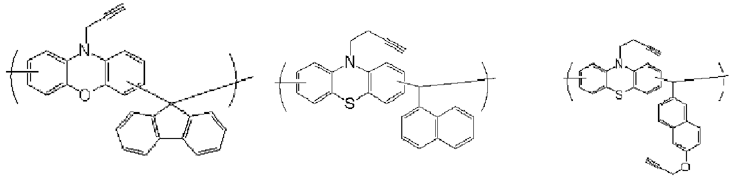

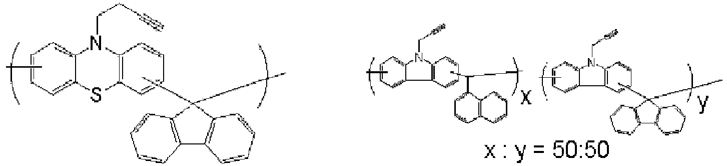

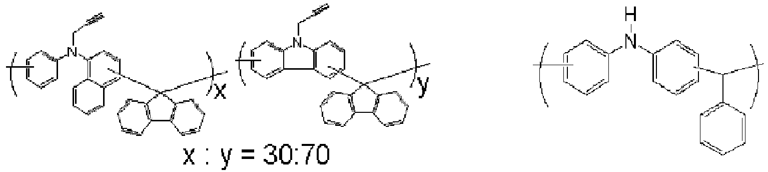

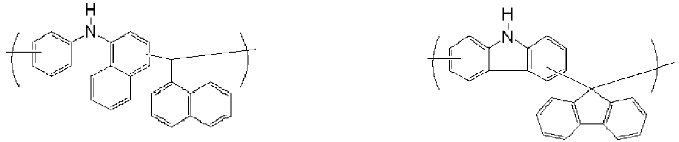

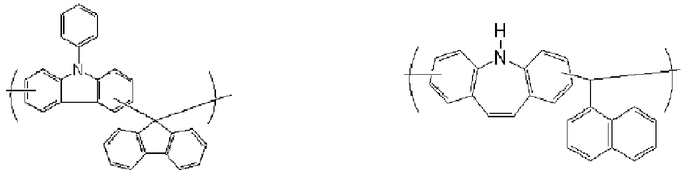

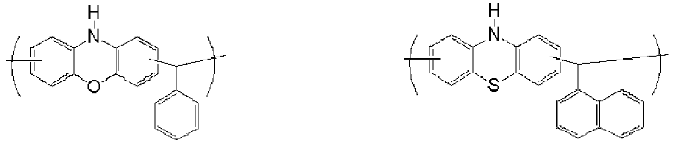

The resin for forming an organic film may be synthesized by known methods, or commercially available products may be used.

A blending amount of the resin for forming an organic film is not particularly limited as long as the film-formability with spin-coating of the composition for forming an organic film is satisfied. The content of the resin for forming an organic film is more preferably 10 parts by mass to 40 parts by mass, further preferably 10 parts by mass to 30 parts by mass, and further preferably 10 parts by mass to 25 parts by mass relative to 100 parts by mass of the composition for forming an organic film. For example, when holes or trenches with an extremely high aspect ratio for 3D NAND memory architecture are filled with the composition for forming an organic film, the blending amount of the resin for forming an organic film needs to be increased. Meanwhile, such a composition for forming an organic film has high viscosity to deteriorate in-plane uniformity and filling characteristics after spin-coating. The composition for forming an organic film of the present invention can be suitably applied because the composition can form the organic film having excellent in-plane uniformity and filling characteristics even with the above blending proportion of the resin for forming an organic film.

### Solvent

The solvent usable in the composition for forming an organic film of the present invention is not particularly limited as long as it can dissolve the resin for forming an organic film and the polymer. Favorably, the solvent can also dissolve an acid generator, a crosslinker, a surfactant, etc., described later. Specific examples thereof include: ketones, such as 2-heptanone, cyclopentanone, and cyclohexanone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, γ-butyrolactone, and propylene glycol mono-tert-butyl ether acetate. One or two or more kinds thereof may be mixed for use, and the solvent is not limited thereto.

Among these, propylene glycol monomethyl ether acetate, propylene glycol monomethyl ether, 2-heptanone, cyclopentanone, cyclohexanone, γ-butyrolactone, and a mixture of two or more kinds thereof are preferably used.

### Other Components

With the composition for forming an organic film of the present invention, an acid generator and a crosslinker to further promote the crosslinking reaction may be added. The acid generator includes an acid generator to generate an acid by pyrolysis and an acid generator to generate an acid by light irradiation, and any of them may be added. Specific examples of the acid generator include acid generators described in paragraphs [0061] to [0085] of JP 2007-199653 A.

Specific examples of the crosslinker include crosslinkers described in paragraphs [0055] to [0060] of JP 2007-199653 A.

With the composition for forming an organic film of the present invention, a surfactant may be added to further improve the in-plane uniformity by spin-coating. Specific examples of the surfactant include surfactants described in paragraphs [0142] to [0147] in JP 2009-269953 A.

With the composition for forming an organic film of the present invention, a basic compound to improve storage stability may be further added. The basic compound prevents proceeding of the crosslinking reaction due to a small amount of an acid generated from the acid generator, and plays a role of a quencher against the acid. Specific examples of such a basic compound include compounds described in paragraphs [0086] to [0090] in JP 2007-199653 A.

As above, the composition for forming an organic film of the present invention is the composition for forming an organic film having excellent hump inhibition in the EBR process. Therefore, the composition for forming an organic film of the present invention is extremely useful as a resist underlayer film material for a multilayer resist process such as: a two-layer resist process; a three-layer resist process using a silicon-containing resist intermediate film or a silicon-containing inorganic hard mask; and a four-layer resist process using a silicon-containing resist intermediate film or a silicon-containing inorganic hard mask, and an organic anti-reflection film or an adhesion film.

### Method for Forming Organic Film

The present invention provides a method for forming an organic film used in a semiconductor device manufacturing process, the method comprising steps of: applying the above composition for forming an organic film of the present invention on a substrate to be processed by spin-coating; and heat-treating the substrate coated with the composition for forming an organic film at a temperature of 100°C or higher and 600°C or lower within a range of 10 seconds to 600 seconds for forming a cured film.

In this method for forming an organic film, the above composition for forming an organic film of the present invention is firstly applied rotationally on the substrate to be processed (spin-coating). Use of the spin-coating method can yield a good filling characteristics. After the coating on the edge is removed in the EBR process, baking (thermal treatment) is performed in order to promote the crosslinking reaction. This baking can evaporate the solvent in the composition, and thereby can prevent mixing even when the resist upper layer film or the silicon-containing resist intermediate film is formed on the organic film.

The baking is performed at a temperature of 100°C or higher and 600°C or lower within a range of 10 to 600 seconds, and preferably performed at a temperature of 200°C or higher and 500°C or lower within a range of 10 to 300 seconds. With considering effects on device damage and wafer deformation, an upper limit of the heating temperature in the wafer process with lithography is preferably 600°C or lower, and more preferably 500°C or lower. The thermal treatment under such conditions can promote the crosslinking reaction to form an organic film without mixing with the film to be formed above.

### Patterning Process

### Three-Layer Resist Process using Silicon-Containing Resist Intermediate Film

The present invention provides a patterning process comprising steps of: forming an organic film on a body to be processed by using the aforementioned composition for forming an organic film of the present invention; forming a resist intermediate film on the organic film by using a resist intermediate film material containing a silicon atom; forming a resist upper layer film on the resist intermediate film by using a resist upper layer film material composed of a photoresist composition; forming a circuit pattern in the resist upper layer film; transferring the pattern to the resist intermediate film by etching while using the circuit-patterned resist upper layer film as a mask; transferring the pattern to the organic film by etching while using the patterned resist intermediate film as a mask; and transferring the pattern to the body to be processed by etching while using the patterned organic film as a mask.

As the body to be processed, a semiconductor device substrate, or a substrate in which any of a metal film, a metal carbide film, a metal oxide film, a metal nitride film, a metal oxycarbide film, and a metal oxynitride film is formed on the semiconductor device substrate is preferably used. More specifically, a substrate such as Si, α-Si, p-Si, SiO₂, SiN, SiON, W, TiN, and Al; a substrate in which the above metal film, etc. is formed on the substrate as a layer to be processed; etc. are used, but not particularly limited thereto.

As the layer to be processed, various low-k films such as Si, SiO₂, SiON, SiN, p-Si, α-Si, W, W-Si, Al, Cu, and Al-Si, and stopper films thereof are used. The layer to be processed can be formed to have a thickness of typically 50 to 10,000 nm, and particularly 100 to 5,000 nm. When the layer to be processed is formed, the substrate and the layer to be processed having different materials are used.

A metal to constitute the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When the organic film is formed on the body to be processed by using the composition for forming an organic film of the present invention, the above method for forming an organic film of the present invention is applied.

Then, the resist intermediate film (silicon-containing resist intermediate film) is formed on the organic film by using the resist intermediate film material containing a silicon atom. As the resist intermediate film material containing a silicon atom, a polysiloxane-based intermediate film material is preferable. Imparting an anti-reflective effect to the silicon-containing resist intermediate film can inhibit reflection. In particular, using a material for 193-nm exposure containing a large amount of aromatic groups and having high etching selectivity to the substrate as the composition for forming an organic film increases the k-value to increase reflection on the substrate. However, the silicon-containing resist intermediate film having the absorption so as to have an appropriate k-value can inhibit the reflection, resulting in the substrate reflection of 0.5% or less. Preferably used for the silicon-containing resist intermediate film having the anti-reflective effect are anthracene for 248-nm or 157-nm exposure, and a polysiloxane crosslinkable with an acid or heat for 193-nm exposure. The polysiloxane has a light absorption group having a phenyl group or silicon-silicon bond at the pendant structure.

Then, the resist upper layer film is formed on the resist intermediate film by using the resist upper layer film material composed of the photoresist composition. The resist upper layer film material may be any of positive-type or negative-type, and a material same as commonly used photoresist compositions may be used. After the resist upper layer film material is applied by spin-coating, the pre-baking is preferably performed within a range at 60 to 180°C for 10 to 300 seconds. Thereafter, the exposure, then post exposure bake (PEB), and development are performed in accordance with a common method to obtain the resist upper layer film pattern. A thickness of the resist upper layer film is not particularly limited, and preferably 30 to 500 nm, particularly preferably 50 to 400 nm.

Then, the circuit pattern (resist upper layer film pattern) is formed in the resist upper layer film. The circuit pattern is preferably formed by lithography using light having a wavelength of 10 nm or longer and 300 nm or shorter, direct writing with electron beam, nanoimprinting, or a combination thereof.

Examples of the exposure light include high-energy ray having a wavelength of 300 nm or shorter, and specifically, far ultraviolet ray, KrF excimer laser light (248 nm), ArF excimer laser light (193 nm), F₂ excimer laser light (157 nm), Kr₂ laser light (146 nm), Ar₂ laser light (126 nm), soft X-ray with 3 to 20 nm (EUV), electron beam (EB), ion beam, and X-ray.

The circuit pattern is preferably developed with alkaline development or an organic solvent.

Then, the pattern is transferred to the resist intermediate film by etching while using the circuit-patterned resist upper layer film as a mask. The etching of the resist intermediate film while using the resist upper layer film pattern as a mask is preferably performed by using a fluorocarbon-based gas. This etching forms the silicon-containing resist intermediate film pattern.

Then, the pattern is transferred to the organic film by etching while using the patterned resist intermediate film as a mask. Since the silicon-containing resist intermediate film has etching resistance against oxygen gas or hydrogen gas, the etching of the organic film while using the silicon-containing resist intermediate film pattern as a mask is preferably performed by using an etching gas mainly composed of oxygen gas or hydrogen gas. This etching forms the organic film pattern.

Then, the pattern is transferred to the body to be processed by etching while using the patterned organic film as a mask. The subsequent etching of the body to be processed (layer to be processed) may be performed by a common method. For example, when the body to be processed is SiO₂-based, SiN-based, or silica-based low dielectric-constant insulative film, the etching is performed mainly using a fluorocarbon-based gas. When the body to be processed is p-Si, Al, or W, the etching is performed mainly using a chlorine-based or bromine-based gas. When the substrate is processed by etching using the fluorocarbon-based gas, the silicon-containing resist intermediate film pattern is simultaneously removed with the substrate processing. Meanwhile, when the substrate is processed by etching using the chlorine-based or bromine-based gas, dry-etching removal using the fluorocarbon-based gas is required to be separately performed after the substrate processing in order to remove the silicon-containing resist intermediate film pattern.

The organic film obtained by using the composition for forming an organic film of the present invention has excellent etching resistance during the above etching of the body to be processed.

### Four-Layer Resist Process using Silicon-Containing Resist Intermediate Film, and Organic Anti-Reflection Film or Adhesion Film

In addition, the present invention provides a patterning process comprising steps of: forming an organic film on a body to be processed by using the aforementioned composition for forming an organic film of the present invention; forming a resist intermediate film on the organic film by using a resist intermediate film material containing a silicon atom; forming an organic anti-reflection film or an adhesion film on the resist intermediate film; forming a resist upper layer film on the organic anti-reflection film or the adhesion film by using a resist upper layer film material composed of a photoresist composition; forming a circuit pattern in the resist upper layer film; transferring the pattern to the organic anti-reflection film or the adhesion film, and the resist intermediate film by etching while using the circuit-patterned resist upper layer film as a mask; transferring the pattern to the organic film by etching while using the patterned resist intermediate film as a mask; and transferring the pattern to the body to be processed by etching while using the patterned organic film as a mask.

This method can be performed in the same manner as the above three-layer resist process using the silicon-containing resist intermediate film except that the organic anti-reflective film (BARC) or the adhesive film is formed between the resist intermediate film and the resist upper layer film.

The organic anti-reflective film and the adhesive film may be formed with spin-coating by using a known organic anti-reflective film material or adhesion film material.

### Three-Layer Resist Process using Inorganic Hard Mask

In addition, the present invention provides, as a patterning process with a three-resist process using the aforementioned composition for forming an organic film of the present invention, a patterning process comprising steps of: forming an organic film on a body to be processed by using the aforementioned composition for forming an organic film of the present invention; forming an inorganic hard mask selected from a silicon oxide film, a silicon nitride film, and a silicon oxynitride film on the organic film; forming a resist upper layer film on the inorganic hard mask by using a resist upper layer film material composed of a photoresist composition; forming a circuit pattern in the resist upper layer film; transferring the pattern to the inorganic hard mask by etching while using the circuit-patterned resist upper layer film as a mask; transferring the pattern to the organic film by etching while using the patterned inorganic hard mask as a mask; and transferring the pattern to the body to be processed by etching while using the patterned organic film as a mask.

This method can be performed in the same manner as the above three-layer resist process using the silicon-containing resist intermediate film except that the inorganic hard mask is formed on the organic film instead of the resist intermediate film.

The inorganic hard mask selected from a silicon oxide film, a silicon nitride film, and a silicon oxynitride film (SiON film) can be formed by a CVD method, an ALD method, etc. The method for forming the silicon nitride film is described in, for example, JP 2002-334869 A, WO 2004/066377, etc. A film thickness of the inorganic hard mask is preferably 5 to 200 nm, and more preferably 10 to 100 nm. As the inorganic hard mask, the SiON film, which is highly effective as the anti-reflective film, is most preferably used.

### Four-Layer Resist Process using Inorganic Hard Mask, and Organic Anti-Reflection Film or Adhesion Film

In addition, the present invention provides, as a patterning process with a four-resist process using the aforementioned composition for forming an organic film of the present invention, patterning process comprising steps of: forming an organic film on a body to be processed by using the aforementioned composition for forming an organic film of the present invention; forming an inorganic hard mask selected from a silicon oxide film, a silicon nitride film, and a silicon oxynitride film on the organic film; forming an organic anti-reflection film or an adhesion film on the inorganic hard mask; forming a resist upper layer film on the organic anti-reflection film or the adhesion film by using a resist upper layer film material composed of a photoresist composition; forming a circuit pattern in the resist upper layer film; transferring the pattern to the organic anti-reflection film or the adhesion film, and the inorganic hard mask by etching while using the circuit-patterned resist upper layer film as a mask; transferring the pattern to the organic film by etching while using the patterned inorganic hard mask as a mask; and transferring the pattern to the body to be processed by etching while using the patterned organic film as a mask.

This method can be performed in the same manner as the above three-layer resist process using the inorganic hard mask except that the organic anti-reflective film (BARC) or the adhesive film is formed between the inorganic hard mask and the resist upper layer film.

In particular, when the SiON film is used as the inorganic hard mask, the reflection can be inhibited by the two anti-reflective films of the SiON film and the BARC even with the immersion exposure having high NA of more than 1.0. Another merit of forming the BARC is an effect of reducing bottom footing of the resist upper layer film pattern just on the SiON film.

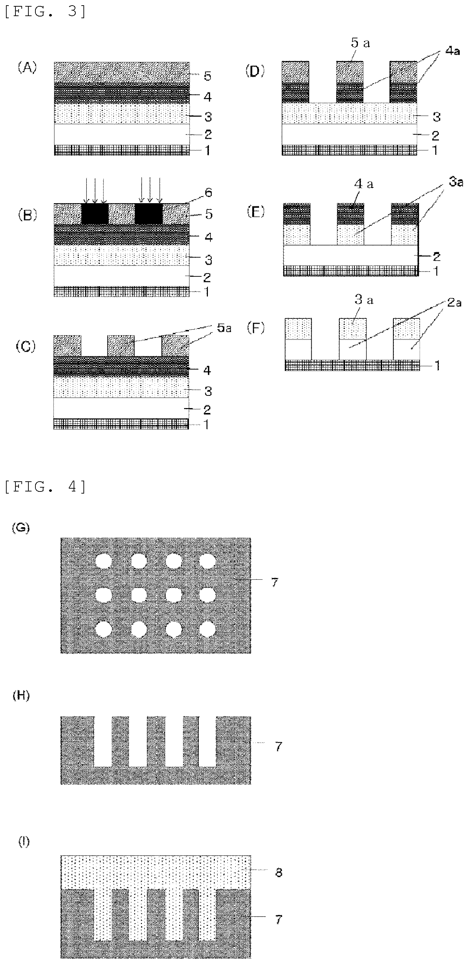

Here, an example of the patterning process of the present invention with the three-layer resist process is described in FIGS. 3(A) to (F). In the three-layer resist process, as illustrated in FIG. 3(A), an organic film 3 is formed on a layer 2 to be processed formed on a substrate 1 by using the composition for forming an organic film of the present invention, then a silicon-containing resist intermediate film 4 is formed, and a resist upper layer film 5 is formed thereon. Then, as illustrated in FIG. 3(B), an exposure portion 6 in the resist upper layer film 5 is exposed, and post exposure baking (PEB) is performed. Thereafter, as illustrated in FIG. 3(C), development is performed to form a resist upper layer film pattern 5a. Subsequently, as illustrated in FIG. 3(D), the silicon-containing resist intermediate film 4 is processed by dry etching by using a fluorocarbon-based gas while using the resist upper layer film pattern 5a as a mask to form a silicon-containing resist intermediate film pattern 4a. Then, as illustrated in FIG. 3(E), the resist upper layer film pattern 5a is removed, and then the organic film 3 is etched with oxygen plasma while using the silicon-containing resist intermediate film pattern 4a as a mask to form an organic film pattern 3a. Furthermore, as illustrated FIG. 3(F), the silicon-containing resist intermediate film pattern 4a is removed, and then the layer 2 to be processed is processed by etching while using the organic film pattern 3a as a mask to form a pattern 2a. Inhibition of humps in forming the organic film can reduce defects derived from the humps in the organic film and generated in the dry-etching processing in FIGS. (D), (E), and (F).

When the inorganic hard mask is formed, the silicon-containing resist intermediate film 4 is replace with the inorganic hard mask. When the BARC or the adhesive film is formed, the BARC or the adhesive film is formed between the silicon-containing resist intermediate film 4 and the resist upper layer film 5. The BARC may be subsequently etched prior to the etching of the silicon-containing resist intermediate film 4. Alternatively, only the BARC may be etched, and then the etching apparatus may be changed, etc. to etch the silicon-containing resist intermediate film 4.

As above, the patterning process of the present invention can form a fine pattern in the body to be processed with high accuracy using the multilayer resist process, and can inhibit formation of humps in the organic film to reduce defects derived from the humps in the organic film.

### EXAMPLE

Hereinafter, the present invention will be described further specifically with showing Synthesis Examples, Comparative Synthesis Examples, Examples, and Comparative Examples, but the present invention is not limited by these examples.

Molecular weights were measured by the following specific method. Determined were a weight-average molecular weight (Mw) and a number-average molecular weight (Mn) in terms of polystyrene by gel permeation chromatography (GPC) with tetrahydrofuran as an eluent (solvent), and a dispersion degree (Mw/Mn) was determined.

### Preparation of Polymers (A-1 to 24 and a-1 to 10)

For synthesizing polymers (A-1) to (A-24) and comparative polymers (a-1) to (a-10) used in preparation of compositions for forming an organic film, monomers (B-1) to (B-6), (C-1) to (C-8), (D-1), and (E-1) to (E-3) described below were used.

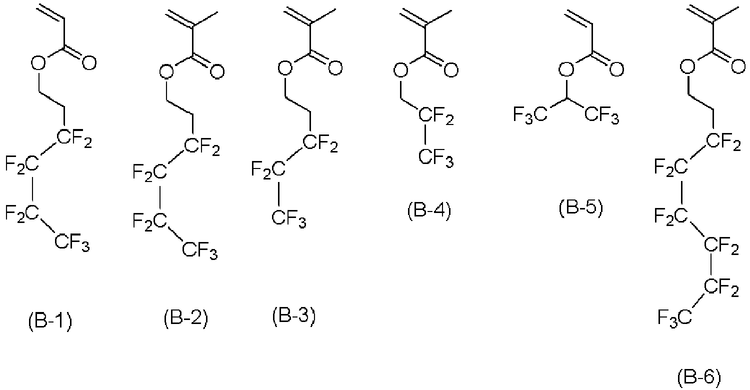

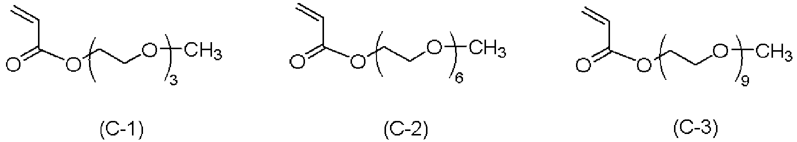

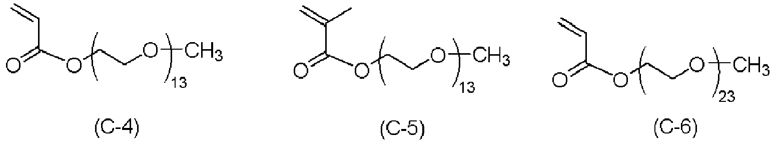

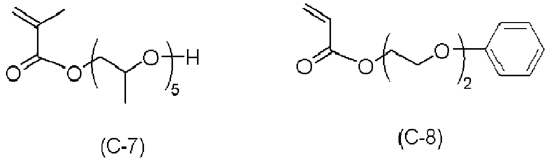

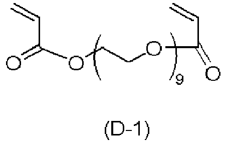

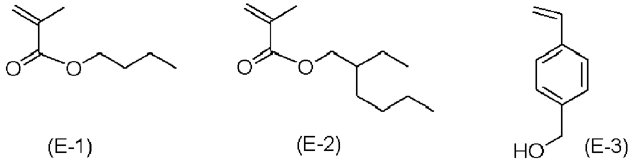

### Synthesis Example 1: Synthesis of Polymer (A-1)

Under a nitrogen atmosphere, 6.0 g of propylene glycol monomethyl ether acetate (PGMEA) was heated and stirred at 80°C. Into this, 3.18 g (0.010 mol) of (B-1), 7.74 g (0.035 mol) of (C-1), and a mixture of 0.473 g of dimethyl 2,2-azobis(2-methylpropionate) and 34 g of PGMEA were added dropwise over 4 hours. The reaction mixture was further heated and stirred for 16 hours, and then cooled to room temperature to obtain a PGMEA solution of a target polymer (A-1). The analysis demonstrated that the polymer (A-1) had a weight-average molecular weight (Mw) of 6,900 and a dispersion degree (Mw/Mn) of 1.4.

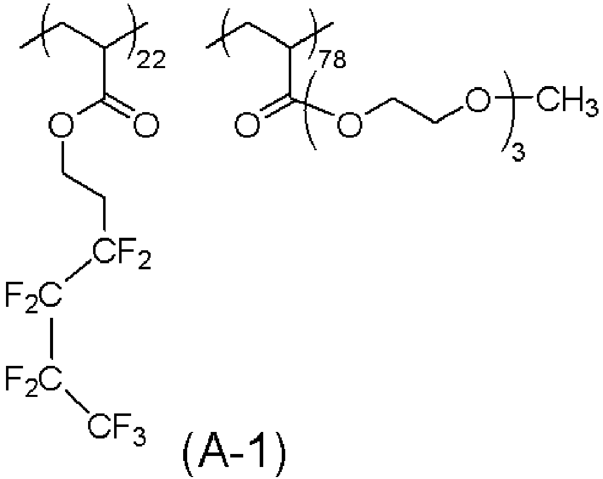

### Synthesis Examples 2 to 34: Synthesis of Polymers (A-2) to (A-24) and Comparative Polymers (a-1) to (a-10)

Polymers (A-2) to (A-24) and comparative polymers (a-1) to (a-10) shown below were obtained as products by a method according to Synthesis Example 1 except that a type and mole proportion of the used raw material monomers were changed for structure of each polymer. Shown are a weight-average molecular weight (Mw) and dispersion degree (Mw/Mn) determined by GPC, and a fluorine content calculated from the raw material monomers and their blending ratio.

The above polymers were all random copolymers.

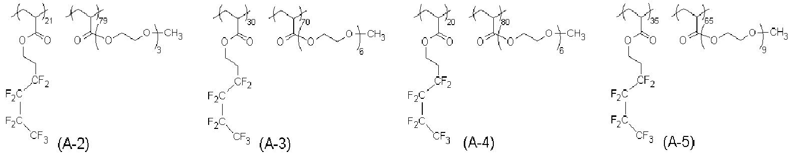

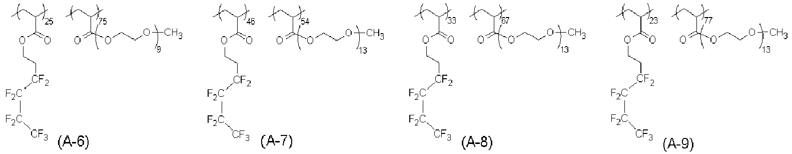

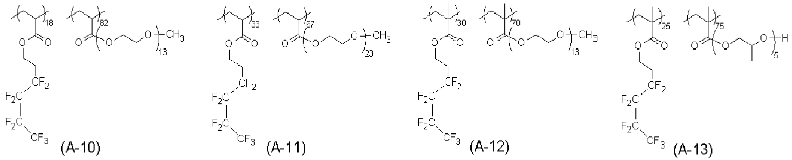

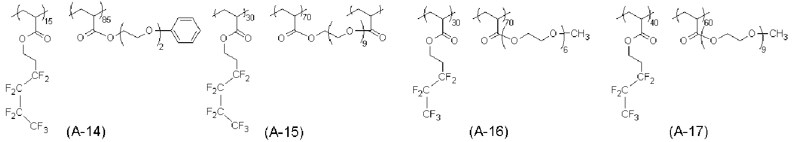

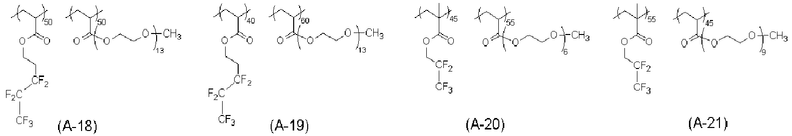

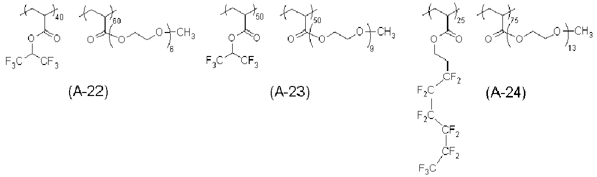

The (a-1) to (a-5) are the comparative polymers because the fluorine content is out of the range from Table 1. The (a-6) to (a-10) are the comparative polymers because a structural unit different from the formula (II) or the formula (III) is contained.

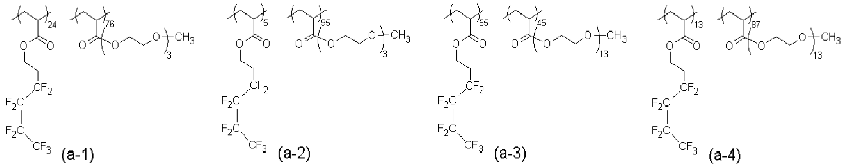

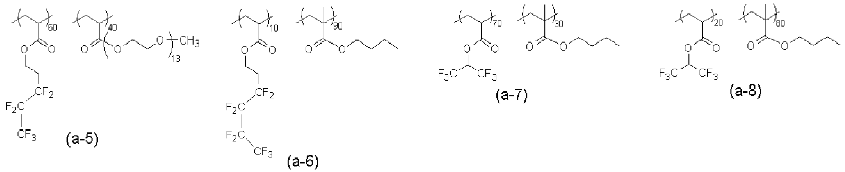

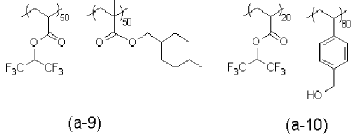

**[Table 1-1]**

| Synthesis Example | Polymer | Mw | Mw/Mn | Fluorine content (mass%) |
|---|---|---|---|---|
| Synthesis Example 1 | (A-1) | 6900 | 1.4 | 16% |
| Synthesis Example 2 | (A-2) | 8000 | 1.3 | 15% |
| Synthesis Example 3 | (A-3) | 8200 | 1.2 | 15% |
| Synthesis Example 4 | (A-4) | 8100 | 1.3 | 10% |
| Synthesis Example 5 | (A-5) | 8500 | 1.3 | 14% |
| Synthesis Example 6 | (A-6) | 7200 | 1.2 | 10% |
| Synthesis Example 7 | (A-7) | 8500 | 1.2 | 16% |
| Synthesis Example 8 | (A-8) | 8100 | 1.2 | 10% |
| Synthesis Example 9 | (A-9) | 8400 | 1.3 | 7% |
| Synthesis Example 10 | (A-10) | 9900 | 1.4 | 5% |
| Synthesis Example 11 | (A-11) | 9100 | 1.3 | 7% |
| Synthesis Example 12 | (A-12) | 9200 | 1.3 | 9% |
| Synthesis Example 13 | (A-13) | 8300 | 1.3 | 12% |
| Synthesis Example 14 | (A-14) | 5600 | 1.3 | 10% |
| Synthesis Example 15 | (A-15) | 6400 | 1.5 | 11% |
| Synthesis Example 16 | (A-16) | 7700 | 1.1 | 12% |
| Synthesis Example 17 | (A-17) | 8500 | 1.3 | 13% |
| Synthesis Example 18 | (A-18) | 7900 | 1.3 | 14% |
| Synthesis Example 19 | (A-19) | 8100 | 1.3 | 10% |
| Synthesis Example 20 | (A-20) | 7200 | 1.2 | 15% |
| Synthesis Example 21 | (A-21) | 7300 | 1.4 | 15% |
| Synthesis Example 22 | (A-22) | 7900 | 1.3 | 15% |
| Synthesis Example 23 | (A-23) | 8300 | 1.3 | 16% |
| Synthesis Example 24 | (A-24) | 7500 | 1.2 | 10% |
| Synthesis Example 25 | (a-1) | 9500 | 1.2 | 17% |
| Synthesis Example 26 | (a-2) | 6700 | 1.1 | 4% |
| Synthesis Example 27 | (a-3) | 8200 | 1.3 | 20% |
| Synthesis Example 28 | (a-4) | 7100 | 1.2 | 4% |
| Synthesis Example 29 | (a-5) | 8400 | 1.4 | 18% |
| Synthesis Example 30 | (a-6) | 5800 | 1.4 | 11% |

**[Table 1-2]**

| Synthesis Example | Polymer | Mw | Mw/Mn | Fluorine content (mass%) |
|---|---|---|---|---|
| Synthesis Example 31 | (a-7) | 6200 | 1.3 | 40% |
| Synthesis Example 32 | (a-8) | 5900 | 1.3 | 14% |
| Synthesis Example 33 | (a-9) | 8300 | 1.3 | 27% |
| Synthesis Example 34 | (a-10) | 3800 | 1.4 | 14% |

### Resins for Forming Organic Film

| | | |
|---|---|---|
| F-1: | Resin represented by the following formula | (F-1) |
| F-2: | Resin represented by the following formula | (F-2) |
| F-3: | Resin represented by the following formula | (F-3) |
| F-4: | Resin represented by the following formula | (F-4) |
| F-5: | Resin represented by the following formula | (F-5) |
| F-6: | Resin represented by the following formula | (F-6) |

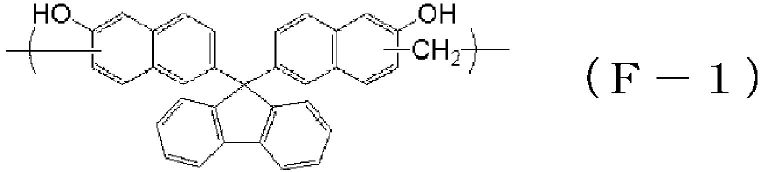

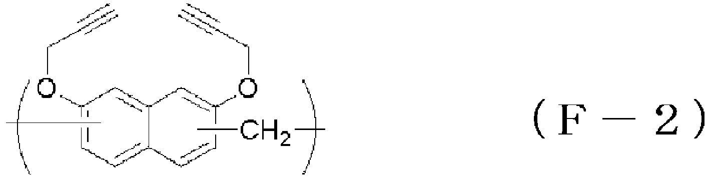

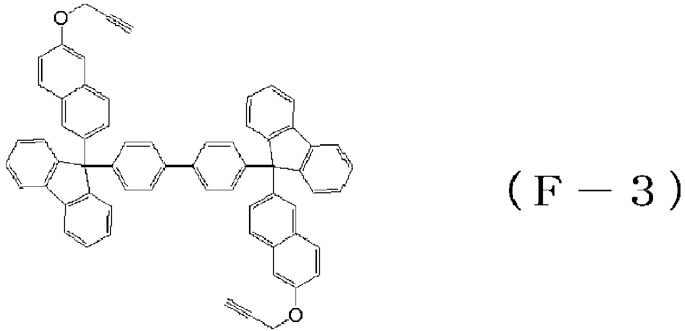

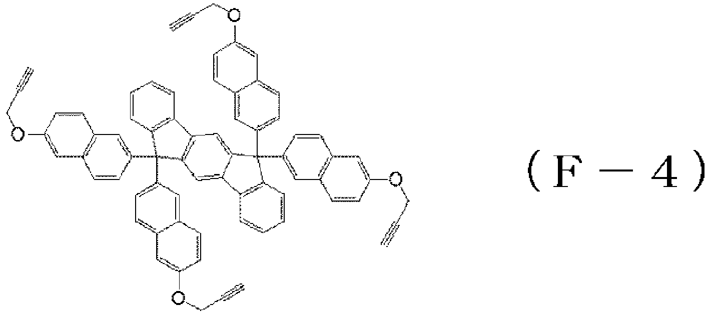

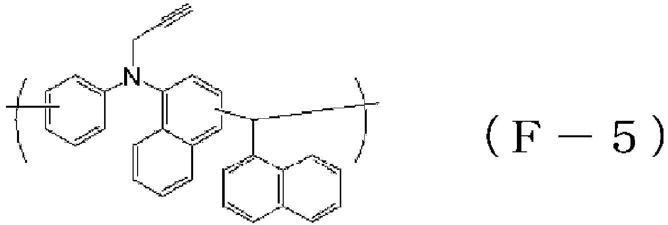

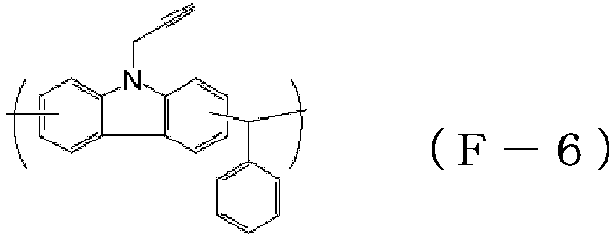

### Solvent

| | |
|---|---|
| G-1: | Propylene glycol monomethyl ether acetate |
| G-2: | Propylene glycol monoethyl ether |

### Preparation of Compositions for Forming Organic Film (UDL-1 to 102 and Comparative UDL-1 to 33

The polymers (A-1) to (A-24) and (a-1) to (a-10), and the resins for forming an organic film (F-1) to (F-6) were dissolved in the solvents at a ratio shown in Table 2, and the solution was filtered with a 0.1-pm filter made of a fluororesin to prepare each of organic film materials (UDL-1 to 102 and Comparative UDL-1 to 33) .

These organic film compositions all contained random copolymers.

**[Table 2-1]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-1 | (F-1) | 10.00 | (A-1) | 0.10 | G-1 | 89.90 | | |
| UDL-2 | (F-1) | 10.00 | (A-2) | 0.10 | G-1 | 89.90 | | |
| UDL-3 | (F-1) | 10.00 | (A-3) | 0.10 | G-1 | 89.90 | | |
| UDL-4 | (F-1) | 10.00 | (A-4) | 0.10 | G-1 | 89.90 | | |
| UDL-5 | (F-1) | 10.00 | (A-5) | 0.10 | G-1 | 89.90 | | |
| UDL-6 | (F-1) | 10.00 | (A-6) | 0.10 | G-1 | 89.90 | | |
| UDL-7 | (F-1) | 10.00 | (A-7) | 0.10 | G-1 | 89.90 | | |
| UDL-8 | (F-1) | 10.00 | (A-8) | 0.10 | G-1 | 89.90 | | |
| UDL-9 | (F-1) | 10.00 | (A-9) | 0.10 | G-1 | 89.90 | | |
| UDL-10 | (F-1) | 10.00 | (A-10) | 0.10 | G-1 | 89.90 | | |
| UDL-11 | (F-1) | 10.00 | (A-11) | 0.10 | G-1 | 89.90 | | |
| UDL-12 | (F-1) | 10.00 | (A-12) | 0.10 | G-1 | 89.90 | | |
| UDL-13 | (F-1) | 10.00 | (A-13) | 0.10 | G-1 | 89.90 | | |
| UDL-14 | (F-1) | 10.00 | (A-14) | 0.10 | G-1 | 89.90 | | |
| UDL-15 | (F-1) | 10.00 | (A-15) | 0.10 | G-1 | 89.90 | | |
| UDL-16 | (F-1) | 10.00 | (A-16) | 0.10 | G-1 | 89.90 | | |
| UDL-17 | (F-1) | 10.00 | (A-17) | 0.10 | G-1 | 89.90 | | |
| UDL-18 | (F-1) | 10.00 | (A-18) | 0.10 | G-1 | 89.90 | | |
| UDL-19 | (F-1) | 10.00 | (A-19) | 0.10 | G-1 | 89.90 | | |
| UDL-20 | (F-1) | 10.00 | (A-20) | 0.10 | G-1 | 89.90 | | |
| UDL-21 | (F-1) | 10.00 | (A-21) | 0.10 | G-1 | 89.90 | | |
| UDL-22 | (F-1) | 10.00 | (A-22) | 0.10 | G-1 | 89.90 | | |
| UDL-23 | (F-1) | 10.00 | (A-23) | 0.10 | G-1 | 89.90 | | |
| UDL-24 | (F-1) | 10.00 | (A-24) | 0.10 | G-1 | 89.90 | | |
| UDL-25 | (F-1) | 10.00 | (A-4) | 0.10 | G-1 | 62.93 | G-2 | 26.97 |
| UDL-26 | (F-1) | 10.00 | (A-6) | 0.10 | G-1 | 62.93 | G-2 | 26.97 |
| UDL-27 | (F-1) | 10.00 | (A-8) | 0.10 | G-1 | 62.93 | G-2 | 26.97 |
| UDL-28 | (F-1) | 10.00 | (A-12) | 0.10 | G-1 | 62.93 | G-2 | 26.97 |
| UDL-29 | (F-1) | 10.00 | (A-13) | 0.10 | G-1 | 62.93 | G-2 | 26.97 |
| UDL-30 | (F-1) | 10.00 | (A-14) | 0.10 | G-1 | 62.93 | G-2 | 26.97 |

**[Table 2-2]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-31 | (F-1) | 10.00 | (A-15) | 0.10 | G-1 | 62.93 | G-2 | 26.97 |
| UDL-32 | (F-1) | 10.00 | (A-16) | 0.10 | G-1 | 62.93 | G-2 | 26.97 |
| UDL-33 | (F-1) | 10.00 | (A-17) | 0.10 | G-1 | 62.93 | G-2 | 26.97 |
| UDL-34 | (F-1) | 10.00 | (A-21) | 0.10 | G-1 | 62.93 | G-2 | 26.97 |
| UDL-35 | (F-1) | 10.00 | (A-22) | 0.10 | G-1 | 62.93 | G-2 | 26.97 |
| UDL-36 | (F-1) | 10.00 | (A-4) | 1.00 | G-1 | 89.00 | | |
| UDL-37 | (F-1) | 10.00 | (A-4) | 0.50 | G-1 | 89.50 | | |
| UDL-38 | (F-1) | 10.000 | (A-4) | 0.001 | G-1 | 89.999 | | |
| UDL-39 | (F-2) | 10.00 | (A-4) | 0.10 | G-1 | 89.90 | | |
| UDL-40 | (F-2) | 10.00 | (A-6) | 0.10 | G-1 | 89.90 | | |
| UDL-41 | (F-2) | 10.00 | (A-8) | 0.10 | G-1 | 89.90 | | |
| UDL-42 | (F-2) | 10.00 | (A-12) | 0.10 | G-1 | 89.90 | | |
| UDL-43 | (F-2) | 10.00 | (A-13) | 0.10 | G-1 | 89.90 | | |
| UDL-44 | (F-2) | 10.00 | (A-14) | 0.10 | G-1 | 89.90 | | |
| UDL-45 | (F-2) | 10.00 | (A-15) | 0.10 | G-1 | 89.90 | | |
| UDL-46 | (F-2) | 10.00 | (A-16) | 0.10 | G-1 | 89.90 | | |
| UDL-47 | (F-2) | 10.00 | (A-21) | 0.10 | G-1 | 89.90 | | |
| UDL-48 | (F-2) | 10.00 | (A-22) | 0.10 | G-1 | 89.90 | | |
| UDL-49 | (F-3) | 10.00 | (A-4) | 0.10 | G-1 | 89.90 | | |
| UDL-50 | (F-3) | 10.00 | (A-6) | 0.10 | G-1 | 89.90 | | |
| UDL-51 | (F-3) | 10.00 | (A-8) | 0.10 | G-1 | 89.90 | | |
| UDL-52 | (F-3) | 10.00 | (A-12) | 0.10 | G-1 | 89.90 | | |
| UDL-53 | (F-3) | 10.00 | (A-13) | 0.10 | G-1 | 89.90 | | |
| UDL-54 | (F-3) | 10.00 | (A-14) | 0.10 | G-1 | 89.90 | | |
| UDL-55 | (F-3) | 10.00 | (A-15) | 0.10 | G-1 | 89.90 | | |
| UDL-56 | (F-3) | 10.00 | (A-16) | 0.10 | G-1 | 89.90 | | |
| UDL-57 | (F-3) | 10.00 | (A-21) | 0.10 | G-1 | 89.90 | | |
| UDL-58 | (F-3) | 10.00 | (A-22) | 0.10 | G-1 | 89.90 | | |
| UDL-59 | (F-4) | 10.00 | (A-4) | 0.10 | G-1 | 89.90 | | |
| UDL-60 | (F-4) | 10.00 | (A-6) | 0.10 | G-1 | 89.90 | | |

**[Table 2-3]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-61 | (F-4) | 10.00 | (A-8) | 0.10 | G-1 | 89.90 | | |
| UDL-62 | (F-4) | 10.00 | (A-12) | 0.10 | G-1 | 89.90 | | |
| UDL-63 | (F-4) | 10.00 | (A-13) | 0.10 | G-1 | 89.90 | | |
| UDL-64 | (F-4) | 10.00 | (A-14) | 0.10 | G-1 | 89.90 | | |
| UDL-65 | (F-4) | 10.00 | (A-15) | 0.10 | G-1 | 89.90 | | |
| UDL-66 | (F-4) | 10.00 | (A-16) | 0.10 | G-1 | 89.90 | | |
| UDL-67 | (F-4) | 10.00 | (A-21) | 0.10 | G-1 | 89.90 | | |
| UDL-68 | (F-4) | 10.00 | (A-22) | 0.10 | G-1 | 89.90 | | |
| UDL-69 | (F-5) | 10.00 | (A-4) | 0.10 | G-1 | 89.90 | | |
| UDL-70 | (F-5) | 10.00 | (A-6) | 0.10 | G-1 | 89.90 | | |
| UDL-71 | (F-5) | 10.00 | (A-8) | 0.10 | G-1 | 89.90 | | |
| UDL-72 | (F-5) | 10.00 | (A-12) | 0.10 | G-1 | 89.90 | | |
| UDL-73 | (F-4) | 10.00 | (A-13) | 0.10 | G-1 | 89.90 | | |
| UDL-74 | (F-4) | 10.00 | (A-14) | 0.10 | G-1 | 89.90 | | |
| UDL-75 | (F-5) | 10.00 | (A-15) | 0.10 | G-1 | 89.90 | | |
| UDL-76 | (F-5) | 10.00 | (A-16) | 0.10 | G-1 | 89.90 | | |
| UDL-77 | (F-5) | 10.00 | (A-21) | 0.10 | G-1 | 89.90 | | |
| UDL-78 | (F-5) | 10.00 | (A-22) | 0.10 | G-1 | 89.90 | | |
| UDL-79 | (F-6) | 10.00 | (A-4) | 0.10 | G-1 | 89.90 | | |
| UDL-80 | (F-6) | 10.00 | (A-6) | 0.10 | G-1 | 89.90 | | |
| UDL-81 | (F-6) | 10.00 | (A-8) | 0.10 | G-1 | 89.90 | | |
| UDL-82 | (F-6) | 10.00 | (A-12) | 0.10 | G-1 | 89.90 | | |
| UDL-83 | (F-6) | 10.00 | (A-13) | 0.10 | G-1 | 89.90 | | |
| UDL-84 | (F-6) | 10.00 | (A-14) | 0.10 | G-1 | 89.90 | | |
| UDL-85 | (F-6) | 10.00 | (A-15) | 0.10 | G-1 | 89.90 | | |
| UDL-86 | (F-6) | 10.00 | (A-16) | 0.10 | G-1 | 89.90 | | |
| UDL-87 | (F-6) | 10.00 | (A-21) | 0.10 | G-1 | 89.90 | | |
| UDL-88 | (F-6) | 10.00 | (A-22) | 0.10 | G-1 | 89.90 | | |
| UDL-89 | (F-1) | 25.00 | (A-4) | 0.25 | G-1 | 74.75 | | |
| UDL-90 | (F-1) | 25.00 | (A-6) | 0.25 | G-1 | 74.75 | | |

**[Table 2-4]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-91 | (F-1) | 25.00 | (A-8) | 0.25 | G-1 | 74.75 | | |
| UDL-92 | (F-1) | 25.00 | (A-12) | 0.25 | G-1 | 74.75 | | |
| UDL-93 | (F-1) | 25.00 | (A-13) | 0.25 | G-1 | 74.75 | | |
| UDL-94 | (F-1) | 25.00 | (A-14) | 0.25 | G-1 | 74.75 | | |
| UDL-95 | (F-1) | 25.00 | (A-15) | 0.25 | G-1 | 74.75 | | |
| UDL-96 | (F-1) | 25.00 | (A-16) | 0.25 | G-1 | 74.75 | | |
| UDL-97 | (F-1) | 25.00 | (A-21) | 0.25 | G-1 | 74.75 | | |
| UDL-98 | (F-1) | 25.00 | (A-22) | 0.25 | G-1 | 74.75 | | |
| UDL-99 | (F-1) | 25.00 | (A-4) | 2.50 | G-1 | 72.50 | | |
| UDL-100 | (F-1) | 25.00 | (A-4) | 1.25 | G-1 | 73.75 | | |
| UDL-101 | (F-1) | 25.000 | (A-4) | 0.003 | G-1 | 74.998 | | |
| UDL-102 | (F-1) | 40.00 | (A-4) | 0.40 | G-1 | 59.60 | | |
| Comparative UDL-1 | (F-1) | 10.00 | (a-1) | 0.10 | G-1 | 89.90 | | |
| Comparative UDL-2 | (F-2) | 10.00 | (a-1) | 0.10 | G-1 | 89.90 | | |
| Comparative UDL-3 | (F-3) | 10.00 | (a-1) | 0.10 | G-1 | 89.90 | | |
| Comparative UDL-4 | (F-4) | 10.00 | (a-1) | 0.10 | G-1 | 89.90 | | |
| Comparative UDL-5 | (F-5) | 10.00 | (a-1) | 0.10 | G-1 | 89.90 | | |
| Comparative UDL-6 | (F-6) | 10.00 | (a-1) | 0.10 | G-1 | 89.90 | | |
| Comparative UDL-7 | (F-1) | 10.00 | (a-2) | 0.10 | G-1 | 89.90 | | |
| Comparative UDL-8 | (F-1) | 10.00 | (a-3) | 0.10 | G-1 | 89.90 | | |
| Comparative UDL-9 | (F-1) | 10.00 | (a-4) | 0.10 | G-1 | 89.90 | | |
| Comparative UDL-10 | (F-1) | 10.00 | (a-5) | 0.10 | G-1 | 89.90 | | |
| Comparative UDL-11 | (F-1) | 10.00 | (a-6) | 0.10 | G-1 | 89.90 | | |
| Comparative UDL-12 | (F-1) | 10.00 | (a-7) | 0.10 | G-1 | 89.90 | | |
| Comparative UDL-13 | (F-1) | 10.00 | (a-8) | 0.10 | G-1 | 89.90 | | |
| Comparative UDL-14 | (F-1) | 10.00 | (a-9) | 0.10 | G-1 | 89.90 | | |
| Comparative UDL-15 | (F-1) | 10.00 | | | G-1 | 90.00 | | |
| Comparative UDL-16 | (F-2) | 10.00 | | | G-1 | 90.00 | | |
| Comparative UDL-17 | (F-3) | 10.00 | | | G-1 | 90.00 | | |
| Comparative UDL-18 | (F-4) | 10.00 | | | G-1 | 90.00 | | |

**[Table 2-5]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| Comparative UDL-19 | (F-5) | 10.00 | | | G-1 | 90.00 | | |
| Comparative UDL-20 | (F-6) | 10.00 | | | G-1 | 90.00 | | |
| Comparative UDL-21 | (F-1) | 10.00 | (a-10) | 0.10 | G-1 | 89.90 | | |
| Comparative UDL-22 | (F-1) | 25.00 | (a-1) | 0.25 | G-1 | 74.75 | | |
| Comparative UDL-23 | (F-2) | 25.00 | (a-1) | 0.25 | G-1 | 74.75 | | |
| Comparative UDL-24 | (F-3) | 25.00 | (a-1) | 0.25 | G-1 | 74.75 | | |
| Comparative UDL-25 | (F-4) | 25.00 | (a-1) | 0.25 | G-1 | 74.75 | | |
| Comparative UDL-26 | (F-5) | 25.00 | (a-1) | 0.25 | G-1 | 74.75 | | |
| Comparative UDL-27 | (F-6) | 25.00 | (a-1) | 0.25 | G-1 | 74.75 | | |
| Comparative UDL-28 | (F-1) | 25.00 | (a-10) | 0.25 | G-1 | 74.75 | | |
| Comparative UDL-29 | (F-2) | 25.00 | (a-10) | 0.25 | G-1 | 74.75 | | |
| Comparative UDL-30 | (F-3) | 25.00 | (a-10) | 0.25 | G-1 | 74.75 | | |
| Comparative UDL-31 | (F-4) | 25.00 | (a-10) | 0.25 | G-1 | 74.75 | | |
| Comparative UDL-32 | (F-5) | 25.00 | (a-10) | 0.25 | G-1 | 74.75 | | |
| Comparative UDL-33 | (F-6) | 25.00 | (a-10) | 0.25 | G-1 | 74.75 | | |

### Production of Silicon Wafer with Formed Organic Cured Film using Composition for Forming Organic Film (UDL-1 to 102 and Comparative UDL-1 to 33)

By using a coater/developer "CLEAN TRACK LITHIUS Pro AP", manufactured by Tokyo Electron Ltd., 2 mL of the composition for forming an organic film (UDL-1 to 102 and Comparative UDL-1 to 33) prepared above was discharged at a center of a silicon wafer, baked, and then rotated and spread at a rotation speed for an average thickness shown in Table 3 to form a coated silicon wafer. While this silicon wafer was rotated at a speed of 1000 rpm and while a removing liquid (a mixed liquid of propylene glycol monomethyl ether acetate and propylene glycol monomethyl ether (30:70 at mass ratio)) was discharged at a discharge amount of 2 mL/s, a removing-liquid-discharging nozzle was moved from an outer periphery toward a position with 3 mm from the center of the silicon wafer to at a speed of 5 mm/s, and the removing liquid was further discharged at this position at a discharge amount of 2 mL/s for 5 seconds. Thereafter, discharge of the discharging liquid was stopped, and the silicon wafer was further rotated at a speed of 1000 rpm for 30 seconds. Then, the silicon wafer coated by using the composition for forming an organic film was heated at 350°C for 60 seconds to obtain a silicon wafer on which the organic cured film was formed.

### Evaluation of Solvent Resistance: Examples 1-1 to 1-102 and Comparative Examples 1-1 to 1-33

The composition for forming an organic film (UDL-1 to 102 and Comparative UDL 1-1 to 1-33) was film-formed on a silicon wafer by the above method, the film thickness was measured, PGMEA solvent was dispensed thereon, left for 30 seconds, spin-dried, baked at 100°C for 60 seconds to evaporate PGMEA, and the film thickness was measured. The film thickness before dispensing the PGMEA solvent was specified as X and the film thickness after dispensing the PGMEA solvent was specified as X₁, and an absolute value of a value determined by (X₁-X) /X×100 was specified and shown in Table 3 as a result of a film thickness change rate (%). A case where the film thickness change rate was less than 0.5% was evaluated as "Good", and a case of 0.5% or more was evaluated as "Poor".

### Evaluation of In-Plane Uniformity: Examples 1-1 to 1-102 and Comparative Examples 1-1 to 1-33

The composition for forming an organic film (UDL-1 to 102 and Comparative UDL 1-1 to 1-33) was film-formed on a silicon wafer by the above method. Thicknesses within a range from a center to 145 mm in diameter of the organic cured film were measured, and a value determined by (Xₘₐₓ - Xₘᵢₙ) /X_{average}, wherein Xₘₐₓ was a maximum value of the film thickness, Xₘᵢₙ was a minimum value of the film thickness, and X_{average} was an average of the film thickness, was specified and shown in Table 3 as a result of in-plane uniformity (%). A case where the in-plane uniformity was less than 2% was evaluated as A (Good), a case of 2% or more and less than 3% was evaluated as B, and a case of 3% or more was evaluated as C (Poor).

### Evaluation of Storage Stability at Low-Temperature: Examples 1-1 to 1-102 and Comparative Examples 1-1 to 1-33

The composition for forming an organic film (UDL-1 to 102 and Comparative UDL 1-1 to 1-33) was stored in a freezer set at -20°C for one week. A case where a precipitate was not generated was evaluated as "Good", and a case where a precipitate was generated was evaluated as "Poor". Table 3 shows the results.

**[Table 3-1]**

| | Composition for forming organic film | Average film thickness | Solvent resistance | In-plane uniformity | Storage stability at low temperature |
|---|---|---|---|---|---|
| Example 1-1 | UDL-1 | 500 nm | Good | A | Good |
| Example 1-2 | UDL-2 | 500 nm | Good | A | Good |
| Example 1-3 | UDL-3 | 500 nm | Good | A | Good |
| Example 1-4 | UDL-4 | 500 nm | Good | A | Good |
| Example 1-5 | UDL-5 | 500 nm | Good | A | Good |
| Example 1-6 | UDL-6 | 500 nm | Good | A | Good |
| Example 1-7 | UDL-7 | 500 nm | Good | A | Good |
| Example 1-8 | UDL-8 | 500 nm | Good | A | Good |
| Example 1-9 | UDL-9 | 500 nm | Good | A | Good |
| Example 1-10 | UDL-10 | 500 nm | Good | B | Good |
| Example 1-11 | UDL-11 | 500 nm | Good | A | Poor |
| Example 1-12 | UDL-12 | 500 nm | Good | A | Good |
| Example 1-13 | UDL-13 | 500 nm | Good | A | Good |
| Example 1-14 | UDL-14 | 500 nm | Good | A | Good |
| Example 1-15 | UDL-15 | 500 nm | Good | A | Good |
| Example 1-16 | UDL-16 | 500 nm | Good | A | Good |
| Example 1-17 | UDL-17 | 500 nm | Good | A | Good |
| Example 1-18 | UDL-18 | 500 nm | Good | A | Good |
| Example 1-19 | UDL-19 | 500 nm | Good | A | Good |
| Example 1-20 | UDL-20 | 500 nm | Good | B | Good |
| Example 1-21 | UDL-21 | 500 nm | Good | B | Good |
| Example 1-22 | UDL-22 | 500 nm | Good | B | Good |
| Example 1-23 | UDL-23 | 500 nm | Good | B | Good |
| Example 1-24 | UDL-24 | 500 nm | Good | B | Good |
| Example 1-25 | UDL-25 | 500 nm | Good | A | Good |
| Example 1-26 | UDL-26 | 500 nm | Good | A | Good |
| Example 1-27 | UDL-27 | 500 nm | Good | A | Good |
| Example 1-28 | UDL-28 | 500 nm | Good | A | Good |
| Example 1-29 | UDL-29 | 500 nm | Good | A | Good |
| Example 1-30 | UDL-30 | 500 nm | Good | A | Good |

**[Table 3-2]**

| | Composition for forming organic film | Average film thickness | Solvent resistance | In-plane uniformity | Storage stability at low temperature |
|---|---|---|---|---|---|
| Example 1-31 | UDL-31 | 500 nm | Good | A | Good |
| Example 1-32 | UDL-32 | 500 nm | Good | A | Good |
| Example 1-33 | UDL-33 | 500 nm | Good | A | Good |
| Example 1-34 | UDL-34 | 500 nm | Good | B | Good |
| Example 1-35 | UDL-35 | 500 nm | Good | B | Good |
| Example 1-36 | UDL-36 | 500 nm | Good | B | Good |
| Example 1-37 | UDL-37 | 500 nm | Good | A | Good |
| Example 1-38 | UDL-38 | 500 nm | Good | B | Good |
| Example 1-39 | UDL-39 | 500 nm | Good | A | Good |
| Example 1-40 | UDL-40 | 500 nm | Good | A | Good |
| Example 1-41 | UDL-41 | 500 nm | Good | A | Good |
| Example 1-42 | UDL-42 | 500 nm | Good | A | Good |
| Example 1-43 | UDL-43 | 500 nm | Good | A | Good |
| Example 1-44 | UDL-44 | 500 nm | Good | A | Good |
| Example 1-45 | UDL-45 | 500 nm | Good | A | Good |
| Example 1-46 | UDL-46 | 500 nm | Good | A | Good |
| Example 1-47 | UDL-47 | 500 nm | Good | B | Good |
| Example 1-48 | UDL-48 | 500 nm | Good | B | Good |
| Example 1-49 | UDL-49 | 500 nm | Good | A | Good |
| Example 1-50 | UDL-50 | 500 nm | Good | A | Good |
| Example 1-51 | UDL-51 | 500 nm | Good | A | Good |
| Example 1-52 | UDL-52 | 500 nm | Good | A | Good |
| Example 1-53 | UDL-53 | 500 nm | Good | A | Good |
| Example 1-54 | UDL-54 | 500 nm | Good | A | Good |
| Example 1-55 | UDL-55 | 500 nm | Good | A | Good |
| Example 1-56 | UDL-56 | 500 nm | Good | A | Good |
| Example 1-57 | UDL-57 | 500 nm | Good | B | Good |
| Example 1-58 | UDL-58 | 500 nm | Good | B | Good |
| Example 1-59 | UDL-59 | 500 nm | Good | A | Good |
| Example 1-60 | UDL-60 | 500 nm | Good | A | Good |

**[Table 3-3]**

| | Composition for forming organic film | Average film thickness | Solvent resistance | In-plane uniformity | Storage stability at low temperature |
|---|---|---|---|---|---|
| Example 1-61 | UDL-61 | 500 nm | Good | A | Good |
| Example 1-62 | UDL-62 | 500 nm | Good | A | Good |
| Example 1-63 | UDL-63 | 500 nm | Good | A | Good |
| Example 1-64 | UDL-64 | 500 nm | Good | A | Good |
| Example 1-65 | UDL-65 | 500 nm | Good | A | Good |
| Example 1-66 | UDL-66 | 500 nm | Good | A | Good |
| Example 1-67 | UDL-67 | 500 nm | Good | B | Good |
| Example 1-68 | UDL-68 | 500 nm | Good | B | Good |
| Example 1-69 | UDL-69 | 500 nm | Good | A | Good |
| Example 1-70 | UDL-70 | 500 nm | Good | A | Good |
| Example 1-71 | UDL-71 | 500 nm | Good | A | Good |
| Example 1-72 | UDL-72 | 500 nm | Good | A | Good |
| Example 1-73 | UDL-73 | 500 nm | Good | A | Good |
| Example 1-74 | UDL-74 | 500 nm | Good | A | Good |
| Example 1-75 | UDL-75 | 500 nm | Good | A | Good |
| Example 1-76 | UDL-76 | 500 nm | Good | A | Good |
| Example 1-77 | UDL-77 | 500 nm | Good | B | Good |
| Example 1-78 | UDL-78 | 500 nm | Good | B | Good |
| Example 1-79 | UDL-79 | 500 nm | Good | A | Good |
| Example 1-80 | UDL-80 | 500 nm | Good | A | Good |
| Example 1-81 | UDL-81 | 500 nm | Good | A | Good |
| Example 1-82 | UDL-82 | 500 nm | Good | A | Good |
| Example 1-83 | UDL-83 | 500 nm | Good | A | Good |
| Example 1-84 | UDL-84 | 500 nm | Good | A | Good |
| Example 1-85 | UDL-85 | 500 nm | Good | A | Good |
| Example 1-86 | UDL-86 | 500 nm | Good | A | Good |
| Example 1-87 | UDL-87 | 500 nm | Good | B | Good |
| Example 1-88 | UDL-88 | 500 nm | Good | B | Good |
| Example 1-89 | UDL-89 | 1000 nm | Good | A | Good |
| Example 1-90 | UDL-90 | 1000 nm | Good | A | Good |

**[Table 3-4]**

| | Composition for forming organic film | Average film thickness | Solvent resistance | In-plane uniformity | Storage stability at low temperature |
|---|---|---|---|---|---|
| Example 1-91 | UDL-91 | 1000 nm | Good | A | Good |
| Example 1-92 | UDL-92 | 1000 nm | Good | A | Good |
| Example 1-93 | UDL-93 | 1000 nm | Good | A | Good |
| Example 1-94 | UDL-94 | 1000 nm | Good | A | Good |
| Example 1-95 | UDL-95 | 1000 nm | Good | A | Good |
| Example 1-96 | UDL-96 | 1000 nm | Good | A | Good |
| Example 1-97 | UDL-97 | 1000 nm | Good | B | Good |
| Example 1-98 | UDL-98 | 1000 nm | Good | B | Good |
| Example 1-99 | UDL-99 | 1000 nm | Good | B | Good |
| Example 1-100 | UDL-100 | 1000 nm | Good | A | Good |
| Example 1-101 | UDL-101 | 1000 nm | Good | B | Good |
| Example 1-102 | UDL-102 | 2000 nm | Good | B | Good |
| Comparative Example 1-1 | Comparative UDL-1 | 500 nm | Good | A | Good |
| Comparative Example 1-2 | Comparative UDL-2 | 500 nm | Good | A | Good |
| Comparative Example 1-3 | Comparative UDL-3 | 500 nm | Good | A | Good |
| Comparative Example 1-4 | Comparative UDL-4 | 500 nm | Good | A | Good |
| Comparative Example 1-5 | Comparative UDL-5 | 500 nm | Good | A | Good |
| Comparative Example 1-6 | Comparative UDL-6 | 500 nm | Good | A | Good |
| Comparative Example 1-7 | Comparative UDL-7 | 500 nm | Good | C | Good |
| Comparative Example 1-8 | Comparative UDL-8 | 500 nm | Good | A | Good |
| Comparative Example 1-9 | Comparative UDL-9 | 500 nm | Good | C | Good |
| Comparative Example 1-10 | Comparative UDL-10 | 500 nm | Good | A | Good |
| Comparative Example 1-11 | Comparative UDL-11 | 500 nm | Good | A | Good |
| Comparative Example 1-12 | Comparative UDL-12 | 500 nm | Good | A | Good |
| Comparative Example 1-13 | Comparative UDL-13 | 500 nm | Good | A | Good |
| Comparative Example 1-14 | Comparative UDL-14 | 500 nm | Good | A | Good |
| Comparative Example 1-15 | Comparative UDL-15 | 500 nm | Good | C | Good |
| Comparative Example 1-16 | Comparative UDL-16 | 500 nm | Good | C | Good |
| Comparative Example 1-17 | Comparative UDL-17 | 500 nm | Good | C | Good |
| Comparative Example 1-18 | Comparative UDL-18 | 500 nm | Good | C | Good |

**[Table 3-5]**

| | Composition for forming organic film | Average film thickness | Solvent resistance | In-plane uniformity | Storage stability at low temperature |
|---|---|---|---|---|---|
| Comparative Example 1-19 | Comparative UDL-19 | 500 nm | Good | C | Good |
| Comparative Example 1-20 | Comparative UDL-20 | 500 nm | Good | C | Good |
| Comparative Example 1-21 | Comparative UDL-21 | 500 nm | Good | A | Good |
| Comparative Example 1-22 | Comparative UDL-22 | 1000 nm | Good | A | Good |
| Comparative Example 1-23 | Comparative UDL-23 | 1000 nm | Good | A | Good |
| Comparative Example 1-24 | Comparative UDL-24 | 1000 nm | Good | A | Good |
| Comparative Example 1-25 | Comparative UDL-25 | 1000 nm | Good | A | Good |
| Comparative Example 1-26 | Comparative UDL-26 | 1000 nm | Good | A | Good |
| Comparative Example 1-27 | Comparative UDL-27 | 1000 nm | Good | A | Good |
| Comparative Example 1-28 | Comparative UDL-28 | 1000 nm | Good | A | Good |
| Comparative Example 1-29 | Comparative UDL-29 | 1000 nm | Good | A | Good |
| Comparative Example 1-30 | Comparative UDL-30 | 1000 nm | Good | A | Good |
| Comparative Example 1-31 | Comparative UDL-31 | 1000 nm | Good | A | Good |
| Comparative Example 1-32 | Comparative UDL-32 | 1000 nm | Good | A | Good |
| Comparative Example 1-33 | Comparative UDL-33 | 1000 nm | Good | A | Good |

### Evaluation of Hump Inhibition Property: Examples 2-1 to 2-102 and Comparative Examples 2-1 to 2-25

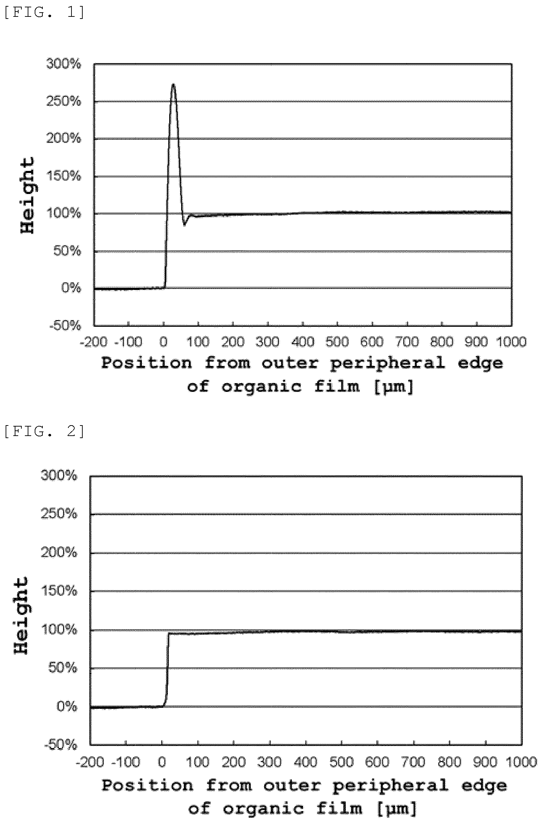

The composition for forming an organic film (UDL-1 to 102 and Comparative UDL-1 to 6, 8, 10 to 14, and 21 to 33) was film-formed on a silicon wafer by the above method, and change in height of the organic film from an outer peripheral edge to a position of 1000 µm toward a center direction of the silicon wafer was measured by using Alpha-Step D-600 (contact-type profiler), manufactured by KLA-TENCOR Corporation. Based on a level of the silicon wafer surface being zero, a case where a maximum height was less than 110% of the film thickness as illustrated in FIG. 2 was evaluated as A (Good), a case where the maximum height was 110% or more and less than 150% was evaluated as B, and a case where a region with the maximum height of 150% or more was generated as in FIG. 1 was evaluated as C (Poor). Table 4 shows the results.

### Filling Evaluation 1: Examples 2-1 to 2-102 and Comparative Examples 2-1 to 2-25

On a SiO₂ wafer substrate having a dense hole pattern (hole diameter: 0.2 um, hole depth: 1.0 um, and distance between centers of adjacent two holes: 0.4 µm) as illustrated in FIG. 4, the composition for forming an organic film (UDL-1 to 102 and Comparative UDL-1 to 6, 8, 10 to 14, and 21 to 33) was film-formed by the above method to form a resist underlayer film 8. The used substrate was a base substrate (SiO₂ wafer substrate) 7 having the dense hole pattern as illustrated in FIG. 4(G) (overhead view) and FIG. 4(H) (sectional view). A sectional shape of the obtained each wafer substrate was observed by using a scanning electron microscope (SEM) to check whether a void was absent inside the holes and the holes were filled with the resist underlayer film. If a resist underlayer film material having poor filling characteristics is used, voids are generated inside the holes. When a resist underlayer film material having good filling characteristics is used, voids are absent inside the holes as illustrated in FIG. 4(I) and the holes were filled with the resist underlayer film in this evaluation. A case where no void was generated was evaluated as "Good", and a case where a void was generated was evaluated as "Poor".

### Filling Evaluation 2: Examples 2-1 to 2-102 and Comparative Examples 2-1 to 2-25

On a SiO₂ wafer substrate having a dense hole pattern (hole diameter: 0.2 um, hole depth: 2.0 um, and distance between centers of adjacent two holes: 0.4 µm) as illustrated in FIG. 4, the composition for forming an organic film (UDL-1 to 102 and Comparative UDL-1 to 6, 8, 10 to 14, and 21 to 33) was film-formed by the above method to form a resist underlayer film 8. The used substrate was a base substrate (SiO₂ wafer substrate) 7 having the dense hole pattern as illustrated in FIG. 4(G) (overhead view) and FIG. 4(H) (sectional view). A sectional shape of the obtained each wafer substrate was observed by using a scanning electron microscope (SEM) to check whether a void was absent inside the holes and was filled with the resist underlayer film. If a resist underlayer film material having poor filling characteristics is used, voids are generated inside the holes. When a resist underlayer film material having good filling characteristics is used, voids are absent inside the holes as illustrated in FIG. 4(I) and the holes were filled with the resist underlayer film in this evaluation. A case where no void was generated was evaluated as "Good", and a case where a void was generated was evaluated as "Poor". When the proportion of the resin for forming an organic film relative to the composition for forming an organic film was small to be insufficient amount of the resin for filling the hole portions, film formation failure occurred.

**[Table 4-1]**

| | Composition for forming organic film | Evaluation of hump inhibition property | Evaluation of filling characteristics 1 | Evaluation of filling characteristics 2 |
|---|---|---|---|---|
| Example 2-1 | UDL-1 | B | Good | Film formation failure |
| Example 2-2 | UDL-2 | B | Good | Film formation failure |
| Example 2-3 | UDL-3 | B | Good | Film formation failure |
| Example 2-4 | UDL-4 | A | Good | Film formation failure |
| Example 2-5 | UDL-5 | A | Good | Film formation failure |
| Example 2-6 | UDL-6 | A | Good | Film formation failure |
| Example 2-7 | UDL-7 | B | Good | Film formation failure |
| Example 2-8 | UDL-8 | A | Good | Film formation failure |
| Example 2-9 | UDL-9 | A | Good | Film formation failure |
| Example 2-10 | UDL-10 | A | Good | Film formation failure |
| Example 2-11 | UDL-11 | A | Good | Film formation failure |
| Example 2-12 | UDL-12 | A | Good | Film formation failure |
| Example 2-13 | UDL-13 | A | Good | Film formation failure |
| Example 2-14 | UDL-14 | A | Good | Film formation failure |
| Example 2-15 | UDL-15 | A | Good | Film formation failure |
| Example 2-16 | UDL-16 | A | Good | Film formation failure |
| Example 2-17 | UDL-17 | A | Good | Film formation failure |
| Example 2-18 | UDL-18 | A | Good | Film formation failure |
| Example 2-19 | UDL-19 | A | Good | Film formation failure |
| Example 2-20 | UDL-20 | B | Good | Film formation failure |
| Example 2-21 | UDL-21 | B | Good | Film formation failure |
| Example 2-22 | UDL-22 | B | Good | Film formation failure |
| Example 2-23 | UDL-23 | B | Good | Film formation failure |
| Example 2-24 | UDL-24 | B | Good | Film formation failure |
| Example 2-25 | UDL-25 | A | Good | Film formation failure |
| Example 2-26 | UDL-26 | A | Good | Film formation failure |
| Example 2-27 | UDL-27 | A | Good | Film formation failure |
| Example 2-28 | UDL-28 | A | Good | Film formation failure |
| Example 2-29 | UDL-29 | A | Good | Film formation failure |
| Example 2-30 | UDL-30 | A | Good | Film formation failure |

**[Table 4-2]**

| | Composition for forming organic film | Evaluation of hump inhibition property | Evaluation of filling characteristics 1 | Evaluation of filling characteristics 2 |
|---|---|---|---|---|
| Example 2-31 | UDL-31 | A | Good | Film formation failure |
| Example 2-32 | UDL-32 | A | Good | Film formation failure |
| Example 2-33 | UDL-33 | A | Good | Film formation failure |
| Example 2-34 | UDL-34 | B | Good | Film formation failure |
| Example 2-35 | UDL-35 | B | Good | Film formation failure |
| Example 2-36 | UDL-36 | A | Good | Film formation failure |
| Example 2-37 | UDL-37 | A | Good | Film formation failure |
| Example 2-38 | UDL-38 | A | Good | Film formation failure |
| Example 2-39 | UDL-39 | A | Good | Film formation failure |
| Example 2-40 | UDL-40 | A | Good | Film formation failure |
| Example 2-41 | UDL-41 | A | Good | Film formation failure |
| Example 2-42 | UDL-42 | A | Good | Film formation failure |
| Example 2-43 | UDL-43 | A | Good | Film formation failure |
| Example 2-44 | UDL-44 | A | Good | Film formation failure |
| Example 2-45 | UDL-45 | A | Good | Film formation failure |
| Example 2-46 | UDL-46 | A | Good | Film formation failure |
| Example 2-47 | UDL-47 | B | Good | Film formation failure |
| Example 2-48 | UDL-48 | B | Good | Film formation failure |
| Example 2-49 | UDL-49 | A | Good | Film formation failure |
| Example 2-50 | UDL-50 | A | Good | Film formation failure |
| Example 2-51 | UDL-51 | A | Good | Film formation failure |
| Example 2-52 | UDL-52 | A | Good | Film formation failure |
| Example 2-53 | UDL-53 | A | Good | Film formation failure |
| Example 2-54 | UDL-54 | A | Good | Film formation failure |
| Example 2-55 | UDL-55 | A | Good | Film formation failure |
| Example 2-56 | UDL-56 | A | Good | Film formation failure |
| Example 2-57 | UDL-57 | B | Good | Film formation failure |
| Example 2-58 | UDL-58 | B | Good | Film formation failure |
| Example 2-59 | UDL-59 | A | Good | Film formation failure |
| Example 2-60 | UDL-60 | A | Good | Film formation failure |

**[Table 4-3]**

| | Composition for forming organic film | Evaluation of hump inhibition property | Evaluation of filling characteristics 1 | Evaluation of filling characteristics 2 |
|---|---|---|---|---|
| Example 2-61 | UDL-61 | A | Good | Film formation failure |
| Example 2-62 | UDL-62 | A | Good | Film formation failure |
| Example 2-63 | UDL-63 | A | Good | Film formation failure |
| Example 2-64 | UDL-64 | A | Good | Film formation failure |
| Example 2-65 | UDL-65 | A | Good | Film formation failure |
| Example 2-66 | UDL-66 | A | Good | Film formation failure |
| Example 2-67 | UDL-67 | B | Good | Film formation failure |
| Example 2-68 | UDL-68 | B | Good | Film formation failure |
| Example 2-69 | UDL-69 | A | Good | Film formation failure |
| Example 2-70 | UDL-70 | A | Good | Film formation failure |
| Example 2-71 | UDL-71 | A | Good | Film formation failure |
| Example 2-72 | UDL-72 | A | Good | Film formation failure |
| Example 2-73 | UDL-73 | A | Good | Film formation failure |
| Example 2-74 | UDL-74 | A | Good | Film formation failure |
| Example 2-75 | UDL-75 | A | Good | Film formation failure |
| Example 2-76 | UDL-76 | A | Good | Film formation failure |
| Example 2-77 | UDL-77 | B | Good | Film formation failure |
| Example 2-78 | UDL-78 | B | Good | Film formation failure |
| Example 2-79 | UDL-79 | A | Good | Film formation failure |
| Example 2-80 | UDL-80 | A | Good | Film formation failure |
| Example 2-81 | UDL-81 | A | Good | Film formation failure |
| Example 2-82 | UDL-82 | A | Good | Film formation failure |
| Example 2-83 | UDL-83 | A | Good | Film formation failure |
| Example 2-84 | UDL-84 | A | Good | Film formation failure |
| Example 2-85 | UDL-85 | A | Good | Film formation failure |
| Example 2-86 | UDL-86 | A | Good | Film formation failure |
| Example 2-87 | UDL-87 | B | Good | Film formation failure |
| Example 2-88 | UDL-88 | B | Good | Film formation failure |
| Example 2-89 | UDL-89 | A | Good | Good |
| Example 2-90 | UDL-90 | A | Good | Good |

**[Table 4-4]**

| | Composition for forming organic film | Evaluation of hump inhibition property | Evaluation of filling characteristics 1 | Evaluation of filling characteristics 2 |
|---|---|---|---|---|
| Example 2-91 | UDL-91 | A | Good | Good |
| Example 2-92 | UDL-92 | A | Good | Good |
| Example 2-93 | UDL-93 | A | Good | Poor |
| Example 2-94 | UDL-94 | A | Good | Good |
| Example 2-95 | UDL-95 | A | Good | Good |
| Example 2-96 | UDL-96 | A | Good | Good |
| Example 2-97 | UDL-97 | B | Good | Poor |
| Example 2-98 | UDL-98 | B | Good | Poor |
| Example 2-99 | UDL-99 | A | Good | Poor |
| Example 2-100 | UDL-100 | A | Good | Good |
| Example 2-101 | UDL-101 | A | Good | Good |
| Example 2-102 | UDL-102 | A | Good | Good |
| Comparative Example 2-1 | Comparative UDL-1 | C | Poor | Film formation failure |
| Comparative Example 2-2 | Comparative UDL-2 | C | Poor | Film formation failure |
| Comparative Example 2-3 | Comparative UDL-3 | C | Poor | Film formation failure |
| Comparative Example 2-4 | Comparative UDL-4 | C | Poor | Film formation failure |
| Comparative Example 2-5 | Comparative UDL-5 | C | Poor | Film formation failure |
| Comparative Example 2-6 | Comparative UDL-6 | C | Poor | Film formation failure |
| Comparative Example 2-7 | Comparative UDL-8 | C | Poor | Film formation failure |
| Comparative Example 2-8 | Comparative UDL-10 | C | Poor | Film formation failure |
| Comparative Example 2-9 | Comparative UDL-11 | C | Poor | Film formation failure |
| Comparative Example 2-10 | Comparative UDL-12 | C | Poor | Film formation failure |
| Comparative Example 2-11 | Comparative UDL-13 | C | Poor | Film formation failure |
| Comparative Example 2-12 | Comparative UDL-14 | C | Poor | Film formation failure |
| Comparative Example 2-13 | Comparative UDL-21 | A | Poor | Film formation failure |
| Comparative Example 2-14 | Comparative UDL-22 | C | Poor | Poor |
| Comparative Example 2-15 | Comparative UDL-23 | C | Poor | Poor |
| Comparative Example 2-16 | Comparative UDL-24 | C | Poor | Poor |
| Comparative Example 2-17 | Comparative UDL-25 | C | Poor | Poor |
| Comparative Example 2-18 | Comparative UDL-26 | C | Poor | Poor |

**[Table 4-5]**

| | Composition for forming organic film | Evaluation of hump inhibition property | Evaluation of filling characteristics 1 | Evaluation of filling characteristics 2 |
|---|---|---|---|---|
| Comparative Example 2-19 | Comparative UDL-27 | C | Poor | Poor |
| Comparative Example 2-20 | Comparative UDL-28 | A | Poor | Poor |
| Comparative Example 2-21 | Comparative UDL-29 | A | Poor | Poor |
| Comparative Example 2-22 | Comparative UDL-30 | A | Poor | Poor |
| Comparative Example 2-23 | Comparative UDL-31 | A | Poor | Poor |
| Comparative Example 2-24 | Comparative UDL-32 | A | Poor | Poor |
| Comparative Example 2-25 | Comparative UDL-33 | A | Poor | Poor |

As shown in Tables 3-1 to 3-5 and Tables 4-1 to 4-5, it was confirmed that the composition for forming an organic film of the present invention (UDL-1 to 102) had excellent solvent resistance, in-plane uniformity, hump inhibition property, and filling characteristics compared with Comparative Examples.

### Patterning Test: Examples 3-1 to 3-88

An organic cured film was formed on a SiO₂ wafer substrate by using the composition for forming an organic film (UDL-1 to 88) by the above method, the following silicon-containing resist intermediate film material (SOG 1) was applied thereon, and the film was baked at 200°C for 60 seconds to form a silicon-containing resist intermediate film with 35 nm in film thickness. The following single layer resist for ArF was applied thereon as a resist upper layer film material, and baked at 105°C for 60 seconds to form a photoresist film with 100 nm in film thickness. The following immersion protective film material (TC-1) was applied on the photoresist film, and baked at 90°C for 60 seconds to form a protective film with 50 nm in film thickness.

A 2% solution of the following polymer in propylene glycol ethyl ether was prepared as the silicon-containing resist intermediate film material (SOG 1).

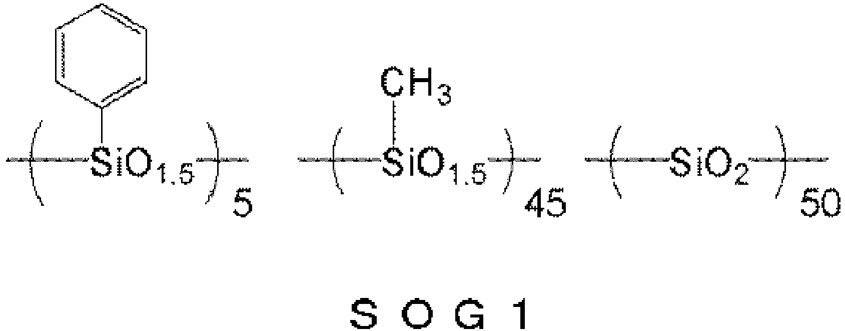

The resist upper layer film material (single layer resist for ArF) was prepared by: dissolving a polymer (RP 1), an acid generator (PAG 1), and a basic compound (Amine 1) in a solvent containing 0.1 mass% of FC-430 (manufactured by Sumitomo 3M Limited.) at a proportion shown in Table 5; and filtering the solution with a 0.1-µm filter made of a fluororesin.

**[Table 5]**

| | Polymer (parts by mass) | Acid generator (parts by mass) | Basic compound (parts by mass) | Solvent (parts by mass) |
|---|---|---|---|---|
| Single-layer resist for ArF | RP 1 (100) | PAG 1 (6.6) | Amine 1 (0.8) | PGMEA (2500) |

The polymer (RP 1), the acid generator (PAG 1), and the basic compound (Amine 1) are shown below.

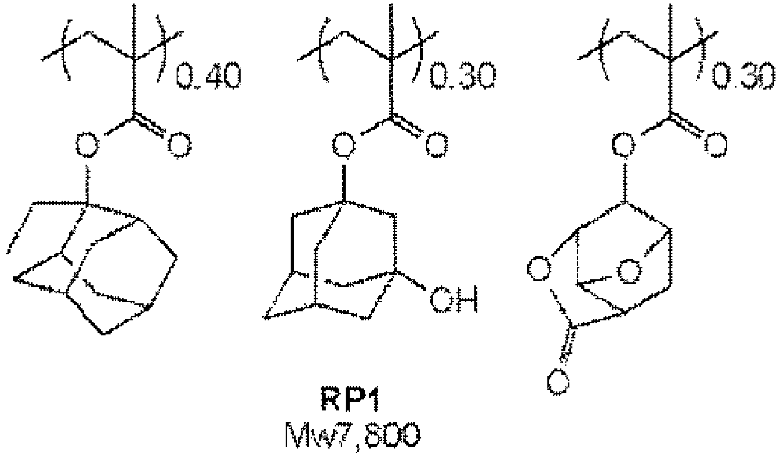

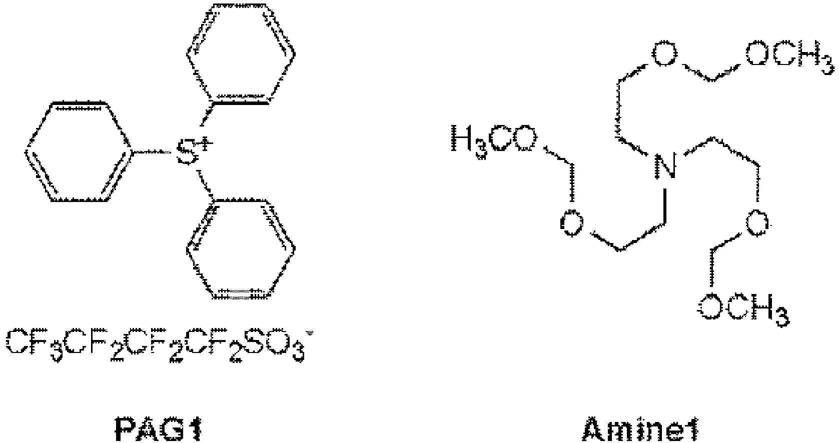

The immersion protective film material (TC-1) was prepared by: dissolving a polymer (PP 1) in an organic solvent at a proportion shown in Table 6; and filtering the solution with a 0.1-µm filter made of a fluororesin.

**[Table 6]**

| | Polymer (parts by mass) | Organic solvent (parts by mass) |
|---|---|---|
| TC-1 | PP 1 (100) | Diisoamyl ether (2700) |
| | | 2-Methyl-1-butanol (270) |

The polymer (PP 1) is shown below.

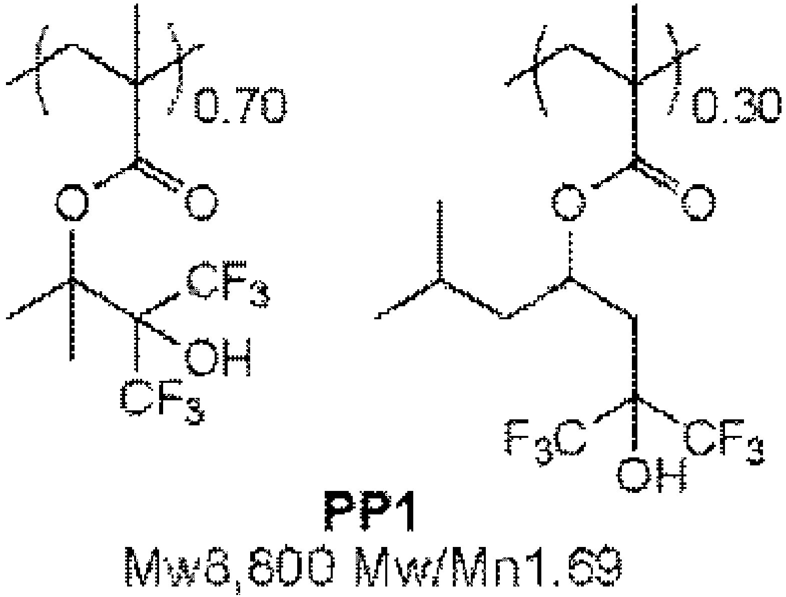

Then, the film was exposed with an ArF immersion exposure device (manufactured by NIKON CORPORATION; NSR-S610C, NA 1.30, σ 0.98/0.65, 35°-dipole s-polarized illumination, 6% halftone phase-shifting mask), baked at 100°C for 60 seconds (PEB), and developed with a 2.38 mass% aqueous solution of tetramethylammonium hydroxide (TMAH) for 30 seconds to obtain a positive line-and-space pattern of 1:1 with 55 nm (resist upper layer film pattern).

Then, while using the resist upper layer film pattern as a mask, the silicon-containing resist intermediate film was processed by dry etching (pattern-transferred) using an etching apparatus "Telius", manufactured by Tokyo Electron Ltd. While using the obtained silicon-containing resist intermediate film pattern as a mask, the organic film was processed by dry etching (pattern-transferred). While using the obtained organic film pattern as a mask, the SiO₂ wafer substrate (SiO₂ film) was processed by dry etching (pattern-transferred). The etching conditions were as follows.

### (Transferring Conditions of Resist Upper Layer Film Pattern to Silicon-Containing Resist Intermediate Film)

Chamber pressure: 10.0 Pa
RF power: 1,500 W
CF₄ gas flow rate: 75 mL/min.
O₂ gas flow rate: 15 mL/min.
Time: 15 sec.

### (Transferring Conditions of Silicon-Containing Resist Intermediate Film Pattern to Organic Film)

Chamber pressure: 2.0 Pa
RF power: 500 W
Ar gas flow rate: 75 mL/min.
O₂ gas flow rate: 45 mL/min.
Time: 120 sec.

### (Transferring Conditions of Organic Film Pattern to SiO₂ Wafer Substrate)

Chamber pressure: 2.0 Pa
RF power: 2,200 W
C₅F₁₂ gas flow rate: 20 mL/min.
C₂F₆ gas flow rate: 10 mL/min.
Ar gas flow rate: 300 mL/min.
O₂ gas flow rate: 60 mL/min.
Time: 90 sec.

Tables 7-1 to 7-3 show the result of observing a cross section of the obtained pattern with an electron microscope (S-4700), manufactured by Hitachi, Ltd.

**[Table 7-1]**

| | Composition for forming organic film | Shape after substrate transfer etching |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |

**[Table 7-2]**

| | Composition for forming organic film | Shape after substrate transfer etching |
|---|---|---|
| Example 3-31 | UDL-31 | Good |
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |
| Example 3-51 | UDL-51 | Good |
| Example 3-52 | UDL-52 | Good |
| Example 3-53 | UDL-53 | Good |
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |
| Example 3-60 | UDL-60 | Good |

**[Table 7-3]**

| | Composition for forming organic film | Shape after substrate transfer etching |
|---|---|---|
| Example 3-61 | UDL-61 | Good |
| Example 3-62 | UDL-62 | Good |
| Example 3-63 | UDL-63 | Good |
| Example 3-64 | UDL-64 | Good |
| Example 3-65 | UDL-65 | Good |
| Example 3-66 | UDL-66 | Good |
| Example 3-67 | UDL-67 | Good |
| Example 3-68 | UDL-68 | Good |
| Example 3-69 | UDL-69 | Good |
| Example 3-70 | UDL-70 | Good |
| Example 3-71 | UDL-71 | Good |
| Example 3-72 | UDL-72 | Good |
| Example 3-73 | UDL-73 | Good |
| Example 3-74 | UDL-74 | Good |
| Example 3-75 | UDL-75 | Good |
| Example 3-76 | UDL-76 | Good |
| Example 3-77 | UDL-77 | Good |
| Example 3-78 | UDL-78 | Good |
| Example 3-79 | UDL-79 | Good |
| Example 3-80 | UDL-80 | Good |
| Example 3-81 | UDL-81 | Good |
| Example 3-82 | UDL-82 | Good |
| Example 3-83 | UDL-83 | Good |
| Example 3-84 | UDL-84 | Good |
| Example 3-85 | UDL-85 | Good |
| Example 3-86 | UDL-86 | Good |
| Example 3-87 | UDL-87 | Good |
| Example 3-88 | UDL-88 | Good |

As shown in Tables 7-1 to 7-3, all Examples 3-1 to 3-88, which used the composition for forming an organic film of the present invention (UDL-1 to 88) favorably and finally transferred the resist upper layer film pattern to the SiO₂ wafer substrate, and it was confirmed that the composition for forming an organic film of the present invention was suitably used in fine patterning with the multilayer resist method.

From the above, the composition for forming an organic film of the present invention has excellent film-formability and high filling characteristics and hump inhibition property, and is thereby extremely excellent as the organic film material used in the multilayer resist process. In addition, the patterning process of the present invention using this composition can fill holes and trenches having an extremely high aspect ratio without a void, can accurately form a fine pattern, and can form the organic film with inhibited humps. Therefore, semiconductor devices, etc. can be efficiently manufactured.

The present description includes the following embodiments.
[1]: A composition for forming an organic film, comprising:
   a resin for forming an organic film;
   a polymer having a structural unit represented by the following general formula (I), and at least one of a structural unit represented by the following general formula (II) and a structural unit represented by the following general formula (III); and
   a solvent, wherein
   the structural unit represented by the following general formula (I), and at least one of the structural unit represented by the following general formula (II) and the structural unit represented by the following general formula (III) form a random copolymer, and
   the polymer has a fluorine content of 5 mass% to 16 mass%, 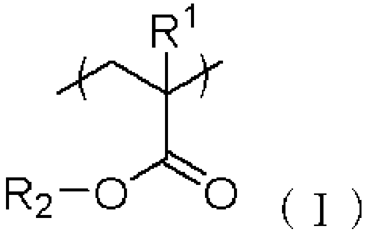 wherein R¹ represents a hydrogen atom or an alkyl group having 1 to 20 carbon atoms; and R² represents an organic group having a fluorine atom and 1 to 20 carbon atoms, and having no sulfonyl group and no amino group, 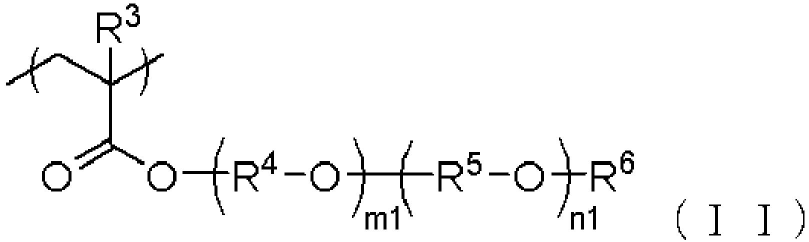 wherein R³ represents a hydrogen atom or an alkyl group having 1 to 20 carbon atoms; R⁴ and R⁵ each represent a linear or branched divalent alkylene group having 1 to 4 carbon atoms; R⁶ represents a hydrogen atom, an alkyl group having 1 to 4 carbon atoms, or a phenyl group; m1 represents 0 to 23; n1 represents 0 to 23; and 23 ≥ m1+n1 ≥ 2, 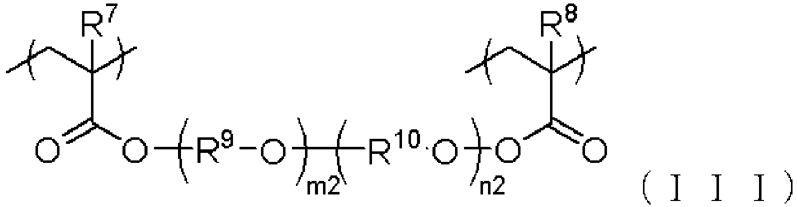 wherein R⁷ and R⁸ represent a hydrogen atom or an alkyl group having 1 to 20 carbon atoms; R⁹ and R¹⁰ each represent a linear or branched divalent alkylene group having 1 to 4 carbon atoms; m2 represents 0 to 23; n2 represents 0 to 23; and 23 ≥ m2+n2 ≥ 2.
[2]: The composition for forming an organic film of the above [1], wherein R² in the structural unit represented by the general formula (I) of the polymer has a structure represented by the following general formula (IV) or (V), 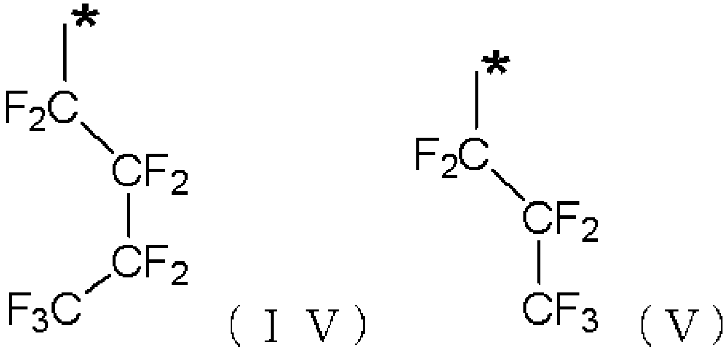 wherein "*" represents a bonding position.
[3]: The composition for forming an organic film of the above [1] or [2], wherein the resin for forming an organic film is a resin having an aromatic skeleton.
[4]: The composition for forming an organic film of any one of the above [1] to [3], wherein a content of the polymer is 0.01 part by mass to 5 parts by mass relative to 100 parts by mass of the resin for forming an organic film.
[5]: The composition for forming an organic film of any one of the above [1] to [4], wherein a content of the resin for forming an organic film is 10 parts by mass to 40 parts by mass relative to 100 parts by mass of the composition for forming an organic film.
[6]: A method for forming an organic film used in a semiconductor device manufacturing process, the method comprising steps of:
   applying the composition for forming an organic film of any one of the above [1] to [5] on a substrate to be processed by spin-coating; and
   heat-treating the substrate coated with the composition for forming an organic film at a temperature of 100°C to 600°C within a range of 10 seconds to 600 seconds for forming a cured film.
[7]: A patterning process, comprising steps of:
   forming an organic film on a body to be processed by using the composition for forming an organic film of any one of the above [1] to [5];
   forming a resist intermediate film on the organic film by using a resist intermediate film material containing a silicon atom;
   forming a resist upper layer film on the resist intermediate film by using a resist upper layer film material composed of a photoresist composition;
   forming a circuit pattern in the resist upper layer film;
   transferring the pattern to the resist intermediate film by etching while using the circuit-patterned resist upper layer film as a mask;
   transferring the pattern to the organic film by etching while using the patterned resist intermediate film as a mask; and
   transferring the pattern to the body to be processed by etching while using the patterned organic film as a mask.
[8]: A patterning process, comprising steps of:
   forming an organic film on a body to be processed by using the composition for forming an organic film of any one of the above [1] to [5];
   forming a resist intermediate film on the organic film by using a resist intermediate film material containing a silicon atom;
   forming an organic anti-reflection film or an adhesion film on the resist intermediate film;
   forming a resist upper layer film on the organic anti-reflection film or the adhesion film by using a resist upper layer film material composed of a photoresist composition;
   forming a circuit pattern in the resist upper layer film;
   transferring the pattern to the organic anti-reflection film or the adhesion film, and the resist intermediate film by etching while using the circuit-patterned resist upper layer film as a mask;
   transferring the pattern to the organic film by etching while using the patterned resist intermediate film as a mask; and
   transferring the pattern to the body to be processed by etching while using the patterned organic film as a mask.
[9]: A patterning process, comprising steps of:
   forming an organic film on a body to be processed by using the composition for forming an organic film of any one of the above [1] to [5];
   forming an inorganic hard mask selected from a silicon oxide film, a silicon nitride film, and a silicon oxynitride film on the organic film;
   forming a resist upper layer film on the inorganic hard mask by using a resist upper layer film material composed of a photoresist composition;
   forming a circuit pattern in the resist upper layer film;
   transferring the pattern to the inorganic hard mask by etching while using the circuit-patterned resist upper layer film as a mask;
   transferring the pattern to the organic film by etching while using the patterned inorganic hard mask as a mask; and
   transferring the pattern to the body to be processed by etching while using the patterned organic film as a mask.
[10]: A patterning process, comprising steps of:
   forming an organic film on a body to be processed by using the composition for forming an organic film of any one of the above [1] to [5];
   forming an inorganic hard mask selected from a silicon oxide film, a silicon nitride film, and a silicon oxynitride film on the organic film;
   forming an organic anti-reflection film or an adhesion film on the inorganic hard mask;
   forming a resist upper layer film on the organic anti-reflection film or the adhesion film by using a resist upper layer film material composed of a photoresist composition;
   forming a circuit pattern in the resist upper layer film;
   transferring the pattern to the organic anti-reflection film or the adhesion film, and the inorganic hard mask by etching while using the circuit-patterned resist upper layer film as a mask;
   transferring the pattern to the organic film by etching while using the patterned inorganic hard mask as a mask; and
   transferring the pattern to the body to be processed by etching while using the patterned organic film as a mask.
[11]: The patterning process of the above [9] or [10], wherein the inorganic hard mask is formed by a CVD method or an ALD method.
[12]: The patterning process of any one of the above [7] to [11], wherein the circuit pattern is formed by a lithography using light having a wavelength of 10 nm to 300 nm, a direct writing with electron beam, nanoimprinting, or a combination thereof.
[13]: The patterning process of any one of the above [7] to [12], wherein the circuit pattern is developed with an alkaline development or an organic solvent.
[14]: The patterning process of any one of the above [7] to [13], wherein the body to be processed is a semiconductor device substrate, or a substrate in which any of a metal film, a metal carbide film, a metal oxide film, a metal nitride film, a metal oxycarbide film, and a metal oxynitride film is formed on the semiconductor device substrate.
[15]: The patterning process of the above [14], wherein a metal to constitute the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming an organic film, comprising:
a resin for forming an organic film;
a polymer having a structural unit represented by the following general formula (I), and at least one of a structural unit represented by the following general formula (II) and a structural unit represented by the following general formula (III); and
a solvent, wherein
the structural unit represented by the following general formula (I), and at least one of the structural unit represented by the following general formula (II) and the structural unit represented by the following general formula (III) form a random copolymer, and
the polymer has a fluorine content of 5 mass% to 16 mass%, 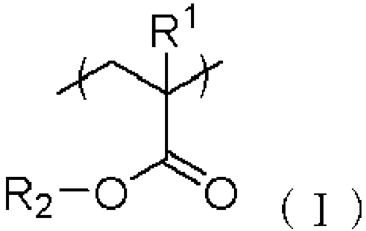 wherein R¹ represents a hydrogen atom or an alkyl group having 1 to 20 carbon atoms; and R² represents an organic group having a fluorine atom and 1 to 20 carbon atoms, and having no sulfonyl group and no amino group, 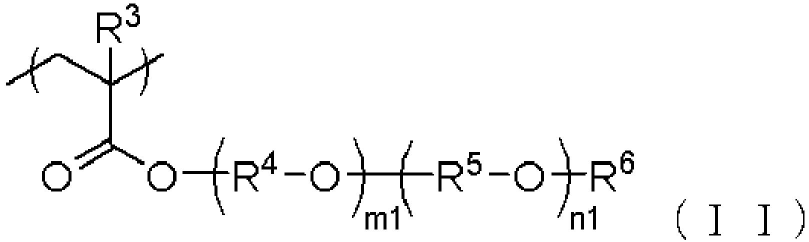 wherein R³ represents a hydrogen atom or an alkyl group having 1 to 20 carbon atoms; R⁴ and R⁵ each represent a linear or branched divalent alkylene group having 1 to 4 carbon atoms; R⁶ represents a hydrogen atom, an alkyl group having 1 to 4 carbon atoms, or a phenyl group; m1 represents 0 to 23; n1 represents 0 to 23; and 23 ≥ m1+n1 ≥ 2, 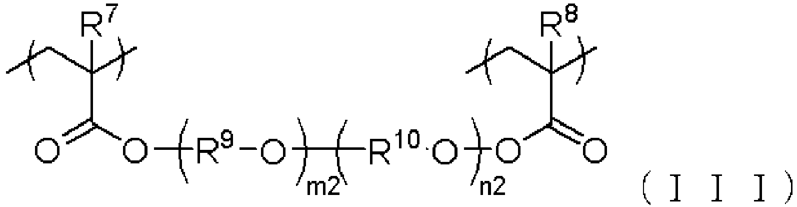 wherein R⁷ and R⁸ represent a hydrogen atom or an alkyl group having 1 to 20 carbon atoms; R⁹ and R¹⁰ each represent a linear or branched divalent alkylene group having 1 to 4 carbon atoms; m2 represents 0 to 23; n2 represents 0 to 23; and 23 ≥ m2+n2 ≥ 2.

2. The composition for forming an organic film according to claim 1, wherein R² in the structural unit represented by the general formula (I) of the polymer has a structure represented by the following general formula (IV) or (V), 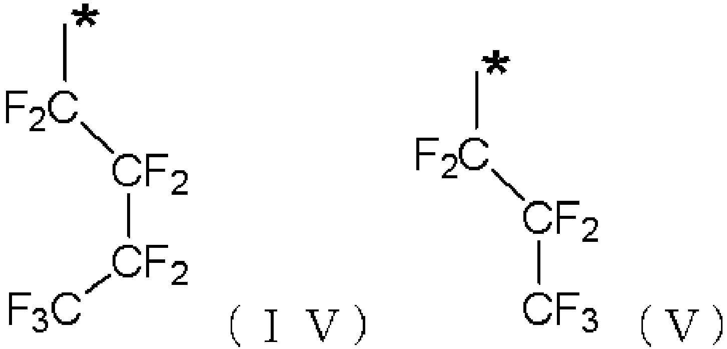 wherein "*" represents a bonding position.

3. The composition for forming an organic film according to claim 1 or 2, wherein the resin for forming an organic film is a resin having an aromatic skeleton.

4. The composition for forming an organic film according to any one of claims 1 to 3, wherein a content of the polymer is 0.01 part by mass to 5 parts by mass relative to 100 parts by mass of the resin for forming an organic film.

5. The composition for forming an organic film according to any one of claims 1 to 4, wherein a content of the resin for forming an organic film is 10 parts by mass to 40 parts by mass relative to 100 parts by mass of the composition for forming an organic film.

6. A method for forming an organic film used in a semiconductor device manufacturing process, the method comprising steps of:
applying the composition for forming an organic film according to any one of claims 1 to 5 on a substrate to be processed by spin-coating; and
heat-treating the substrate coated with the composition for forming an organic film at a temperature of 100°C to 600°C within a range of 10 seconds to 600 seconds for forming a cured film.

7. A patterning process, comprising steps of:
forming an organic film on a body to be processed by using the composition for forming an organic film according to any one of claims 1 to 5;
forming a resist intermediate film on the organic film by using a resist intermediate film material containing a silicon atom;
forming a resist upper layer film on the resist intermediate film by using a resist upper layer film material composed of a photoresist composition;
forming a circuit pattern in the resist upper layer film;
transferring the pattern to the resist intermediate film by etching while using the circuit-patterned resist upper layer film as a mask;
transferring the pattern to the organic film by etching while using the patterned resist intermediate film as a mask; and
transferring the pattern to the body to be processed by etching while using the patterned organic film as a mask.

8. A patterning process, comprising steps of:
forming an organic film on a body to be processed by using the composition for forming an organic film according to any one of claims 1 to 5;
forming a resist intermediate film on the organic film by using a resist intermediate film material containing a silicon atom;
forming an organic anti-reflection film or an adhesion film on the resist intermediate film;
forming a resist upper layer film on the organic anti-reflection film or the adhesion film by using a resist upper layer film material composed of a photoresist composition;
forming a circuit pattern in the resist upper layer film;
transferring the pattern to the organic anti-reflection film or the adhesion film, and the resist intermediate film by etching while using the circuit-patterned resist upper layer film as a mask;
transferring the pattern to the organic film by etching while using the patterned resist intermediate film as a mask; and
transferring the pattern to the body to be processed by etching while using the patterned organic film as a mask.

9. A patterning process, comprising steps of:
forming an organic film on a body to be processed by using the composition for forming an organic film according to any one of claims 1 to 5;
forming an inorganic hard mask selected from a silicon oxide film, a silicon nitride film, and a silicon oxynitride film on the organic film;
forming a resist upper layer film on the inorganic hard mask by using a resist upper layer film material composed of a photoresist composition;
forming a circuit pattern in the resist upper layer film;
transferring the pattern to the inorganic hard mask by etching while using the circuit-patterned resist upper layer film as a mask;
transferring the pattern to the organic film by etching while using the patterned inorganic hard mask as a mask; and
transferring the pattern to the body to be processed by etching while using the patterned organic film as a mask.

10. A patterning process, comprising steps of:
forming an organic film on a body to be processed by using the composition for forming an organic film according to any one of claims 1 to 5;
forming an inorganic hard mask selected from a silicon oxide film, a silicon nitride film, and a silicon oxynitride film on the organic film;
forming an organic anti-reflection film or an adhesion film on the inorganic hard mask;
forming a resist upper layer film on the organic anti-reflection film or the adhesion film by using a resist upper layer film material composed of a photoresist composition;
forming a circuit pattern in the resist upper layer film;
transferring the pattern to the organic anti-reflection film or the adhesion film, and the inorganic hard mask by etching while using the circuit-patterned resist upper layer film as a mask;
transferring the pattern to the organic film by etching while using the patterned inorganic hard mask as a mask; and
transferring the pattern to the body to be processed by etching while using the patterned organic film as a mask.

11. The patterning process according to claim 9 or 10, wherein the inorganic hard mask is formed by a CVD method or an ALD method.

12. The patterning process according to any one of claims 7 to 11, wherein the circuit pattern is formed by a lithography using light having a wavelength of 10 nm to 300 nm, a direct writing with electron beam, nanoimprinting, or a combination thereof.

13. The patterning process according to any one of claims 7 to 12, wherein the circuit pattern is developed with an alkaline development or an organic solvent.

14. The patterning process according to any one of claims 7 to 13, wherein the body to be processed is a semiconductor device substrate, or a substrate in which any of a metal film, a metal carbide film, a metal oxide film, a metal nitride film, a metal oxycarbide film, and a metal oxynitride film is formed on the semiconductor device substrate.

15. The patterning process according to claim 14, wherein a metal to constitute the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
